(19) Europäisches Patentamt
European Patent Office
Office européen des brevets

(11) EP 3 858 885 B1

(12) # EUROPEAN PATENT SPECIFICATION

(45) Date of publication and mention of the grant of the patent:
**08.05.2024 Bulletin 2024/19**

(21) Application number: **19865626.6**

(22) Date of filing: **26.09.2019**

(51) International Patent Classification (IPC):
***C08G 59/62*** *(2006.01)* ***C08J 5/18*** *(2006.01)*
***C08K 3/38*** *(2006.01)* ***C08K 9/04*** *(2006.01)*
***C08L 63/00*** *(2006.01)* ***C09K 5/14*** *(2006.01)*

(52) Cooperative Patent Classification (CPC):
(C-Sets available)
**C08J 7/0427; C08G 59/621; C08J 5/18; C08K 9/04; C09K 5/14;** C08J 2363/00; C08J 2463/00; C08K 2003/385 (Cont.)

(86) International application number:
**PCT/JP2019/038007**

(87) International publication number:
**WO 2020/067364 (02.04.2020 Gazette 2020/14)**

(54) **COMPOSITION FOR FORMING HEAT CONDUCTIVE MATERIALS, HEAT CONDUCTIVE MATERIAL, HEAT CONDUCTIVE SHEET, DEVICE WITH HEAT CONDUCTIVE LAYER, AND FILM**

ZUSAMMENSETZUNG ZUR FORMUNG VON WÄRMELEITFÄHIGEN MATERIALIEN, WÄRMELEITENDES MATERIAL, WÄRMELEITENDE PLATTE, VORRICHTUNG MIT WÄRMELEITENDER SCHICHT UND FILM

COMPOSITION POUR FORMER DES MATÉRIAUX THERMOCONDUCTEURS, MATÉRIAU THERMOCONDUCTEUR, FEUILLE THERMOCONDUCTRICE, DISPOSITIF AVEC COUCHE THERMOCONDUCTRICE, ET FILM

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:
**28.09.2018 JP 2018185541**
**09.11.2018 JP 2018211400**
**09.11.2018 JP 2018211507**
**09.11.2018 JP 2018211644**
**09.11.2018 JP 2018211405**

(43) Date of publication of application:
**04.08.2021 Bulletin 2021/31**

(73) Proprietor: **FUJIFILM Corporation**
**Tokyo 106-8620 (JP)**

(72) Inventors:
- **HITOMI, Seiichi**
  **Kanagawa 258-8577 (JP)**
- **TAKAHASHI, Keita**
  **Ashigara-kami-gun, Kanagawa 258-8577 (JP)**
- **NIORI, Teruki**
  **Ashigara-kami-gun, Kanagawa 258-8577 (JP)**
- **HAYASHI, Daisuke**
  **Ashigara-kami-gun, Kanagawa 258-8577 (JP)**

(74) Representative: **Hoffmann Eitle**
**Patent- und Rechtsanwälte PartmbB**
**Arabellastraße 30**
**81925 München (DE)**

(56) References cited:
**WO-A1-2010/140674** **WO-A1-2013/030998**
**WO-A1-2015/127179** **WO-A1-2016/093248**
**WO-A1-2016/125664** **CN-A- 109 651 596**
**JP-A- S59 157 114** **JP-A- 2004 093 816**
**JP-A- 2013 159 759** **JP-A- 2016 094 599**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
**C08K 9/04, C08L 63/00**

## Description

## BACKGROUND OF THE INVENTION

1. Field of the Invention

The present invention relates to a thermally conductive material-forming composition, a thermally conductive material, a thermally conductive sheet, a device with a thermally conductive layer, and a film.

2. Description of the Related Art

In recent years, a power semiconductor device used in various electrical machines such as a personal computer, a general household electric appliance, and an automobile has been rapidly miniaturized. With the miniaturization, it is difficult to control heat generated from the power semiconductor device having a high density.

In order to deal with such a problem, a thermally conductive material, which promotes heat dissipation from the power semiconductor device, is used.

For example, JP2013-089670A discloses a "heat dissipation member ... consisting of a thermosetting adhesive containing boron nitride particles (A), an epoxy resin (B), and a phenolic resin (C), ... used to dissipate heat through the insulating resin layer (claim 1)". As the phenolic resin (C), a phenol novolac resin has been proposed.

Furthermore, for example, JP2013-089670A discloses a "thermally conductive sheet for a semiconductor module which is interposed between a heat dissipation member and a semiconductor element in a semiconductor module including a module body comprising the semiconductor element and the heat dissipation member for dissipating heat generated by the semiconductor element, and comprises an epoxy resin layer consisting of an epoxy composition, wherein the epoxy composition contains an epoxy monomer represented by General Formula (1), a phenol-based curing agent represented by General Formula (2), and boron nitride particles or aluminum nitride particles, and the boron nitride particles or aluminum nitride particles are contained in a form of aggregated particles".

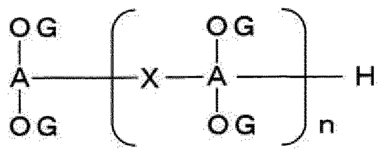

· · · (1)

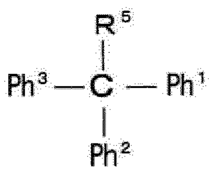

· · · (2)

WO2010140674A1 discloses an epoxy resin composition from which a cured product having a heat resistance and a heat transfer rate can be obtained. Specifically, the document discloses an epoxy resin composition comprising an epoxy resin, a curing agent and an inorganic filler having a heat transfer rate of 20 W/m·K or more, which contains, as said curing agent, a phenol compound obtained by reacting one or more compounds with a hydroxybenzaldehyde, and/or, as said epoxy resin, an epoxy compound obtained by further reacting the aforesaid phenol compound with an epihalohydrin.

## SUMMARY OF THE INVENTION

As a result of an examination of the insulating resin layer described in JP2013-089670A, the present inventors found that there is room for improvement in thermally conductive properties.

Furthermore, as a result of an examination of the thermally conductive sheet for a semiconductor module described in JP2013-089670A, the present inventors found that there is room for improvement in thermally conductive properties.

For example, it was found that in the epoxy composition described in JP2013-089670A, a hydroxyl group in the phenol-based curing agent is easily adsorbed with boron nitride due to hydrogen bond interaction or the like, which inhibits an appropriate crosslinking polymerization reaction between the phenol-based curing agent and the epoxy monomer. That is, it was clarified that improving adsorptivity between the phenol-based curing agent and the boron

nitride is one of factors which improve thermally conductive properties of the thermally conductive sheet.

Therefore, in one aspect of the present invention, an object of the present invention is to provide a thermally conductive material-forming composition from which a thermally conductive material having excellent thermally conductive properties can be obtained.

Moreover, another object of the present invention is to provide a thermally conductive material formed of the thermally conductive material-forming composition, a thermally conductive sheet, and a device with a thermally conductive layer.

In addition, in one aspect of the present invention, an object of the present invention is to provide a film from which a thermally conductive sheet having excellent thermally conductive properties can be prepared.

Moreover, another object of the present invention is to provide a thermally conductive sheet prepared using the film, and a device with a thermally conductive layer.

As a result of a thorough examination conducted to achieve the objects, the present inventors have found that the objects can be achieved by the following configuration.

The present invention is defined by the claims. The following aspects and embodiments thereof are useful in understanding the present invention.

<<First aspect of present invention>>

In the first aspect is disclosed,
a thermally conductive material-forming composition according to claim 1, comprising:

an epoxy compound;
one or more kinds of phenolic compounds selected from the group consisting of a compound represented by General Formula (1) and a compound represented by General Formula (2); and
an inorganic substance

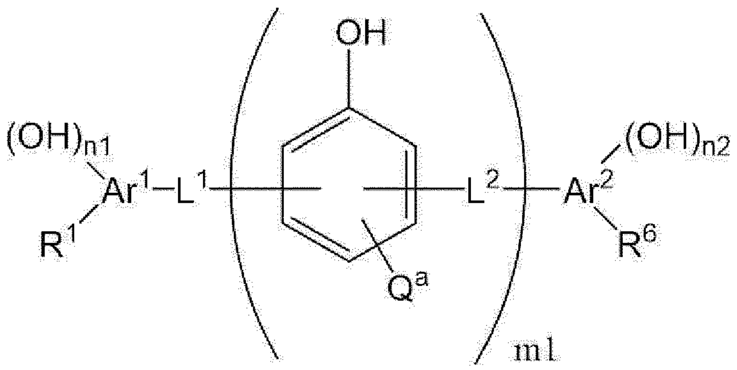

(1)

In General Formula (1), m1 represents an integer of 0 or greater;

n1 and n2 each independently represent an integer of 2 or greater;
$L^1$ represents $-C(R^2)(R^3)-$ or -CO-;
$L^2$ represents $-C(R^4)(R^5)-$ or -CO-;
$Ar^1$ and $Ar^2$ each independently represent a benzene ring group or a naphthalene ring group;
$R^1$ and $R^6$ each independently represent a hydrogen atom, a halogen atom, a carboxylic acid group, a boronic acid group, an aldehyde group, an alkyl group, an alkoxy group, or an alkoxycarbonyl group;
$R^2$ to $R^5$ each independently represent a hydrogen atom, a hydroxyl group, a halogen atom, a carboxylic acid group, a boronic acid group, an aldehyde group, an alkyl group, an alkoxy group, or an alkoxycarbonyl group;
$Q^a$ represents a hydrogen atom, an alkyl group, a phenyl group, a halogen atom, a carboxylic acid group, a boronic acid group, an aldehyde group, an alkoxy group, or an alkoxycarbonyl group; and
in a case where there are a plurality of $L^2$'s and $Q^a$'s, the plurality of $L^2$'s may be the same as or different from each other and the plurality of $Q^a$'s may be the same as or different from each other, and
in a case where m1 represents 0, $L^1$ represents -CH(OH)- or -CO-; and

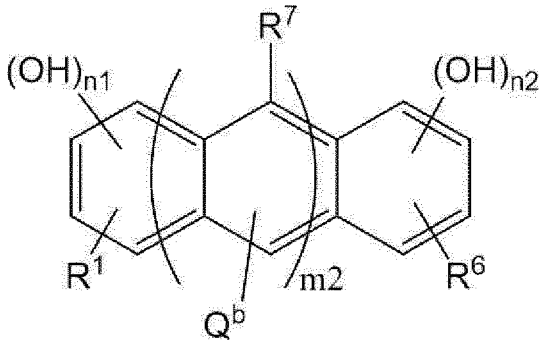

(2)

in General Formula (2), m2 represents an integer of 0 or greater;
n1 and n2 each independently represent an integer of 2 or greater;
$R^1$ and $R^6$ each independently represent a hydrogen atom, a halogen atom, a carboxylic acid group, a boronic acid group, an aldehyde group, an alkyl group, an alkoxy group, or an alkoxycarbonyl group;
$R^7$ represents a hydrogen atom or a hydroxyl group;
$Q^b$ represents a hydrogen atom, an alkyl group, a phenyl group, a halogen atom, a carboxylic acid group, a boronic acid group, an aldehyde group, an alkoxy group, or an alkoxycarbonyl group; and
in a case where there are a plurality of $R^7$'s and $Q^b$'s, the plurality of $R^7$'s may be the same as or different from each other and the plurality of $Q^b$'s may be the same as or different from each other.

In one embodiment according to the first aspect is disclosed, the thermally conductive material-forming composition, in which a hydroxyl group content of the phenolic compound is 12.0 mmol/g or greater.
In one embodiment according to the first aspect is disclosed, the thermally conductive material-forming composition in which a molecular weight of the phenolic compound is 400 or less.
In one embodiment according to the first aspect is disclosed, the thermally conductive material-forming composition in which the epoxy compound has a biphenyl skeleton.
In one embodiment according to the first aspect is disclosed, the thermally conductive material-forming composition in which the inorganic substance includes an inorganic nitride.
In one embodiment according to the first aspect is disclosed, the thermally conductive material-forming composition of the previous embodiment, in which the inorganic nitride includes boron nitride.
In one embodiment according to the first aspect is disclosed, the thermally conductive material-forming composition, further comprising a surface modifier for the inorganic substance.
In one embodiment according to the first aspect is disclosed, the thermally conductive material-forming composition of the previous embodiment, in which the surface modifier has a fused-ring skeleton or a triazine skeleton.
In one embodiment according to the first aspect is disclosed, the thermally conductive material-forming composition, further comprising a curing accelerator.
In one embodiment according to the first aspect is disclosed, a thermally conductive material obtained by curing the thermally conductive material-forming composition.
In one embodiment according to the first aspect is disclosed, a thermally conductive sheet consisting of the thermally conductive material of the previous embodiment.
A device is disclosed with a thermally conductive layer comprising:

a device; and
a thermally conductive layer which is disposed on the device and includes the thermally conductive sheet of the previous embodiment.

<<Second aspect of present invention>>

In the second aspect is disclosed,
a thermally conductive material-forming composition comprising:

a phenolic compound;
an epoxy compound; and
boron nitride,
in which the phenolic compound has a hydroxyl group content of 10.5 mmol/g or greater, and an adsorption amount

of 0. 12 mg or less with respect to 1 g of the boron nitride.

In one embodiment according the second aspect is disclosed, the thermally conductive material-forming composition, in which the hydroxyl group content is 12.0 mmol/g or greater.
In one embodiment according the second aspect is disclosed, the thermally conductive material-forming composition, in which the adsorption amount of the phenolic compound is 0.01 mg or greater with respect to 1 g of the boron nitride.
In one embodiment according the second aspect is disclosed, the thermally conductive material-forming composition in which an adsorption amount of the epoxy compound is 0.20 mg or less with respect to 1 g of the boron nitride.
In one embodiment according the second aspect is disclosed, the thermally conductive material-forming composition in which the epoxy compound has a biphenyl skeleton.
In one embodiment according the second aspect is disclosed, the thermally conductive material-forming composition, further comprising a surface modifier for the boron nitride.
In one embodiment according the second aspect is disclosed, the thermally conductive material-forming composition, further comprising a curing accelerator.
In one embodiment according the second aspect is disclosed, a thermally conductive material obtained by curing the thermally conductive material-forming composition.
In one embodiment according the second aspect is disclosed, the thermally conductive material of the previous embodiment, which is molded into a sheet shape.
In one embodiment according the second aspect is disclosed, the thermally conductive material of the previous embodiment, in which a density ratio X determined from Expression (1) is 0.96 or greater;

Density ratio X = activity measured density of thermally conductive material determined by Archimedes method/theoretical density Di of thermally conductive material determined by Expression (DI) Expression (1)

Expression (DI)

$$Di = Df \times Vf/100 + Dr \times Vr/100$$

In Expression (DI), Di means a density of a theoretical thermally conductive material T which consists of an organic nonvolatile component and an inorganic substance including the boron nitride;

moreover, a content mass Wf of the inorganic substance in the thermally conductive material T is equal to a content of an inorganic substance in the thermally conductive material-forming composition. Furthermore, a content mass Wr of the organic volatile component in the thermally conductive material T is equal to a value obtained by subtracting the content of the inorganic substance from a content of a total solid content in the thermally conductive material-forming composition;
Df is a density of the inorganic substance.
Dr is a density of the organic nonvolatile component and is 1.2 g/cm$^3$;
Vf is a volume percentage of a volume of the inorganic substance in the thermally conductive material T to a volume of the thermally conductive material T and is a value determined by Expression (DII);

Expression (DII)

$$Vf = (Wf/Df)/((Wf/Df) + (Wr/Dr)) \times 100$$

Vr is a volume percentage of a volume of the organic nonvolatile component in the thermally conductive material T to the volume of the thermally conductive material T and is a value determined by Expression (DIII);

Expression (DIII)

$$Vr = 100 - Vf.$$

In one embodiment according the second aspect is disclosed, a thermally conductive sheet comprising the thermally conductive material of either of the two previous embodiments.

In one embodiment according the second aspect is disclosed, a device with a thermally conductive layer comprising:

a device; and
a thermally conductive layer which is disposed on the device and includes the thermally conductive sheet of the previous embodiment.

According to one aspect of the present invention, it is possible to provide a thermally conductive material-forming composition from which a thermally conductive material having excellent thermally conductive properties can be obtained.

Moreover, according to the present invention, it is possible to provide a thermally conductive material formed of the thermally conductive material-forming composition, a thermally conductive sheet, and a device with a thermally conductive layer.

According to one aspect of the present invention, it is possible to provide a film from which a thermally conductive sheet having excellent thermally conductive properties can be prepared.

Moreover, according to the present invention, it is possible to provide a thermally conductive sheet prepared using the film, and a device with a thermally conductive layer.

## DESCRIPTION OF THE PREFERRED EMBODIMENTS

Hereinafter, a thermally conductive material-forming composition, a film, a thermally conductive material, a thermally conductive sheet, and a device with a thermally conductive layer according to an embodiment of the present invention will be described in detail.

The following constituent elements are described based on the representative embodiments of the present invention in some cases, but the present invention is not limited to such an embodiment.

Moreover, in the present specification, the numerical range expressed using "to" means a range including the numerical values listed before and after "to" as a lower limit value and an upper limit value.

Furthermore, in the present specification, an oxiranyl group is a functional group which is also referred to as an epoxy group, and for example, a group, in which two adjacent carbon atoms of a saturated hydrocarbon ring group are bonded to each other through an oxo group (-O-) to form an oxirane ring, and the like are also included in the oxiranyl group. The oxiranyl group may or may not have a substituent (a methyl group or the like), if possible.

In the present specification, the description of "(meth)acryloyl group" means "either or both of an acryloyl group and a methacryloyl group". Moreover, the description of "(meth)acrylamide group" means "either or both of an acrylamide group and a methacrylamide group".

In the present specification, an acid anhydride group may be a monovalent group or a divalent group. In a case where the acid anhydride group represents a monovalent group, an example thereof includes a substituent obtained by removing any hydrogen atom from an acid anhydride such as maleic acid anhydride, phthalic acid anhydride, pyromellitic acid anhydride, or trimellitic acid anhydride. Moreover, in a case where the acid anhydride group represents a divalent group, the divalent group means a group represented by *-CO-O-CO-* (* represents a bonding position).

In addition, in the present specification, a substituent or the like, which is not specified whether to be substituted or unsubstituted, may or may not have an additional substituent (for example, a substituent group Y which will be described later), if possible, as long as the desired effect is not impaired. For example, the notation of an "alkyl group" means a substituted or unsubstituted alkyl group as long as the desired effect is not impaired.

Furthermore, in the present specification, in a case where the description of "may have a substituent" appears, the type of a substituent, the position of a substituent, and the number of substituents are not particularly limited. Examples of the number of substituents include 1 and 2 or larger. Examples of the substituent include a group of monovalent nonmetallic atoms excluding a hydrogen atom, and the substituent can be selected from the following substituent group Y, for example.

In the present specification, examples of a halogen atom include a chlorine atom, a fluorine atom, a bromine atom, and an iodine atom.

Substituent group Y:
a halogen atom (-F, -Br, -Cl, -I, or the like), a hydroxyl group, an amino group, a carboxylic acid group and a conjugated base group thereof, a carboxylic acid anhydride group, a cyanate ester group, an unsaturated polymerizable group, an oxiranyl group, an oxetanyl group, an aziridinyl group, a thiol group, an isocyanate group, an thioisocyanate group, an aldehyde group, an alkoxy group, an aryloxy group, an alkylthio group, an arylthio group, an alkyldithio group, an aryldithio group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsufinyl group, an arylsulfinyl group, an alkylsulfonyl group, an arylsulfonyl group, a sulfo group ($-SO_3H$) and a conjugated base group thereof, an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, an N-acylsulfamoyl group and a conjugated base group thereof, an N-alkylsulfonylsulfamoyl group ($-SO_2NHSO_2$(alkyl)) and a conjugated base group thereof, an N-arylsulfonylsulfamoyl group ($-SO_2NHSO_2$(aryl)) and a conjugated base group thereof, an N-alkylsulfonylcarbamoyl group ($-CONHSO_2$(alkyl)) and a conjugated base group thereof, an N-arylsulfonylcarbamoyl group ($-CONHSO_2$(aryl)) and a conjugated base group thereof, an alkoxysilyl group ($-Si(Oalkyl)_3$), an aryloxysilyl group ($-Si(Oaryl)_3$), a hydroxysilyl group ($-Si(OH)_3$) and a conjugated base group thereof, a phosphono group ($-PO_3H_2$) and a conjugated base group thereof, a dialkylphosphono group ($-PO_3(alkyl)_2$), a diarylphosphono group ($-PO_3(aryl)_2$), an alkylarylphosphono group ($-PO_3$(alkyl)(aryl)), a monoalkylphosphono group ($-PO_3H$(alkyl)) and a conjugated base group thereof, a monoarylphosphono group ($-PO_3H$(aryl)) and a conjugated base group thereof, a phosphonooxy group ($-OPO_3H_2$) and a conjugated base group thereof, a dialkylphosphonooxy group ($-OPO_3(alkyl)_2$), a diarylphosphonooxy group ($-OPO_3(aryl)_2$), an alkylarylphosphonooxy group ($-OPO_3$(alkyl)(aryl)), a monoalkylphosphonooxy group ($-OPO_3H$(alkyl)) and a conjugated base group thereof, a monoarylphosphonooxy group ($-OPO_3H$(aryl)) and a conjugated base group thereof, a cyano group, a nitro group, an aryl group, an alkenyl group, an alkynyl group, and an alkyl group.

These substituents may or may not form a ring by being bonded to each other, if possible, or by being bonded to a group substituted with the substituent.

<<First aspect of present invention>>

Hereinafter, a first aspect of the present invention will be described in detail.

[Thermally conductive material-forming composition]

In the first aspect of the present invention, a thermally conductive material-forming composition (hereinafter, also simply referred to as a "composition") according to the embodiment of the present invention contains an epoxy compound, a phenolic compound, and an inorganic substance.

Moreover, the phenolic compound is one or more kinds selected from the group consisting of a compound represented by General Formula (1) and a compound represented by General Formula (2).

The mechanism by which the objects of the present invention are achieved with the composition according to the embodiment of the present invention, which adopts the constitution described above, is not always clear, but the present inventors estimate as follows.

That is, in the composition according to the embodiment of the present invention, in general, the epoxy compound acts as a so-called main agent, and the phenolic compound acts as a so-called curing agent. Here, it is estimated that since the phenolic compound has a predetermined structure, a dense crosslinked structure is likely to be formed, and thermally conductive properties of the obtained thermally conductive material are improved.

In addition, a thermally conductive material formed of the composition according to the embodiment of the present invention also has favorable adhesiveness. Moreover, favorable insulating properties (electrical insulating properties) can also be imparted to the thermally conductive material formed of the composition according to the embodiment of the present invention.

Hereinafter, the components contained in the composition will be described in detail.

[Phenolic compound]

The composition according to the embodiment of the present invention contains a phenolic compound.
The phenolic compound generally acts as a so-called curing agent in the composition according to the embodiment of the present invention.
The phenolic compound is one or more kinds selected from the group consisting of a compound represented by General Formula (1) and a compound represented by General Formula (2).

<Compound represented by General Formula (1)>

General Formula (1) will be shown below.

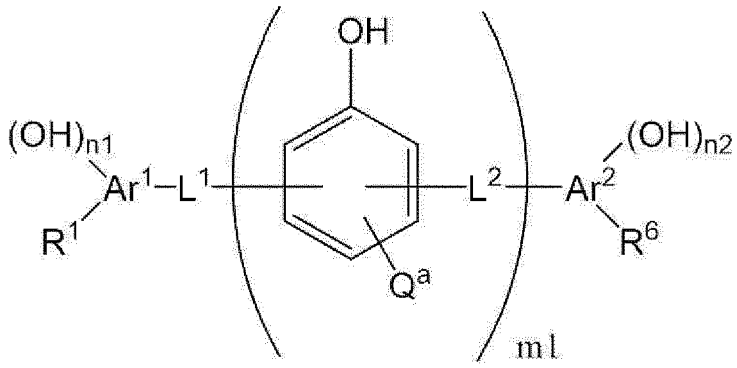
(1)

In General Formula (1), m1 represents an integer of 0 or greater.
m1 is preferably 0 to 10, more preferably 0 to 3, even more preferably 0 or 1, and particularly preferably 1.
In General Formula (1), n1 and n2 each independently represent an integer of 2 or greater.
n1 and n2 are each independently preferably 2 to 4, more preferably 2 or 3, and even more preferably 2.
In General Formula (1), $R^1$ and $R^6$ each independently represent a hydrogen atom, a halogen atom, a carboxylic acid group, a boronic acid group, an aldehyde group, an alkyl group, an alkoxy group, or an alkoxycarbonyl group.
The alkyl group may be linear or branched. The number of carbon atoms in the alkyl group is preferably 1 to 10. The alkyl group may or may not have a substituent.
An alkyl group moiety in the alkoxy group and an alkyl group moiety in the alkoxycarbonyl group are the same as the aforementioned alkyl group.
$R^1$ and $R^6$ are each independently preferably a hydrogen atom or a halogen atom, more preferably a hydrogen atom or a chlorine atom, and even more preferably a hydrogen atom.
In General Formula (1), $L^1$ represents $-C(R^2)(R^3)-$ or -CO-.
$L^2$ represents $-C(R^4)(R^5)-$ or -CO-.
$R^2$ to $R^5$ each independently represent a hydrogen atom, a hydroxyl group, a halogen atom, a carboxylic acid group, a boronic acid group, an aldehyde group, an alkyl group, an alkoxy group, or an alkoxycarbonyl group.
The alkyl group may be linear or branched. The number of carbon atoms in the alkyl group is preferably 1 to 10. The alkyl group may or may not have a substituent.
An alkyl group moiety in the alkoxy group and an alkyl group moiety in the alkoxycarbonyl group are the same as the aforementioned alkyl group.
$R^2$ to $R^5$ are each independently preferably a hydrogen atom or a hydroxyl group and more preferably a hydrogen atom.
$L^1$ and $L^2$ are each independently preferably $-CH_2-$, -CH(OH)-, or -CO- and more preferably $-CH_2-$.
In a case where m1 is 0, $L^1$ is -CH(OH)-, or -CO-.
In a case where m1 is 1, $L^1$ and $L^2$ are each independently preferably $-CH_2-$.
Furthermore, in General Formula (1), in a case where there are a plurality of $R^4$'s, the plurality of $R^4$'s may be the same as or different from each other. In a case where there are a plurality of $R^5$'s, the plurality of $R^5$'s may be the same as or different from each other.
In General Formula (1), $Ar^1$ and $Ar^2$ each independently represent a benzene ring group or a naphthalene ring group.
$Ar^1$ and $Ar^2$ are each independently preferably a benzene ring group.

In General Formula (1), $Q^a$ represents a hydrogen atom, an alkyl group, a phenyl group, a halogen atom, a carboxylic acid group, a boronic acid group, an aldehyde group, an alkoxy group, or an alkoxycarbonyl group.

$Q^a$ represents a hydrogen atom, an alkyl group, a phenyl group, a halogen atom, a carboxylic acid group, a boronic acid group, an aldehyde group, an alkoxy group, or an alkoxycarbonyl group.

The alkyl group may be linear or branched. The number of carbon atoms in the alkyl group is preferably 1 to 10. The alkyl group may or may not have a substituent.

An alkyl group moiety in the alkoxy group and alkoxycarbonyl group and an alkyl group moiety in the alkoxycarbonyl group are the same as the aforementioned alkyl group.

The phenyl group may or may not have a substituent.

$Q^a$ is preferably bonded to a para position with respect to a hydroxyl group of a benzene ring group to which $Q^a$ is bonded.

$Q^a$ is preferably a hydrogen atom or an alkyl group and more preferably an alkyl group. The alkyl group is preferably a methyl group.

Furthermore, in General Formula (1), in a case where there are a plurality of $L^2$'s and $Q^a$'s, the plurality of $L^2$'s may be the same as or different from each other and the plurality of $Q^a$'s may be the same as or different from each other.

<Compound represented by General Formula (2)>

General Formula (2) will be shown below.

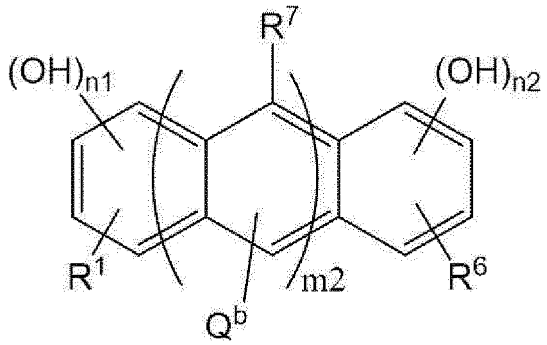

(2)

In General Formula (2), m2 represents an integer of 0 or greater.

m2 is preferably 0 to 10, more preferably 0 to 3, even more preferably 0 or 3, and particularly preferably 0.

In General Formula (2), n1 and n2 each independently represent an integer of 2 or greater.

n1 and n2 are each independently preferably 2 to 4, more preferably 2 or 3, and even more preferably 2.

In General Formula (2), $R^1$ and $R^6$ each independently represent a hydrogen atom, a halogen atom, a carboxylic acid group, a boronic acid group, an aldehyde group, an alkyl group, an alkoxy group, or an alkoxycarbonyl group.

$R^1$ and $R^6$ in General Formula (2) are the same as $R^1$ and $R^6$ in General Formula (1), respectively.

In General Formula (2), $R^7$ represents a hydrogen atom or a hydroxyl group.

In a case where there are a plurality of $R^7$'s, it is preferable that at least one $R^7$ represents a hydroxyl group. For example, in a case where m2 represents 3, it is preferable that at least one $R^7$ among three $R^7$'s represents a hydroxyl group, and more preferable that one $R^7$ represents a hydroxyl group.

In General Formula (2), $Q^b$ represents a hydrogen atom, an alkyl group, a phenyl group, a halogen atom, a carboxylic acid group, a boronic acid group, an aldehyde group, an alkoxy group, or an alkoxycarbonyl group.

The alkyl group may be linear or branched. The number of carbon atoms in the alkyl group is preferably 1 to 10. The alkyl group may or may not have a substituent.

An alkyl group moiety in the alkoxy group and alkoxycarbonyl group and an alkyl group moiety in the alkoxycarbonyl group are the same as the aforementioned alkyl group.

The phenyl group may or may not have a substituent.

$Q^b$ is preferably a hydrogen atom.

Furthermore, in General Formula (2), in a case where there are a plurality of $R^7$'s and $Q^b$'s, the plurality of $R^7$'s may be the same as or different from each other and the plurality of $Q^b$'s may be the same as or different from each other.

The phenolic compound is preferably the compound represented by General Formula (1) from the viewpoint that the insulating properties of the obtained thermally conductive material are superior.

The lower limit value of the hydroxyl group content of the phenolic compound is preferably 11.0 mmol/g or greater, more preferably 12.0 mmol/g or greater, and even more preferably 13.0 mmol/g or greater. The upper limit value

thereof is preferably 25.0 mmol/g or less.

Moreover, the hydroxyl group content means the number of hydroxyl groups (preferably, phenolic hydroxyl groups) contained in 1 g of the phenolic compound.

Furthermore, the phenolic compound may or may not have an active hydrogen-containing group (carboxylic acid group or the like) capable of a polymerization reaction with an epoxy compound, in addition to the hydroxyl group. The lower limit value of the content (total content of hydrogen atoms in a hydroxyl group, a carboxylic acid group, and the like) of an active hydrogen in the phenolic compound is preferably 11.0 mmol/g or greater, more preferably 12.0 mmol/g or greater, and even more preferably 13.0 mmol/g or greater. The upper limit value thereof is preferably 25.0 mmol/g or less.

The upper limit value of the molecular weight of the phenolic compound is preferably 600 or less, more preferably 500 or less, and even more preferably 400 or less. The lower limit value thereof is preferably 192 or greater and more preferably 300 or greater.

One kind of the phenolic compounds may be used singly, or two or more kinds thereof may be used.

Moreover, the composition according to the embodiment of the present invention may contain a compound (also referred to as an "other active hydrogen-containing compound") having a group capable of reacting with an epoxy compound, which will be described later, in addition to the aforementioned phenolic compound (the compound represented by General Formula (1) and/or the compound represented by General Formula (2)).

In a case where the composition contains an other active hydrogen-containing compound, a mass ratio (content of other active hydrogen-containing compound/content of phenolic compound) of a content of the other active hydrogen-containing compound to the content of the phenolic compound in the composition is preferably greater than 0 and 1 or less, more preferably greater than 0 and 0.1 or less, and even more preferably greater than 0 and 0.05 or less.

Preferred examples of the compound represented by General Formula (1) or General Formula (2) will be shown below.

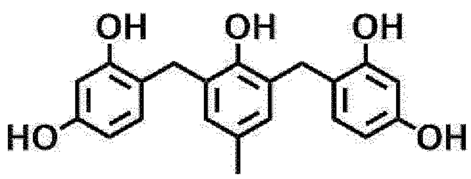

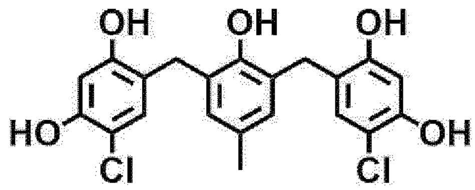

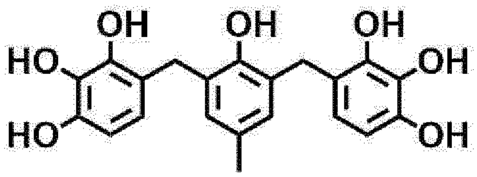

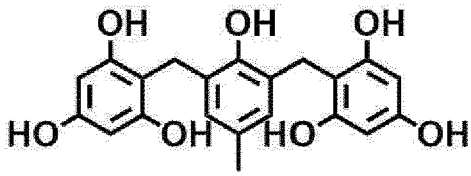

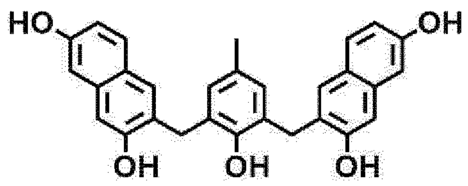
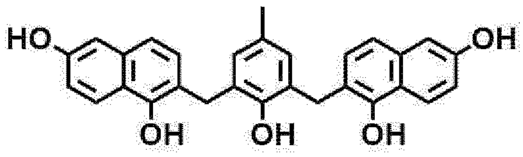
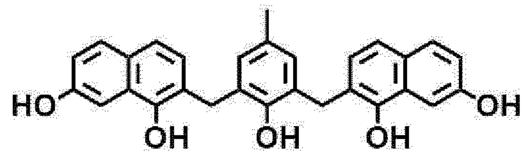
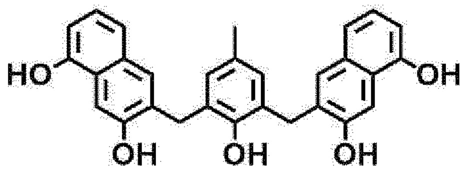
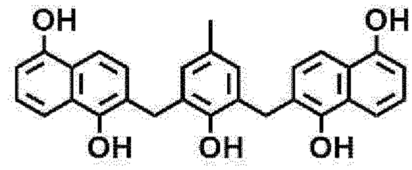
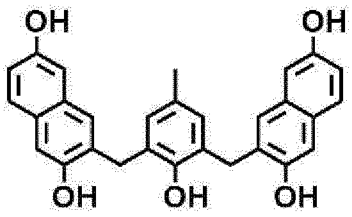
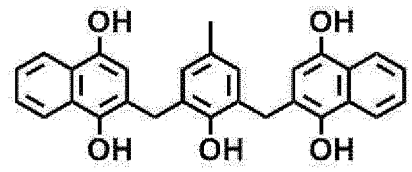
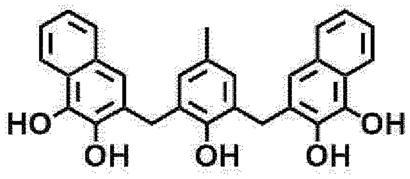
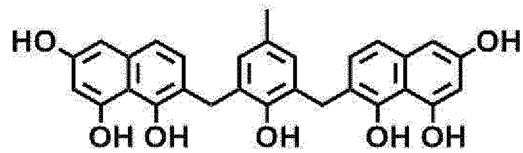
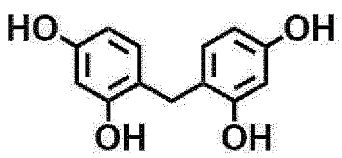
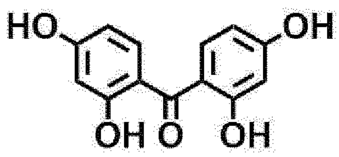
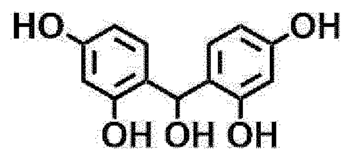
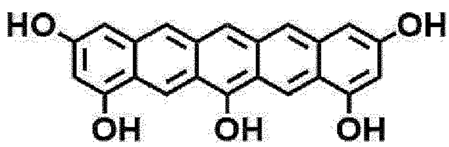
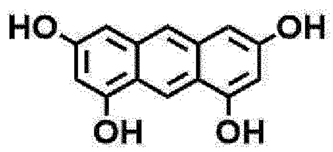
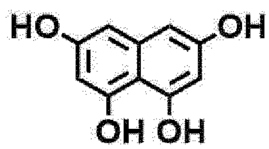

[Epoxy compound]

The composition according to the embodiment of the present invention contains an epoxy compound.

The epoxy compound generally acts as a so-called main agent in the composition according to the embodiment of the present invention.

The epoxy compound is a compound having at least one oxiranyl group (epoxy group) in one molecule. The oxiranyl group may or may not have a substituent, if possible.

The number of oxiranyl groups contained in the epoxy compound is preferably 2 or larger, more preferably 2 to 40, even more preferably 2 to 10, and particularly preferably 2, in one molecule.

A molecular weight of the epoxy compound is preferably 150 to 10,000, more preferably 150 to 2,000, and even more preferably 250 to 400.

An epoxy group content of the epoxy compound is preferably 2.0 to 20.0 mmol/g and more preferably 5.0 to 15.0 mmol/g.

Moreover, the epoxy group content means the number of oxiranyl groups contained in 1 g of the epoxy compound.

The epoxy compound is preferably a liquid at room temperature (23°C).

The epoxy compound may or may not exhibit liquid crystallinity.

That is, the epoxy compound may be a liquid crystal compound. In other words, the epoxy compound may be a liquid crystal compound having an oxiranyl group.

Examples of the epoxy compound (which may be a liquid crystalline epoxy compound) include a compound (rod-like compound) which has a rod-like structure in at least a portion thereof, and a compound (disk-like compound) which has a disk-like structure in at least a portion thereof.

Hereinafter, the rod-like compound and the disk-like compound will be described in detail.

<Rod-like compound>

Examples of the epoxy compound, which is a rod-like compound, include azomethines, azoxies, cyanobiphenyls, cyanophenyl esters, benzoic acid esters, cyclohexane carboxylic acid phenyl esters, cyanophenyl cyclohexanes, cyano-substituted phenylpyrimidines, alkoxy-substituted phenylpyrimidines, phenyldioxanes, tolans, and alkenylcyclohexyl benzonitriles. In addition to these low-molecular-weight compounds described above, high-molecular-weight compounds can also be used. The aforementioned high-molecular-weight compounds are high-molecular-weight compounds obtained by polymerizing rod-like compounds having a low-molecular-weight reactive group.

Examples of a preferred rod-like compound include a rod-like compound represented by General Formula (XXI).

General Formula (XXI): $Q^1\text{-}L^{111}\text{-}A^{111}\text{-}L^{113}\text{-}M\text{-}L^{114}\text{-}A^{112}\text{-}L^{112}\text{-}Q^2$

In General Formula (XXI), $Q^1$ and $Q^2$ are each independently an oxiranyl group, and $L^{111}$, $L^{112}$, $L^{113}$, and $L^{114}$ each independently represent a single bond or a divalent linking group. $A^{111}$ and $A^{112}$ each independently represent a divalent linking group (spacer group) having 1 to 20 carbon atoms. M represents a mesogenic group.

The oxiranyl groups represented by $Q^1$ and $Q^2$ may or may not have a substituent.

In General Formula (XXI), $L^{111}$, $L^{112}$, $L^{113}$, and $L^{114}$ each independently represent a single bond or a divalent linking group.

The divalent linking groups represented by $L^{111}$, $L^{112}$, $L^{113}$, and $L^{114}$ are each independently preferably a divalent linking group selected from the group consisting of -O-, -S-, -CO-, $-NR^{112}-$, -CO-O-, -O-CO-O-, $-CO-NR^{112}-$, $-NR^{112}-CO-$, -O-CO-, $-CH_2-O-$, $-O-CH_2-$, $-O-CO-NR^{112}-$, $-NR^{112}-CO-O-$, and $-NR^{112}-CO-NR^{112}-$. $R^{112}$ is an alkyl group having 1 to 7 carbon atoms or a hydrogen atom.

Among them, $L^{113}$ and $L^{114}$ are each independently preferably -O-.

$L^{111}$ and $L^{112}$ are each independently preferably a single bond.

In General Formula (XXI), $A^{111}$ and $A^{112}$ each independently represent a divalent linking group having 1 to 20 carbon atoms.

The divalent linking group may contain heteroatoms, such as oxygen atoms and sulfur atoms, which are not adjacent to each other. Among them, an alkylene group, an alkenylene group, or an alkynylene group, each of which has 1 to 12 carbon atoms, is preferable. The aforementioned alkylene group, alkenylene group, or alkynylene group may or may not have an ester group.

The divalent linking group is preferably linear, and the divalent linking group may or may not have a substituent. Examples of the substituent include a halogen atom (a fluorine atom, a chlorine atom, and a bromine atom), a cyano group, a methyl group, and an ethyl group.

Among them, $A^{111}$ and $A^{112}$ are each independently preferably an alkylene group having 1 to 12 carbon atoms and more preferably a methylene group.

In General Formula (XXI), M represents a mesogenic group, and examples of the mesogenic group include known mesogenic groups. Among them, a group represented by General Formula (XXII) is preferable.

General Formula (XXII): $-(W^1\text{-}L^{115})_n\text{-}W^2-$

In General Formula (XXII), $W^1$ and $W^2$ each independently represent a divalent cyclic alkylene group, a divalent cyclic alkenylene group, an arylene group, or a divalent heterocyclic group. $L^{115}$ represents a single bond or a divalent linking group. n represents an integer 1 to 4.

Examples of $W^1$ and $W^2$ include 1,4-cyclohexenediyl, 1,4-cyclohexanediyl, 1,4-phenylene, pyrimidine-2,5-diyl, pyridine-2,5-diyl, 1,3,4-thiadiazole-2,5-diyl, 1,3,4-oxadiazole-2,5-diyl, naphthalene-2,6-diyl, naphthalene-1,5-diyl, thiophene-2,5-diyl, and pyridazine-3,6-diyl. In a case of the 1,4-cyclohexanediyl, the compound may be any one isomer of structural isomers of a trans-isomer and a cis-isomer, or a mixture in which the isomers are mixed at any ratio. Among them, a trans-isomer is preferable.

Each of $W^1$ and $W^2$ may have a substituent. Examples of the substituent include the groups exemplified in the aforementioned substituent group Y, and more specifically, examples of the substituent include a halogen atom (a fluorine atom, a chlorine atom, a bromine atom, and an iodine atom), a cyano group, an alkyl group having 1 to 10 carbon atoms

(for example, a methyl group, an ethyl group, a propyl group, and the like), an alkoxy group having 1 to 10 carbon atoms (for example, a methoxy group, an ethoxy group, and the like), an acyl group having 1 to 10 carbon atoms (for example, a formyl group, an acetyl group, and the like), an alkoxycarbonyl group having 1 to 10 carbon atoms (for example, a methoxycarbonyl group, an ethoxycarbonyl group, and the like), an acyloxy group having 1 to 10 carbon atoms (for example, an acetyloxy group, a propionyloxy group, and the like), a nitro group, a trifluoromethyl group, a difluoromethyl group, and the like.

In a case where there are a plurality of $W^1$'s, the plurality of $W^1$'s may be the same as or different from each other.

In General Formula (XXII), $L^{115}$ represents a single bond or a divalent linking group. Examples of the divalent linking group represented by $L^{115}$ include the specific examples of the divalent linking groups represented by $L^{111}$ to $L^{114}$, such as -CO-O-, -O-CO-, $-CH_2-O-$, and $-O-CH_2-$.

In a case where there are a plurality of $L^{115}$'s, the plurality of $L^{115}$'s may be the same as or different from each other.

Examples of a skeleton preferable as the basic skeleton of the mesogenic group represented by General Formula (XXII) will be shown below. Substituents may be substituted in these skeletons of the mesogenic group.

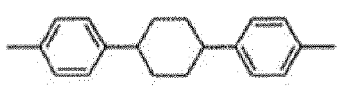
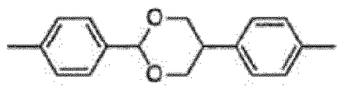
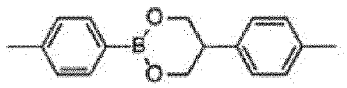
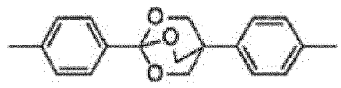
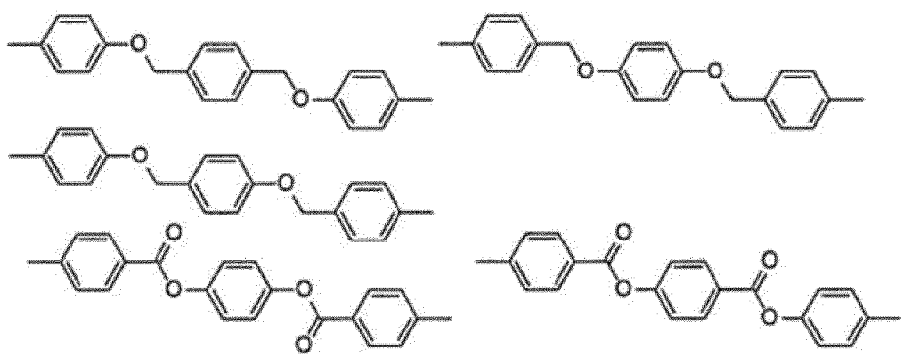
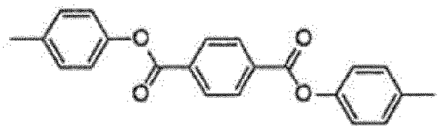
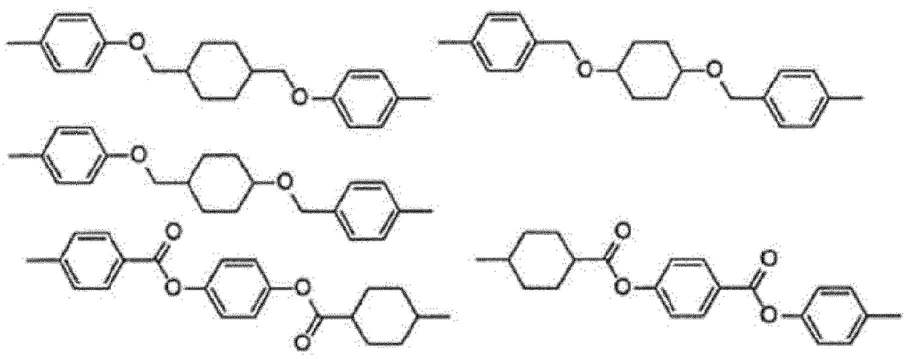

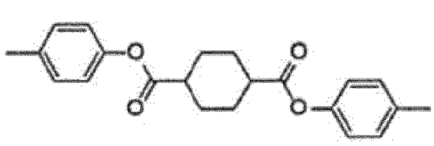
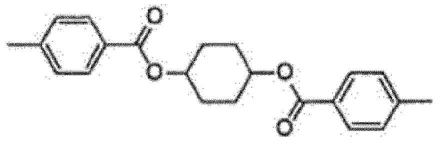

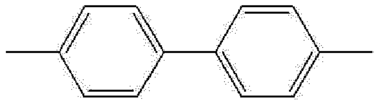

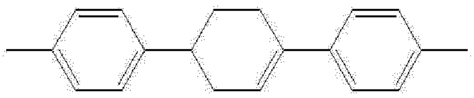

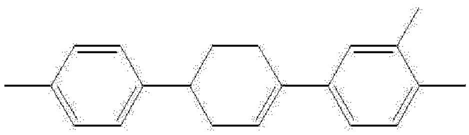

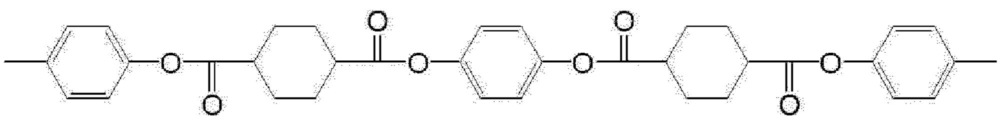

Among the skeletons, a biphenyl skeleton is preferable from the viewpoint that the thermally conductive properties of the obtained thermally conductive material are superior.

Moreover, the compound represented by General Formula (XXI) can be synthesized with reference to the method described in JP1999-513019A (JP-H11-513019A) (WO97/000600A).

The rod-like compound may be a monomer having the mesogenic group described in JP1999-323162A(JP-H11-323162A) and JP4118691B.

Among them, the rod-like compound is preferably a compound represented by General Formula (E1).

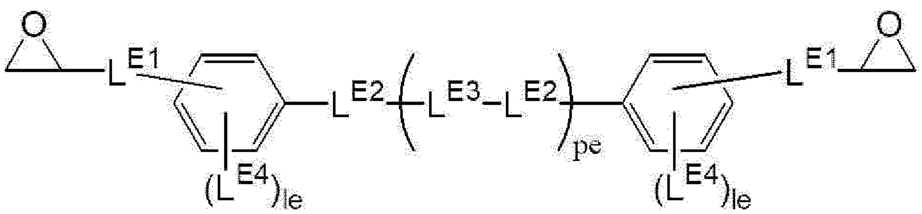

(E1)

In General Formula (E1), $L^{E1}$'s each independently represent a single bond or a divalent linking group.

Among them, $L^{E1}$ is preferably a divalent linking group.

The divalent linking group is preferably -O-, -S-, -CO-, -NH-, -CH=CH-, -C=C-, -CH=N-, -N=CH-, -N=N-, an alkylene group which may have a substituent, or a group consisting of a combination of two or more thereof, and more preferably -O-alkylene group- or -alkylene group-O-.

Moreover, the alkylene group may be any one of linear, branched, or cyclic, but is preferably a linear alkylene group having 1 or 2 carbon atoms.

The plurality of $L^{E1}$'s may be the same as or different from each other.

In General Formula (E1), $L^{E2}$'s each independently represent a single bond, -CH=CH-, -CO-O-, -O-CO-, $-C(-CH_3)=CH-$, $-CH=C(-CH_3)-$, -CH=N-, -N=CH-, -N=N-, -C=C-, $-N=N^+(-O^-)-$, $-N^+(-O^-)=N-$, $-CH=N^+(-O^-)-$, $-N^+(-O^-)=CH-$, -CH=CH-CO-, -CO-CH=CH-, -CH=C(-CN)-, or -C(-CN)=CH-.

Among them, $L^{E2}$'s are each independently preferably a single bond, -CO-O-, or -O-CO-.

In a case where there are a plurality of $L^{E2}$'s, the plurality of $L^{E2}$'s may be the same as or different from each other.

In General Formula (E1), $L^{E3}$'s each independently represent a single bond, a 5-membered or 6-membered aromatic ring group or a 5-membered or 6-membered non-aromatic ring group, which may have a substituent, or a

polycyclic group consisting of these rings.

Examples of the aromatic ring group and non-aromatic ring group represented by $L^{E3}$ include a 1,4-cyclohexanediyl group, a 1,4-cyclohexenediyl group, a 1,4-phenylene group, a pyrimidine-2,5-diyl group, a pyridine-2,5-diyl group, a 1,3,4-thiadiazole-2,5-diyl group, a 1,3,4-oxadiazole-2,5-diyl group, a naphthalene-2,6-diyl group, a naphthalene-1,5-diyl group, a thiophene-2,5-diyl group, and a pyridazine-3,6-diyl group, each of which may have a substituent. In a case of the 1,4-cyclohexanediyl group, the group may be any one isomer of structural isomers of a trans-isomer and a cis-isomer, or a mixture in which the isomers are mixed at any ratio. Among them, a trans-isomer is preferable.

In particular, $L^{E3}$ is preferably a single bond, a 1,4-phenylene group, or a 1,4-cyclohexenediyl group.

The substituents contained in the groups represented by $L^{E3}$ are each independently preferably an alkyl group, an alkoxy group, a halogen atom, a cyano group, a nitro group, or an acetyl group, and more preferably an alkyl group (preferably having one carbon atom).

Furthermore, in a case where there are a plurality of substituents, the plurality of substituents may be the same as or different from each other.

In a case where there are a plurality of $L^{E3}$'s, the plurality of $L^{E3}$'s may be the same as or different from each other.

In General Formula (E1), pe represents an integer of 0 or greater.

In a case where pe is an integer of 2 or greater, a plurality of (-$L^{E3}$-$L^{E2}$ -)'s may be the same as or different from each other.

Among them, pe is preferably 0 to 2, more preferably 0 or 1, and even more preferably 0.

In General Formula (E1), $L^{E4}$'s each independently represent a substituent.

The substituents are each independently preferably an alkyl group, an alkoxy group, a halogen atom, a cyano group, a nitro group, or an acetyl group, and more preferably an alkyl group (preferably having one carbon atom).

A plurality of $L^{E4}$'s may be the same as or different from each other. Moreover, in a case where le described below is an integer of 2 or greater, a plurality of $L^{E4}$'s in the same $(L^{E4})_{le}$ may also be the same as or different from each other.

In General Formula (E1), le's each independently represent an integer of 0 to 4. Among them, le's are each independently preferably 0 to 2.

A plurality of le's may be the same as or different from each other.

The rod-like compound preferably has a biphenyl skeleton from the viewpoint that the thermally conductive properties of the obtained thermally conductive material are superior.

In other words, it is preferable that the epoxy compound has a biphenyl skeleton and more preferable that the epoxy compound in this case is a rod-like compound.

<Disk-like compound>

The epoxy compound, which is a disk-like compound, has a disk-like structure in at least a portion thereof.

The disk-like structure has at least an alicyclic ring or an aromatic ring. In particular, in a case where the disk-like structure has an aromatic ring, the disk-like compound can form a columnar structure by forming a stacking structure based on the intermolecular $\pi$-$\pi$ interaction.

Specific examples of the disk-like structure include the triphenylene structure described in Angew. Chem. Int. Ed. 2012, 51, 7990 to 7993, or JP1995-306317A (JP-H07-306317A), and the trisubstituted benzene structures described in JP2007-002220A and JP2010-244038A.

The disk-like compound preferably has three or more oxiranyl groups. The cured substance of the composition, which contains the disk-like compound having three or more oxiranyl groups, tends to have a high glass transition temperature and high heat resistance.

The number of oxiranyl groups contained in the disk-like compound is preferably 8 or smaller and more preferably 6 or smaller.

Specific examples of the disk-like compound include compounds which have an oxiranyl group at at least one (preferably, three or more) of terminals in the compounds or the like described in C. Destrade et al., Mol. Crysr. Liq. Cryst., vol. 71, page 111 (1981); edited by The Chemical Society of Japan, Quarterly Review of Chemistry, No. 22, Chemistry of liquid crystal, Chapter 5, Chapter 10, Section 2 (1994); B. Kohne et al., Angew. Chem. Soc. Chem. Comm., page 1794 (1985); J. Zhang et al., J. Am. Chem. Soc., vol. 116, page 2655 (1994); and JP4592225B.

Examples of the disk-like compound include compounds which have an oxiranyl group at at least one (preferably, three or more) of terminals in the triphenylene structure described in Angew. Chem. Int. Ed. 2012, 51, 7990 to 7993 and JP1995-306317A (JP-H07-306317A) and the trisubstituted benzene structures described in JP2007-002220A and JP2010-244038A.

The disk-like compound is preferably a compound represented by any one of Formula (D1), ..., or Formula (D16) from the viewpoint that the thermally conductive properties of the thermally conductive material are superior.

First, Formulae (D1) to (D15) will be described, and then Formula (D16) will be described.

Furthermore, in the following formulae, "-LQ" represents "-L-Q" and "QL-" represents "Q-L-".

(D1)

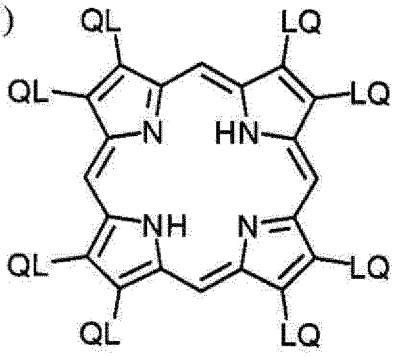

(D2)

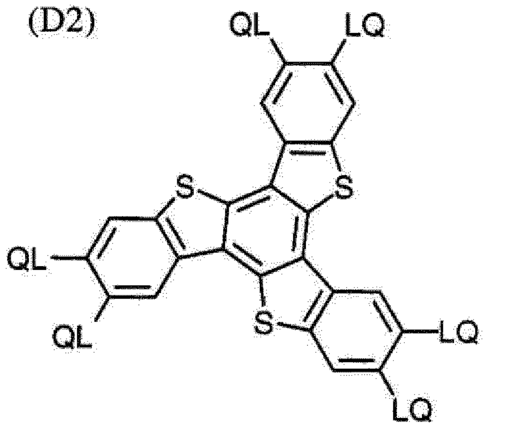

(D3)

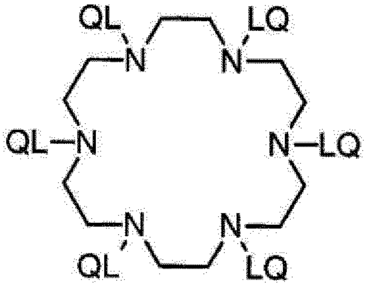

(D4)

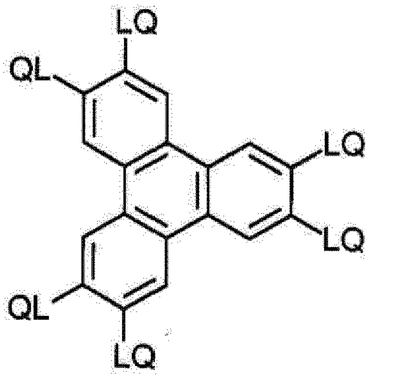

(D5)

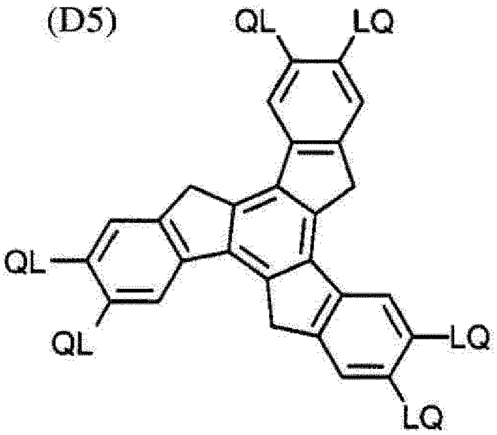

(D6)

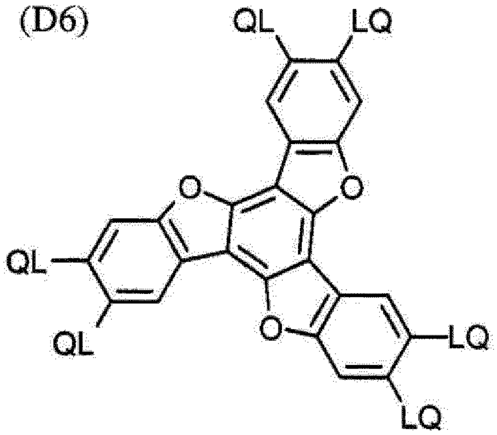

(D7)

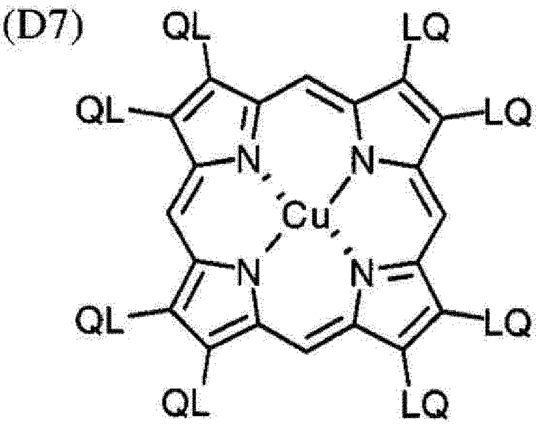

(D8)

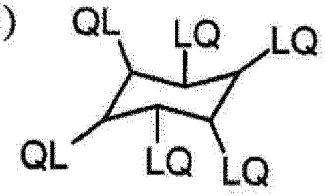

(D9)

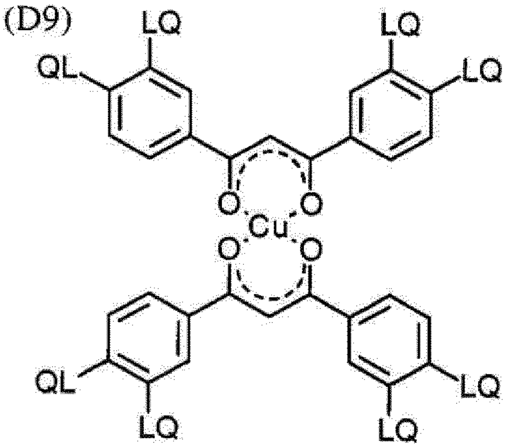

(D10)

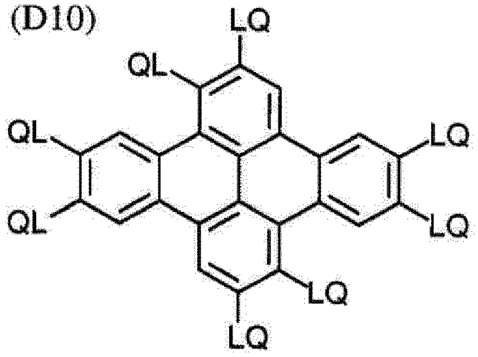

(D11)

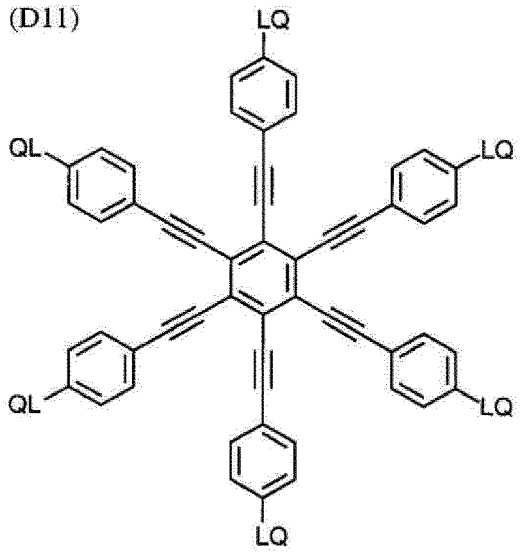

(D12)

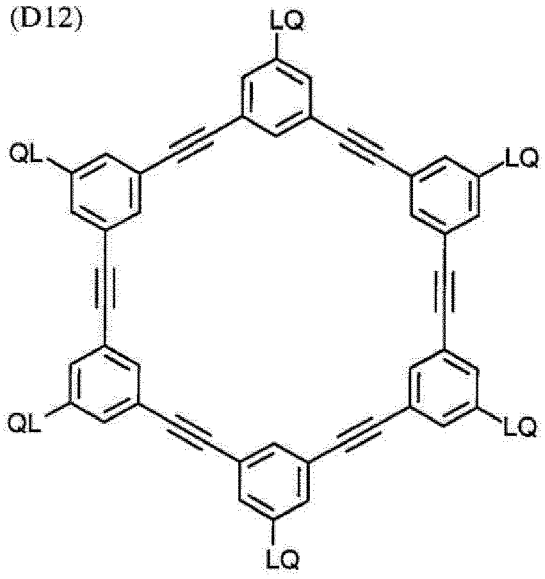

(D13)

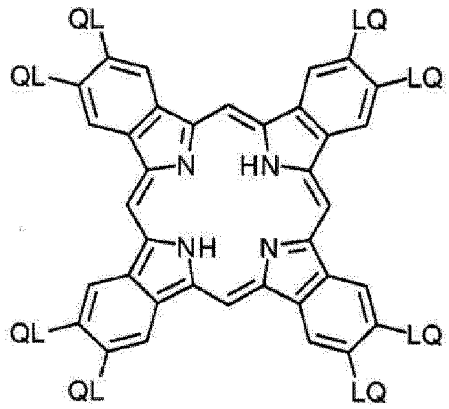

(D14)

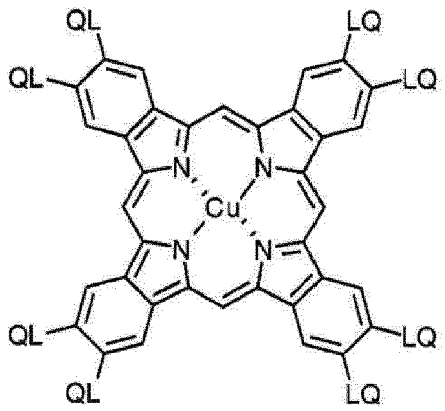

(D15)

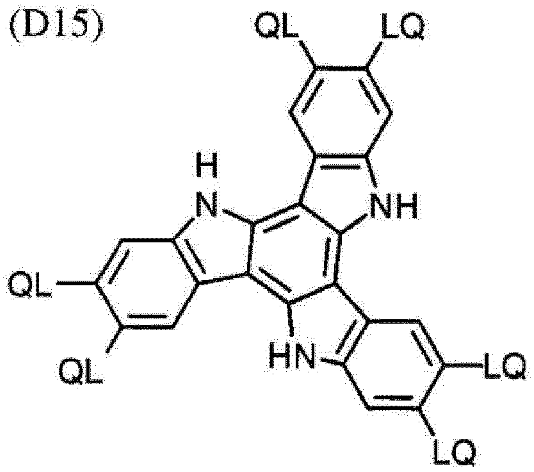

In Formulae (D1) to (D15), L represents a divalent linking group.

From the viewpoint that the thermally conductive properties of the thermally conductive material are superior, L's are each independently preferably a group selected from the group consisting of an alkylene group, an alkenylene group, an arylene group, -CO-, -NH-, -O-, -S-, and a combination thereof, and more preferably a group obtained by combining two or more groups selected from the group consisting of an alkylene group, an alkenylene group, an arylene group, -CO-, -NH-, -O-, and -S-.

The number of carbon atoms in the alkylene group is preferably 1 to 12. The number of carbon atoms in the alkenylene group is preferably 2 to 12. The number of carbon atoms in the arylene group is preferably 10 or smaller.

The alkylene group, alkenylene group, and arylene group may have a substituent (preferably, an alkyl group, a halogen atom, cyano, an alkoxy group, an acyloxy group, or the like).

Examples of L will be shown below. In the following examples, a bond on a left side is bonded to a central structure (hereinafter, also simply referred to as a "central ring") of the compound represented by any one of Formula (D1), ..., or Formula (D15), and a bond on a right side is bonded to Q.

AL means an alkylene group or an alkenylene group, and AR means an arylene group.

L101: -AL-CO-O-AL-

L102: -AL-CO-O-AL-O-
L103: -AL-CO-O-AL-O-AL-
L104: -AL-CO-O-AL-O-CO-
L105: -CO-AR-O-AL-
L106: -CO-AR-O-AL-O-
L107: -CO-AR-O-AL-O-CO-
L108: -CO-NH-AL-
L109: -NH-AL-O-
L110: -NH-AL-O-CO-

L111: -O-AL-
L112: -O-AL-O-
L113: -O-AL-O-CO-

L114: -O-AL-O-CO-NH-AL-

L115: -O-AL-S-AL-
L116: -O-CO-AL-AR-O-AL-O-CO-
L117: -O-CO-AR-O-AL-CO-
L118: -O-CO-AR-O-AL-O-CO-
L119: -O-CO-AR-O-AL-O-AL-O-CO-
L120: -O-CO-AR-O-AL-O-AL-O-AL-O-CO-
L121: -S-AL-
L122: -S-AL-O-
L123: -S-AL-O-CO-
L124: -S-AL-S-AL-
L125: -S-AR-AL-
L126: -O-CO-AL-
L127: -O-CO-AL-O-
L128: -O-CO-AR-O-AL-
L129: -O-CO-
L130: -O-CO-AR-O-AL-O-CO-AL-S-AR-
L131: -O-CO-AL-S-AR-
L132: -O-CO-AR-O-AL-O-CO-AL-S-AL-
L133: -O-CO-AL-S-AR-
L134: -O-AL-S-AR-
L135: -AL-CO-O-AL-O-CO-AL-S-AR-
L136: -AL-CO-O-AL-O-CO-AL-S-AL-
L137: -O-AL-O-AR-
L138: -O-AL-O-CO-AR-
L139: -O-AL-NH-AR-
L140: -O-CO-AL-O-AR-
L141: -O-CO-AR-O-AL-O-AR-
L142: -AL-CO-O-AR-
L143: -AL-CO-O-AL-O-AR-

In Formulae (D1) to (D15), Q's each independently represent a hydrogen atom or a substituent.

Examples of the substituent include the groups exemplified in the aforementioned substituent group Y More specifically, as the substituent, the reactive functional group, the halogen atom, the isocyanate group, the cyano group, the unsaturated polymerizable group, the oxiranyl group, the oxetanyl group, the aziridinyl group, the thioisocyanate group, the aldehyde group, and the sulfo group can be mentioned.

Here, in a case where Q is a group other than the oxiranyl group, it is preferable that Q is stable with respect to the oxiranyl group.

Moreover, in Formulae (D1) to (D15), one or more (preferably two or more) Q's each represent an oxiranyl group. Among them, from the viewpoint that the thermally conductive properties of the thermally conductive material are superior, it is preferable that all Q's each represent an oxiranyl group.

Furthermore, it is preferable that the compounds represented by Formulae (D1) to (D15) do not have -NH- from the viewpoint of stability of an oxiranyl group.

Among the compounds represented by Formulae (D1) to (D15), from the viewpoint that the thermally conductive properties of the thermally conductive material are superior, the compound represented by Formula (D4) is preferable. In other words, the central ring of the disk-like compound is preferably a triphenylene ring.

From the viewpoint that the thermally conductive properties of the thermally conductive material are superior, the compound represented by Formula (D4) is preferably a compound represented by Formula (XI).

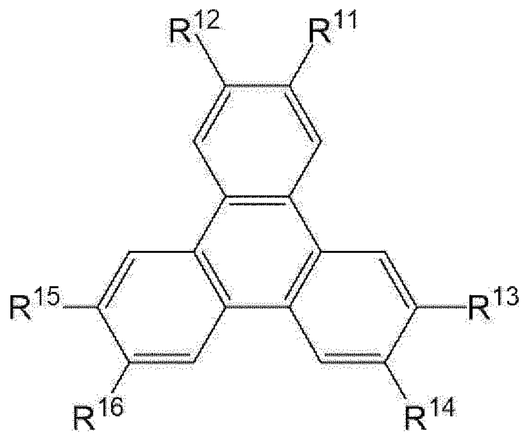

Formula (XI)

In Formula (XI), $R^{11}$, $R^{12}$, $R^{13}$, $R^{14}$, $R^{15}$, and $R^{16}$ each independently represent $*-X^{11}-L^{11}-P^{11}$ or $*-X^{12}-L^{12}-Y^{12}$.

Moreover, * represents a position bonded to a triphenylene ring.

Among $R^{11}$, $R^{12}$, $R^{13}$, $R^{14}$, $R^{15}$, and $R^{16}$, two or more are $*-X^{11}-L^{11}-P^{11}$, and it is preferable that three or more are $*-X^{11}-L^{11}-P^{11}$.

Among them, from the viewpoint that the thermally conductive properties of the thermally conductive material are superior, it is preferable that any one or more of $R^{11}$ or $R^{12}$, any one or more of $R^{13}$ or $R^{14}$, and any one or more of $R^{15}$ or $R^{16}$ are $*-X^{11}-L^{11}-P^{11}$.

It is more preferable that $R^{11}$, $R^{12}$, $R^{13}$, $R^{14}$, $R^{15}$, and $R^{16}$ are all $*-X^{11}-L^{11}-P^{11}$. Moreover, it is even more preferable that $R^{11}$, $R^{12}$, $R^{13}$, $R^{14}$, $R^{15}$, and $R^{16}$ are all the same.

$X^{11}$'s each independently represent a single bond, -O-, -CO-, -NH-, -O-CO-, -O-CO-O-, -O-CO-NH-, -O-CO-S-, -CO-O-, -CO-NH-, -CO-S-, -NH-CO-, -NH-CO-O-, -NH-CO-NH-, -NH-CO-S-, -S-, -S-CO-, -S-CO-O-, -S-CO-NH-, or -S-CO-S-.

Among them, $X^{11}$'s are each independently preferably -O-, -O-CO-, -O-CO-O-, -O-CO-NH-, -CO-O-, -CO-NH-, -NH-CO-, or -NH-CO-O-, more preferably -O-, -O-CO-, -CO-O-, -O-CO-NH-, or -CO-NH-, and even more preferably -O-CO- or -CO-O-.

$L^{11}$'s each independently represent a single bond or a divalent linking group.

Examples of the divalent linking group include -O-, -O-CO-, -CO-O-, -S-, -NH-, an alkylene group (the number of carbon atoms is preferably 1 to 10, more preferably 1 to 8, and even more preferably 1 to 7), an arylene group (the number of carbon atoms is preferably 6 to 20, more preferably 6 to 14, and even more preferably 6 to 10), or a group consisting of a combination thereof.

Examples of the alkylene group include a methylene group, an ethylene group, a propylene group, a butylene group, a pentylene group, a hexylene group, and a heptylene group.

Examples of the arylene group include a 1,4-phenylene group, a 1,3-phenylene group, a 1,4-naphthylene group, a 1,5-naphthylene group, and an anthracenylene group, and a 1,4-phenylene group is preferable.

Each of the alkylene group and the arylene group may have a substituent. The number of the substituents is preferably 1 to 3 and more preferably 1. The substitution position of the substituent is not particularly limited. As the substituent, a halogen atom or an alkyl group having 1 to 3 carbon atoms is preferable and a methyl group is more preferable.

It is also preferable that the alkylene group and the arylene group are unsubstituted. It is particularly preferable that the alkylene group is unsubstituted.

Examples of $-X^{11}-L^{11}-$ include L101 to L143 which are the aforementioned examples of L.

$P^{11}$ represents an oxiranyl group. The oxiranyl group may or may not have a substituent.

$X^{12}$ is the same as $X^{11}$, and the suitable conditions thereof are also the same.

$L^{12}$ is the same as $L^{11}$, and the suitable conditions thereof are also the same.

Examples of $-X^{12}-L^{12}-$ include L101 to L143 which are the aforementioned examples of L.

$Y^{12}$ represents a hydrogen atom, a linear, branched, or cyclic alkyl group having 1 to 20 carbon atoms, or a group obtained by substituting one methylene group or two or more methylene groups in a linear, branched, or cyclic alkyl group having 1 to 20 carbon atoms with -O-, -S-, -NH-, $-N(CH_3)-$, -CO-, -O-CO-, or -CO-O-.

In a case where $Y^{12}$ is a linear, branched, or cyclic alkyl group having 1 to 20 carbon atoms or a group obtained by substituting one methylene group or two or more methylene groups in a linear, branched, or cyclic alkyl group having 1 to 20 carbon atoms with -O-, -S-, -NH-, $-N(CH_3)-$, -CO-, -O-CO-, or -CO-O-, one or more hydrogen atoms contained in $Y^{12}$ may be substituted with halogen atoms.

Specific examples of the compound represented by Formula (XI) include compounds which have an oxiranyl

group at at least one (preferably, three or more) of terminals in compounds described in paragraphs 0028 to 0036 in JP1995-281028A (JP-H07-281028A), JP1995-306317A (JP-H07-306317A), paragraphs 0016 to 0018 in JP2005-156822A, paragraphs 0067 to 0072 in JP2006-301614A, and Liquid Crystal Handbook (published by MARUZEN Co., Ltd. in 2000), pp. 330 to 333.

The compound represented by Formula (XI) can be synthesized based on the methods described in JP1995-306317A (JP-H07-306317A), JP1995-281028A (JP-H07-281028A), JP2005-156822A, and JP2006-301614A.

In addition, from the viewpoint that the thermally conductive properties of the thermally conductive material are superior, the compound represented by Formula (D16) is also preferable as the disk-like compound.

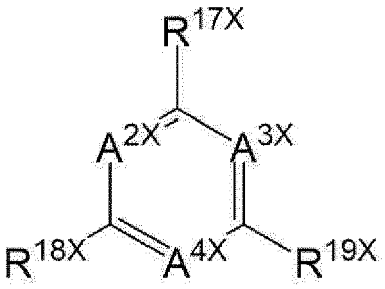

(D16)

In Formula (D16), $A^{2X}$, $A^{3x}$, and $A^{4X}$ each independently represent -CH= or -N=. Among them, $A^{2X}$, $A^{3X}$, and $A^{4X}$ are each independently preferably -CH=.

$R^{17X}$, $R^{18X}$, and $R^{19X}$ each independently represent $*\text{-}X^{211X}\text{-}(Z^{21X}\text{-}X^{212X})_{n21X}\text{-}L^{21X}\text{-}Q$. * represents a position bonded to the central ring.

$X^{211X}$ and $X^{212X}$ each independently represent a single bond, -O-, -CO-, -NH-, -O-CO-, -O-CO-O-, -O-CO-NH-, -O-CO- S-, -CO-O-, -CO-NH-, -CO-S-, -NH-CO-, -NH-CO-O-, -NH-CO-NH-, -NH-CO-S-, -S-, -S-CO-, -S-CO-O-, -S-CO-NH-, or -S-CO-S-.

$Z^{21X}$'s each independently represent a 5-membered or 6-membered aromatic ring group or a 5-membered or 6-membered non-aromatic ring group.

$L^{21X}$ represents a single bond or a divalent linking group.

Q has the same definition as Q in Formulae (D1) to (D15), and the preferred conditions thereof are also the same. In Formula (D16), at least one (preferably all) Q among a plurality of Q's represents an oxiranyl group.

n21X represents an integer 0 to 3. In a case where n21X is 2 or greater, a plurality of $(Z^{21X}\text{-}X^{212X})$'s may be the same as or different from each other.

Here, it is preferable that the compound represented by Formula (D16) does not have -NH- from the viewpoint of stability of an oxiranyl group.

The compound represented by Formula (D16) is preferably a compound represented by Formula (XII).

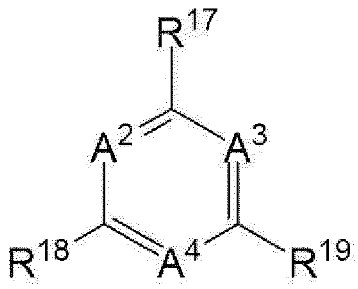

(XII)

In Formula (XII), $A^2$, $A^3$, and $A^4$ each independently represent -CH= or -N=. Among them, $A^2$, $A^3$, and $A^4$ are each preferably -CH=. In other words, it is also preferable that the central ring of the disk-like compound is a benzene ring.

$R^{17}$, $R^{18}$, and $R^{19}$ each independently represent $*\text{-}X^{211}\text{-}(Z^{21}\text{-}X^{212})_{n21}\text{-}L^{21}\text{-}P^{21}$ or $*\text{-}X^{221}\text{-}(Z^{22}\text{-}X^{222})_{n22}\text{-}Y^{22}$. * represents a position bonded to the central ring.

Two or more among $R^{17}$, $R^{18}$, and $R^{19}$ are each $*\text{-}X^{211}\text{-}(Z^{21}\text{-}X^{212})_{n21}\text{-}L^{21}\text{-}P^{21}$. From the viewpoint that the thermally conductive properties of the thermally conductive material are superior, it is preferable that $R^{17}$, $R^{18}$, and $R^{19}$ are all $*\text{-}X^{211}\text{-}(Z^{21}\text{-}X^{212})_{n21}\text{-}L^{21}\text{-}P^{21}$.

Moreover, it is preferable that $R^{17}$, $R^{18}$, and $R^{19}$ are all the same.

$X^{211}$, $X^{212}$, $X^{221}$, and $X^{222}$ each independently represent a single bond, -O-, -CO-, -NH-, -O-CO-, -O-CO-O-,

-O-CO-NH-, -O-CO- S-, -CO-O-, -CO-NH-, -CO-S-, -NH-CO-, -NH-CO-O-, -NH-CO-NH-, -NH-CO-S-, -S-, -S-CO-, -S-CO-O-, -S-CO-NH-, or -S-CO-S-.

Among them, $X^{211}$, $X^{212}$, $X^{221}$, and $X^{222}$ are each independently preferably a single bond, -O-, -CO-O-, or -O-CO-.

$Z^{21}$ and $Z^{22}$ each independently represent a 5-membered or 6-membered aromatic ring group or a 5-membered or 6-membered non-aromatic ring group, and examples thereof include a 1,4-phenylene group, a 1,3-phenylene group, and an aromatic heterocyclic group.

The aromatic ring group and the non-aromatic ring group may have a substituent. The number of the substituents is preferably 1 or 2 and more preferably 1. The substitution position of the substituent is not particularly limited. As the substituent, a halogen atom or a methyl group is preferable. It is also preferable that the aromatic ring group and the non-aromatic ring group are unsubstituted.

Examples of the aromatic heterocyclic group include the following aromatic heterocyclic groups.

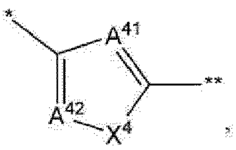 , 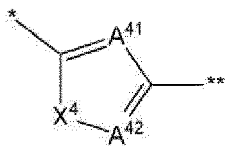 , 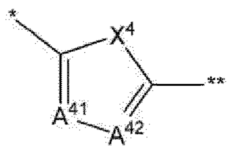

In the formulae, * represents a portion bonded to $X^{211}$ or $X^{221}$. ** represents a portion bonded to $X^{212}$ or $X^{222}$. $A^{41}$ and $A^{42}$ each independently represent a methine group or a nitrogen atom. $X^4$ represents an oxygen atom, a sulfur atom, a methylene group, or an imino group.

It is preferable that at least one of $A^{41}$ or $A^{42}$ represents a nitrogen atom, and more preferable that both $A^{41}$ and $A^{42}$ represent nitrogen atoms. Moreover, $X^4$ is preferably an oxygen atom.

In a case where n21 and n22, which will be described later, are each 2 or greater, a plurality of ($Z^{21}$-$X^{212}$)'s may be the same as or different from each other and a plurality of ($Z^{22}$-$X^{222}$)'s may be the same as or different from each other.

$L^{21}$'s each independently represent a single bond or a divalent linking group, and have the same definitions as $L^{11}$ in Formula (XI). $L^{21}$ is preferably -O-, -O-CO-, -CO-O-, -S-, -NH-, an alkylene group (the number of carbon atoms is preferably 1 to 10, more preferably 1 to 8, and even more preferably 1 to 7), an arylene group (the number of carbon atoms is preferably 6 to 20, more preferably 6 to 14, and even more preferably 6 to 10), or a group consisting of a combination thereof.

In a case where n22, which will be described later, is 1 or greater, examples of -$X^{212}$-$L^{21}$- include L101 to L143 which are the aforementioned examples of L in Formulae (D1) to (D15).

$P^{21}$ represents an oxiranyl group. The oxiranyl group may or may not have a substituent.

$Y^{22}$'s each independently represent a hydrogen atom, a linear, branched, or cyclic alkyl group having 1 to 20 carbon atoms, or a group obtained by substituting one methylene group or two or more methylene groups in a linear, branched, or cyclic alkyl group having 1 to 20 carbon atoms with -O-, -S-, -NH-, -N($CH_3$)-, -CO-, -O-CO-, or -CO-O-, and have the same definitions as $Y^{12}$ in General Formula (XI), and the preferred ranges thereof are also the same.

n21 and n22 each independently represent an integer of 0 to 3, and are each preferably an integer of 1 to 3 and more preferably 2 or 3 from the viewpoint that the thermally conductive properties are superior.

Preferred examples of the disk-like compound include the following compounds.

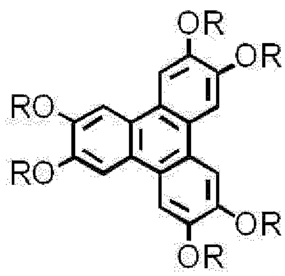

R = 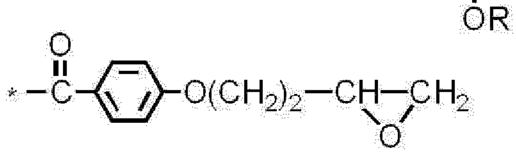 R = 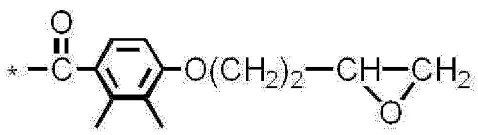

R = 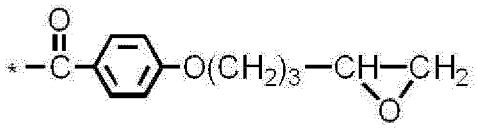 R = 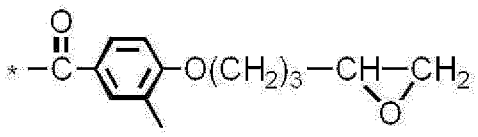

R = 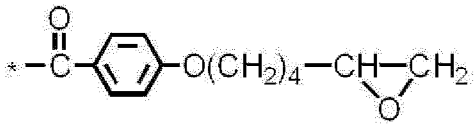 R = 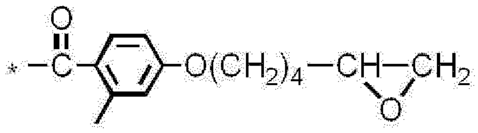

R = 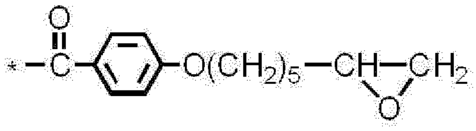 R = 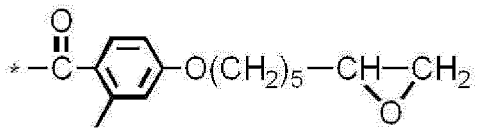

R = 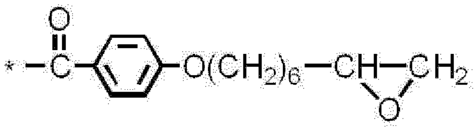 R = 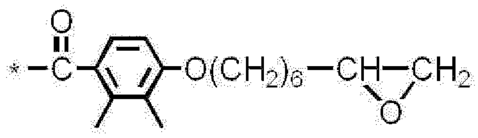

R = 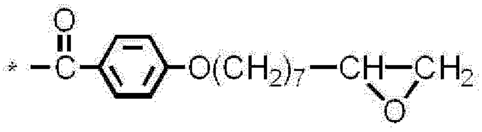 R = 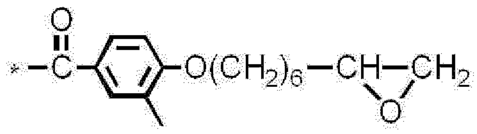

R = 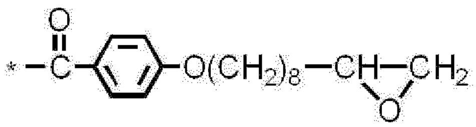 R = 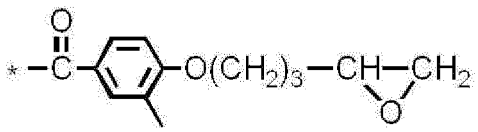

R = 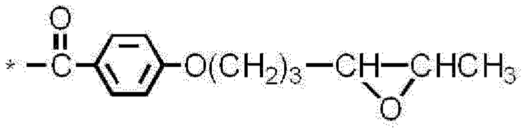 R = 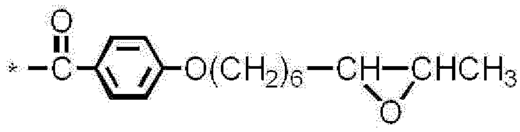

R = 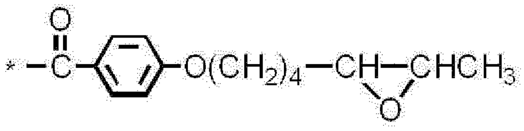 R = 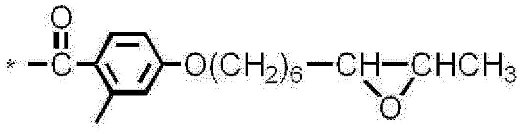

R = 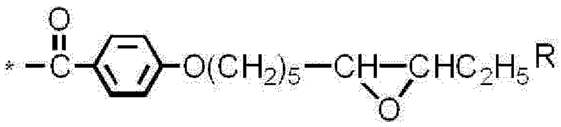 R = 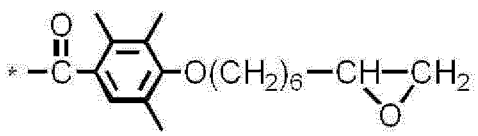

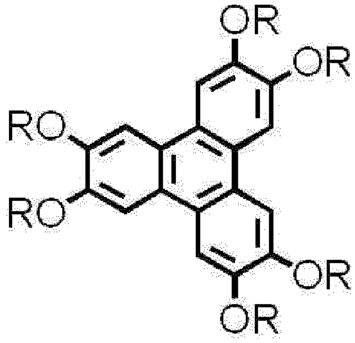

R = 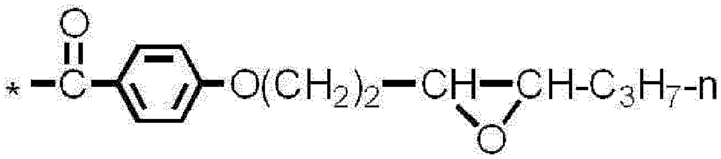

R = 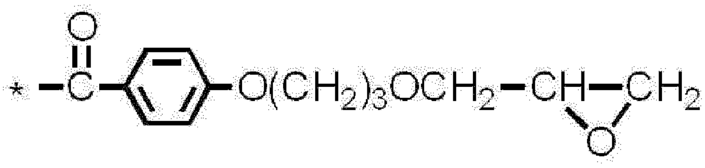

R = 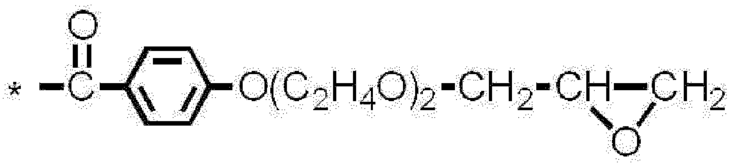

R = 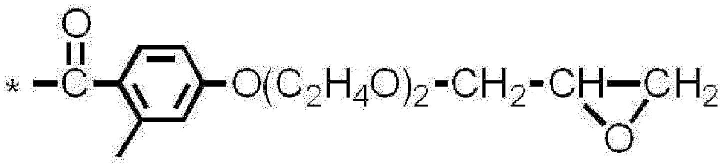

R = 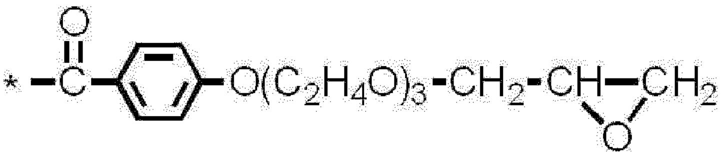

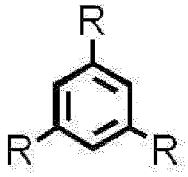

R = 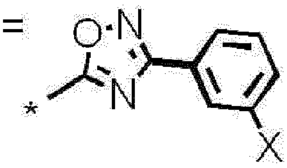

X =

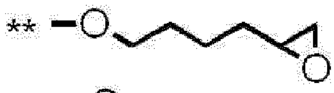

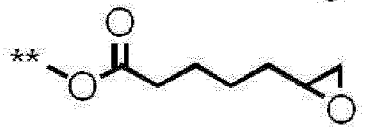

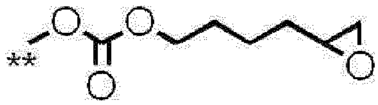

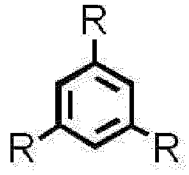

R = 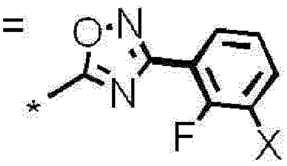

X =

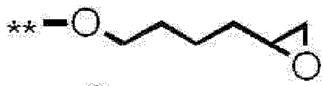

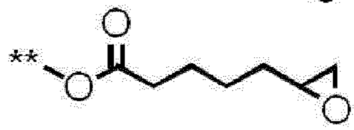

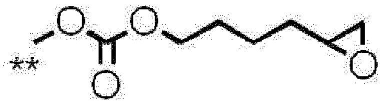

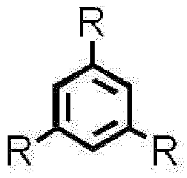

R = 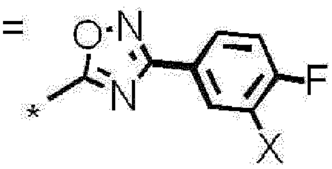

X =

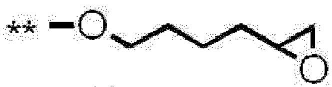

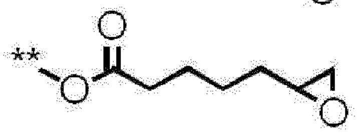

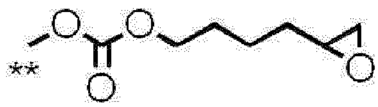

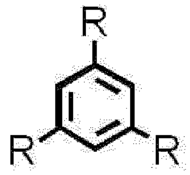

R =

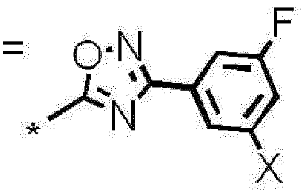

X =

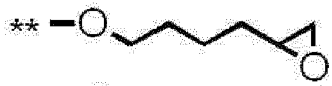

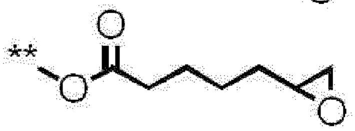

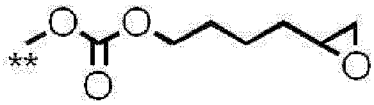

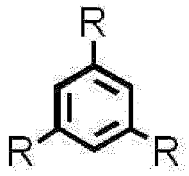

R =

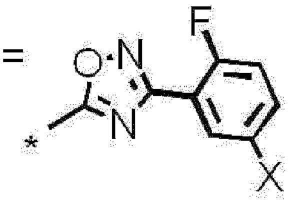

X =

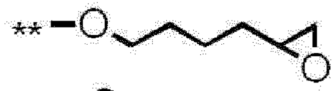

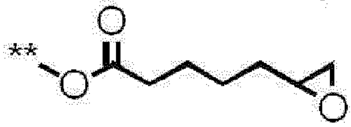

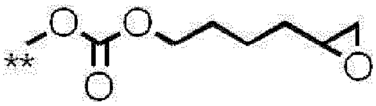

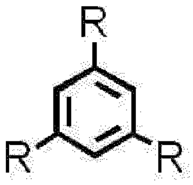

R =

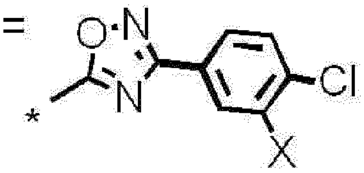

X =

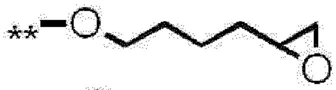

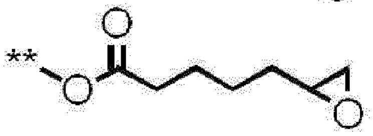

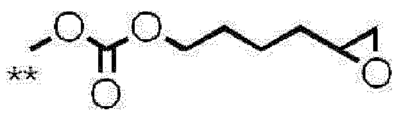

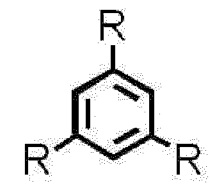

R =

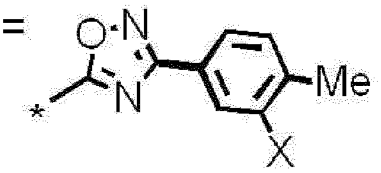

X =

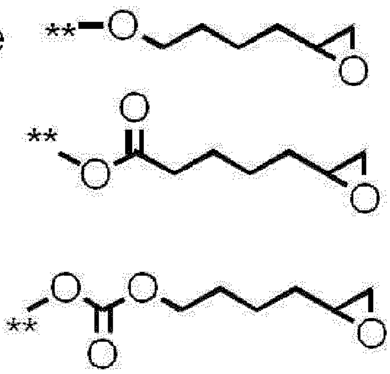

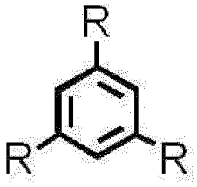

R =

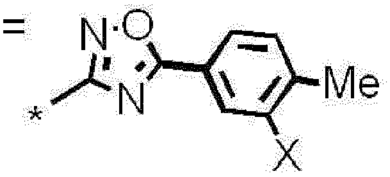

X =

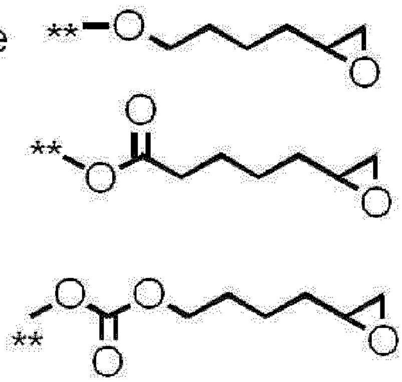

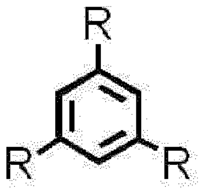

R =

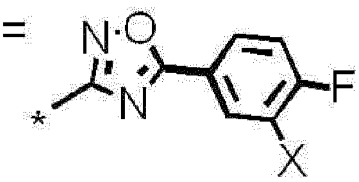

X =

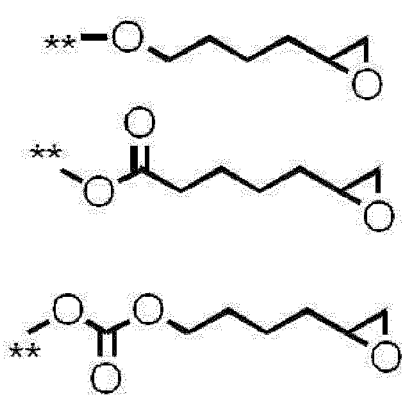

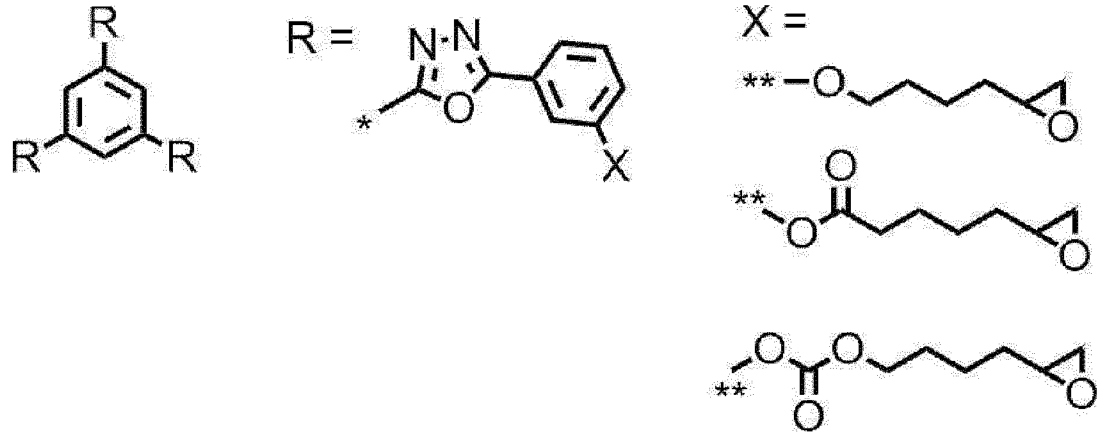

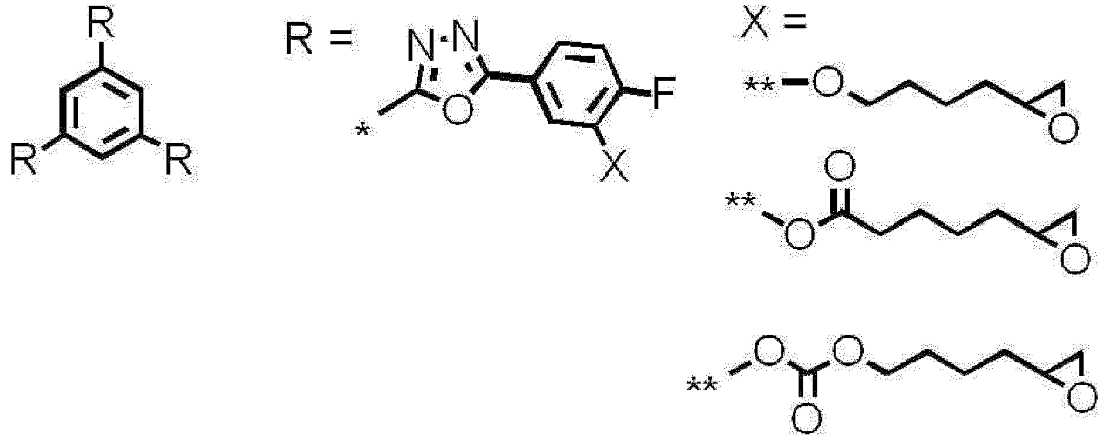

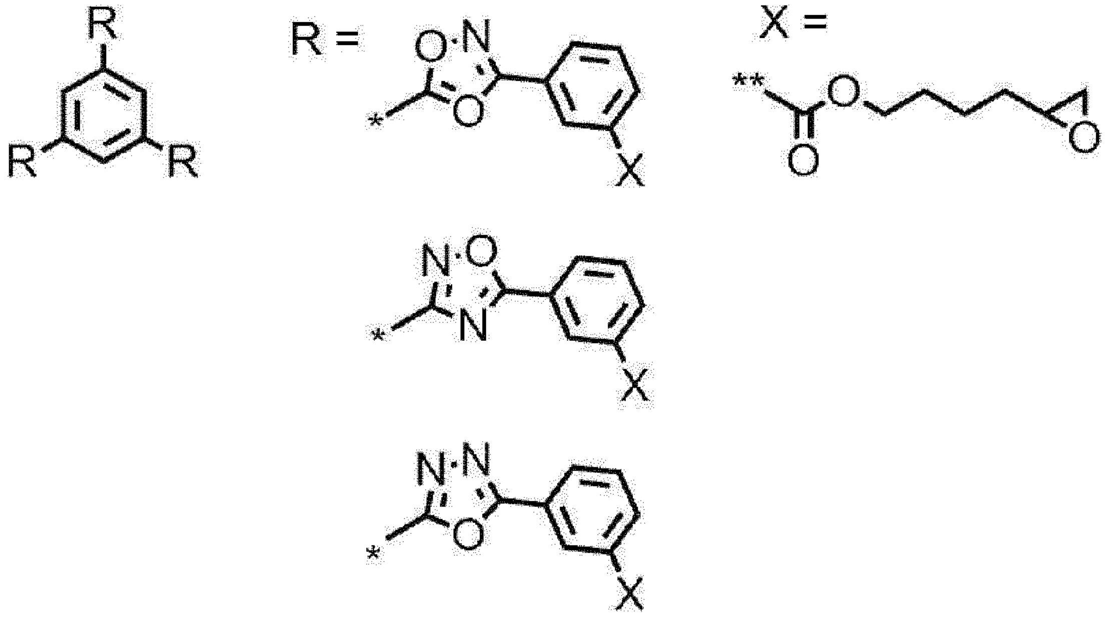

Furthermore, in the following structural formulae, R represents $-X^{212}-L^{21}-P^{21}$.

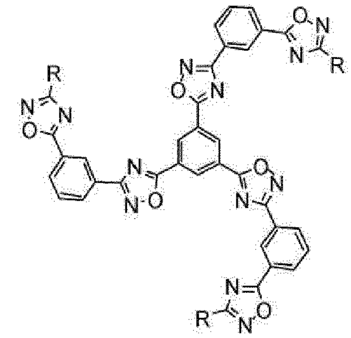
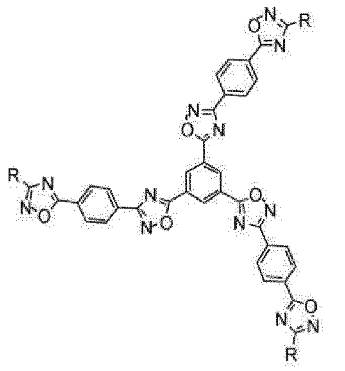
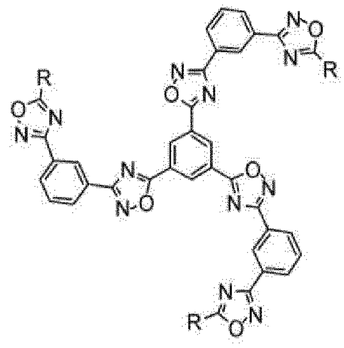
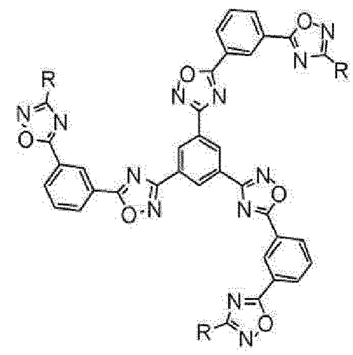
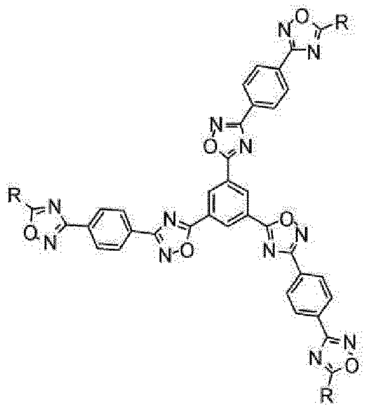
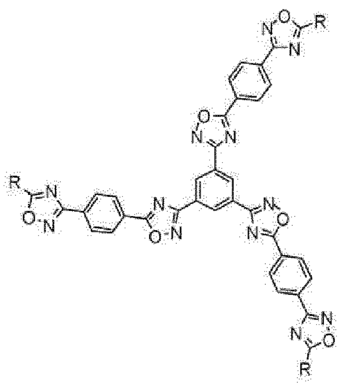
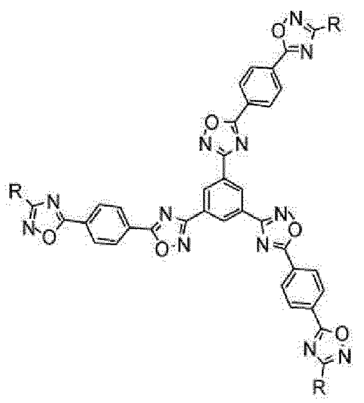
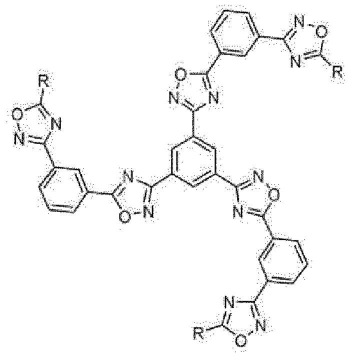

Regarding the details and specific examples of the compound represented by Formula (XII), compounds which have an oxiranyl group at at least one (preferably, three or more) of terminals in the compound described in paragraphs 0013 to 0077 in JP2010-244038A can be referred to.

The compound represented by Formula (XII) can be synthesized based on the methods described in JP2010-244038A, JP2006-076992A, and JP2007-002220A.

In addition, from the viewpoint that stacking is reinforced by reducing an electron density to make it easy to form a columnar aggregate, it is also preferable that the disk-like compound is a compound having a hydrogen-bonding functional group. Examples of the hydrogen-bonding functional group include -O-CO-NH-, -CO-NH-, -NH-CO-, -NH-CO-O-, -NH-CO-NH-, -NH-CO-S-, or -S-CO-NH-.

<Other epoxy compounds>

Examples of other epoxy compounds except for the aforementioned epoxy compound include an epoxy compound represented by General Formula (DN).

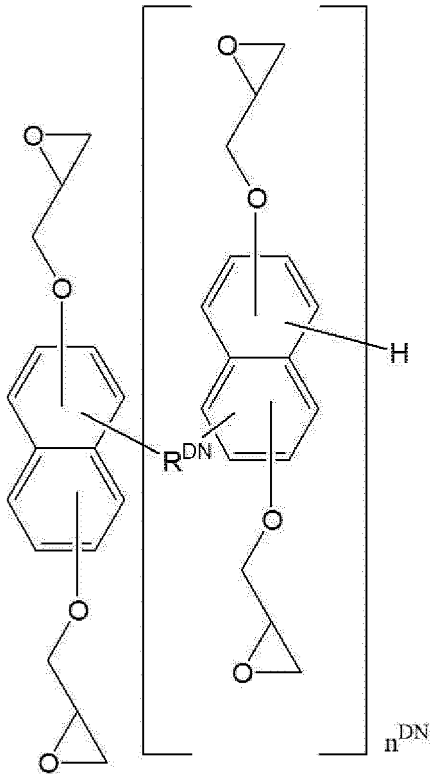

(DN)

In General Formula (DN), $n^{DN}$ represents an integer of 0 or greater, and is preferably 0 to 5 and more preferably 1.

$R^{DN}$ represents a single bond or a divalent linking group. The divalent linking group is preferably -O-, -O-CO-, -CO-O-, -S-, an alkylene group (the number of carbon atoms is preferably 1 to 10), an arylene group (the number of carbon atoms is preferably 6 to 20), or a group consisting of a combination thereof, more preferably an alkylene group, and even more preferably a methylene group.

As the other epoxy compounds, a compound in which an oxiranyl group is fused is also mentioned. Examples of such a compound include 3,4:8,9-diepoxybicyclo[4.3.0]nonane.

Examples of the other epoxy compounds include, in addition to the aforementioned epoxy compounds, a bisphenol A type epoxy compound, a bisphenol F type epoxy compound, a bisphenol S type epoxy compound, a bisphenol AD type epoxy compound, and the like, which are glycidyl ethers of bisphenol A, F, S, and AD; a hydrogenated bisphenol A type epoxy compound, a hydrogenated bisphenol AD type epoxy compound, and the like; a phenol novolac type glycidyl ether (phenol novolac type epoxy compound), a cresol novolac type glycidyl ether (cresol novolac type epoxy compound), a bisphenol A novolac type glycidyl ether, and the like; a dicyclopentadiene type glycidyl ether (dicyclopentadiene type epoxy compound); a dihydroxypentadiene type glycidyl ether (dihydroxypentadiene type epoxy compound); a polyhydroxybenzene type glycidyl ether (polyhydroxybenzene type epoxy compound); a benzene polycarboxylic acid type glycidyl ester (benzene polycarboxylic acid type epoxy compound); and a trisphenol methane type epoxy compound.

One kind of the epoxy compounds may be used singly, or two or more kinds thereof may be used.

A ratio of the content of the epoxy compound to the content of the phenolic compound in the composition is preferably such that an equivalent ratio (the number of oxiranyl groups/the number of hydroxyl groups) of the oxiranyl group of the epoxy compound to the hydroxyl group of the phenolic compound is 30/70 to 70/30, more preferably such that the equivalent ratio is 40/60 to 60/40, and even more preferably such that the equivalent ratio is 45/55 to 55/45.

Moreover, the ratio of the content of the epoxy compound to the content of the phenolic compound in the composition is preferably such that an equivalent ratio (the number of oxiranyl groups/the number of active hydrogens) of the oxiranyl group of the epoxy compound to the active hydrogen (hydrogen atom in a hydroxyl group or the like) of the phenolic compound is 30/70 to 70/30, more preferably such that the equivalent ratio is 40/60 to 60/40, and even more preferably such that the equivalent ratio is 45/55 to 55/45.

Furthermore, in a case where the composition contains an other active hydrogen-containing compound, a ratio of the content of the epoxy compound to the total content of the phenolic compound and the other active hydrogen-containing compound is preferably such that an equivalent ratio (the number of oxiranyl groups/the number of active hydrogens) of the oxiranyl group of the epoxy compound to the active hydrogen (hydrogen atom in a hydroxyl group or the like) is 30/70 to 70/30, more preferably such that the equivalent ratio is 40/60 to 60/40, and even more preferably such that the equivalent ratio is 45/55 to 55/45.

In addition, the total content of the epoxy compound and the phenolic compound in the composition is preferably 5% to 90% by mass, more preferably 10% to 50% by mass, and even more preferably 15% to 40% by mass with respect to the total solid content of the composition.

Furthermore, the total solid content means components forming a thermally conductive material, and does not contain a solvent. The components forming a thermally conductive material mentioned here may be components of which the chemical structures are changed by being reacted (polymerized) in a case of forming a thermally conductive material. Moreover, in a case where a component is the component forming a thermally conductive material, the component is considered to be a solid content even in a case where a property of the component is liquid.

[Inorganic substance]

The composition contains an inorganic substance.

As the inorganic substance, any inorganic substances, which have been used in the related art in an inorganic filler of a thermally conductive material, may be used. As the inorganic substance, from the viewpoint that the thermally conductive properties and insulating properties of the thermally conductive material are superior, an inorganic nitride or an inorganic oxide is preferable.

A shape of the inorganic substance is not particularly limited, and may be a granule shape, a film shape, or a plate shape. Examples of a shape of the granular inorganic substance include a rice grain shape, a spherical shape, a cubical shape, a spindle shape, a scale shape, an aggregation shape, and an amorphous shape.

Examples of the inorganic oxide include zirconium oxide ($ZrO_2$), titanium oxide ($TiO_2$), silicon oxide ($SiO_2$), aluminum oxide ($Al_2O_3$), iron oxide ($Fe_2O_3$, FeO, or $Fe_3O_4$), copper oxide (CuO or $Cu_2O$), zinc oxide (ZnO), yttrium oxide ($Y_2O_3$), niobium oxide ($Nb_2O_5$), molybdenum oxide (MoOs), indium oxide ($In_2O_3$ or $In_2O$), tin oxide ($SnO_2$), tantalum oxide ($Ta_2O_5$), tungsten oxide ($WO_3$ or $W_2O_5$), lead oxide (PbO or $PbO_2$), bismuth oxide ($Bi_2O_3$), cerium oxide ($CeO_2$ or $Ce_2O_3$), antimony oxide ($Sb_2O_3$ or $Sb_2O_5$), germanium oxide ($GeO_2$ or GeO), lanthanum oxide ($La_2O_3$), and ruthenium oxide ($RuO_2$).

Only one kind of the inorganic oxides may be used, or two or more kinds thereof may be used.

The inorganic oxide is preferably titanium oxide, aluminum oxide, or zinc oxide, and more preferably aluminum oxide.

The inorganic oxide may be an oxide which is produced by oxidizing a metal prepared as a nonoxide in an environment or the like.

Examples of the inorganic nitride include boron nitride (BN), carbon nitride ($C_3N_4$), silicon nitride ($Si_3N_4$), gallium nitride (GaN), indium nitride (InN), aluminum nitride (AlN), chromium nitride ($Cr_2N$), copper nitride ($Cu_3N$), iron nitride ($Fe_4N$), iron nitride ($Fe_3N$), lanthanum nitride (LaN), lithium nitride ($Li_3N$), magnesium nitride ($Mg_3N_2$), molybdenum nitride ($Mo_2N$), niobium nitride (NbN), tantalum nitride (TaN), titanium nitride (TiN), tungsten nitride ($W_2N$), tungsten nitride ($WN_2$), yttrium nitride (YN), and zirconium nitride (ZrN).

Only one kind of the inorganic nitrides may be used, or two or more kinds thereof may be used.

The inorganic nitride preferably contains an aluminum atom, a boron atom, or a silicon atom, more preferably contains aluminum nitride, boron nitride, or silicon nitride, even more preferably contains aluminum nitride or boron nitride, and particularly preferably contains boron nitride.

A size of the inorganic substance is not particularly limited, but from the viewpoint that the dispersibility of the inorganic substance is superior, an average particle diameter of the inorganic substances is preferably 500 μm or less, more preferably 300 μm or less, and even more preferably 200 μm or less. The lower limit thereof is not particularly limited, but is preferably 10 nm or greater and more preferably 100 nm or greater from the viewpoint of handleability.

For the average particle diameter of the inorganic substances, in a case where a commercial product is used, the value listed in the catalog is adopted. In a case where a value is not listed in the catalog, as a method for measuring the average particle diameter, 100 inorganic substances are randomly selected using an electron microscope, particle diameters (major axes) of the respective inorganic substances are measured, and the arithmetic mean thereof is determined.

Only one kind of the inorganic substances may be used, or two or more kinds thereof may be used.

The inorganic substance preferably contains at least one of an inorganic nitride or an inorganic oxide, more preferably contains at least an inorganic nitride, and even more preferably contains both an inorganic nitride and an inorganic oxide.

The inorganic nitride preferably contains at least one of boron nitride or aluminum nitride and more preferably contains at least boron nitride.

A content of the inorganic nitride (preferably boron nitride and/or aluminum nitride) in the inorganic substance is preferably 10% to 100% by mass and more preferably 40% to 100% by mass with respect to the total mass of the inorganic substance.

The inorganic oxide is preferably aluminum oxide.

From the viewpoint that the thermally conductive properties of the thermally conductive material are superior, the composition more preferably contains at least inorganic particles having an average particle diameter of 20 μm or greater (preferably, 50 μm or greater).
A content of the inorganic substance in the composition is preferably 40% to 95% by mass, more preferably 50% to 95% by mass, and even more preferably 60% to 95% by mass with respect to the total solid content of the composition.

[Surface modifier]

The composition according to the embodiment of the present invention may further contain a surface modifier from the viewpoint that the thermally conductive properties of the thermally conductive material are superior.
The surface modifier is a component which modifies the surface of the aforementioned inorganic substance.
In the present specification, "surface modification" means a state where an organic substance is adsorbed onto at least a portion of a surface of an inorganic substance. A form of the adsorption is not particularly limited, and may be in a bonded state. That is, the surface modification also includes a state where an organic group obtained by desorbing a portion of an organic substance is bonded to a surface of an inorganic substance. The bond may be any one of a covalent bond, a coordinate bond, an ionic bond, a hydrogen bond, a van der Waals bond, or a metallic bond. In the surface-modified state, a monolayer may be formed on at least a portion of the surface. The monolayer is a single-layer film formed by chemical adsorption of organic molecules, and is known as a self-assembled monolayer (SAM). Moreover, in the present specification, the surface modification may be performed only on a portion of the surface of the inorganic substance, or may be performed on the entire surface thereof. In the present specification, a "surface-modified inorganic substance" means an inorganic substance of which the surface is modified with a surface modifier, that is, matter in which an organic substance is adsorbed onto a surface of an inorganic substance.
That is, in the composition according to the embodiment of the present invention, the inorganic substance may form a surface-modified inorganic substance (preferably, a surface-modified inorganic nitride and/or a surface-modified inorganic oxide) in cooperation with the surface modifier.
As the surface modifier, surface modifiers, which is known in the related art, such as carboxylic acid such as a long-chain alkyl fatty acid, organic phosphonic acid, organic phosphoric acid ester, and an organic silane molecule (silane coupling agent) can be used. In addition to the aforementioned surface modifiers, for example, the surface modifiers described in JP2009-502529A, JP2001-192500A, and JP4694929B may be used.
Furthermore, the composition (preferably, in a case where the inorganic substance includes an inorganic nitride (boron nitride and/or aluminum nitride)) preferably contains a compound having a fused-ring skeleton or a triazine skeleton as the surface modifier.

<Surface modifier A>

As the surface modifier, for example, a surface modifier A described below is preferable. Moreover, the surface modifier A is a surface modifier having a fused-ring skeleton.
The surface modifier A satisfies the following Conditions 1 and 2.

- Condition 1: the surface modifier A has a functional group (hereinafter, also referred to as a "specific functional group A") selected from the following group P of functional groups.

(Group P of functional groups)

A functional group selected from the group consisting of a boronic acid group ($-B(OH)_2$), an aldehyde group (-CHO), an isocyanate group (-N=C=O), an isothiocyanate group (-N=C=S), a cyanate group (-O-CN), an acyl azide group, a succinimide group, a sulfonyl chloride group ($-SO_2Cl$), a carboxylic acid chloride group (-COCl), an onium group, a carbonate group (-O-CO-O-), an aryl halide group, a carbodiimide group (-N=C=N-), an acid anhydride group (-CO-O-CO- or a monovalent acid anhydride group such as maleic acid anhydride, phthalic acid anhydride, pyromellitic acid anhydride, and trimellitic acid anhydride), a carboxylic acid group (-COOH), a phosphonic acid group ($-PO(OH)_2$), a phosphinic acid group (-HPO(OH)), a phosphoric acid group ($-OP(=O)(OH)_2$), a phosphoric acid ester group ($-OP(=O)(OR^B)_2$), a sulfonic acid group ($-SO_3H$), a halogenated alkyl group, a nitrile group (-CN), a nitro group ($-NO_2$), an ester group (-CO-O- or -O-CO-), a carbonyl group (-CO-), an imidoester group (-C(=NRc)-O- or -O-C(=NRc)-), an alkoxysilyl group, an acrylic group ($-OCOCH_2=CH_2$), a methacrylic group ($-OCOCH(CH_3)=CH_2$), an oxetanyl group, a vinyl group ($-CH=CH_2$), an alkynyl group (a group obtained by removing one hydrogen atom from alkyne, and examples thereof include an ethynyl group and a prop-2-yn-1-yl group), a maleimide group, a thiol group (-SH), a hydroxyl group (-OH), a halogen atom (a F atom, a Cl atom, a Br atom, and an I atom), and an amino group.

The acyl azide group means a group represented by the following structure. Moreover, * in the formula represents a bonding position. A counter anion ($Z^-$) of the acyl azide group is not particularly limited, and examples thereof include a halogen ion.

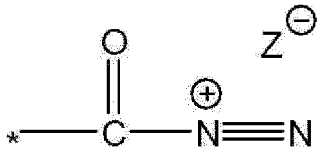

The succinimide group, the oxetanyl group, and the maleimide group represent groups formed by removing one hydrogen atom at any position from the compounds represented by the following formulae, respectively.

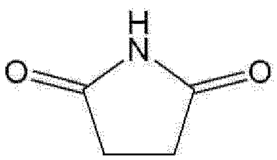 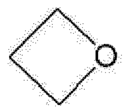 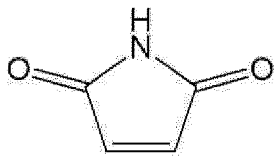

Furthermore, the onium group means a group having an onium salt structure. The onium salt is a compound which is generated in a case where a compound having an electron pair not being involved in chemical bonding forms a coordinate bond with another cationic compound through the electron pair. Generally, the onium salt contains a cation and an anion.

The onium salt structure is not particularly limited, but examples thereof include an ammonium salt structure, a pyridinium salt structure, an imidazolium salt structure, a pyrrolidinium salt structure, a piperidinium salt structure, a triethylenediamine salt structure, a phosphonium salt structure, a sulfonium salt structure, and a thiopyrylium salt structure. Moreover, a type of the anion used as a counter is not particularly limited, and known anions are used. A valence of the anion is not particularly limited, examples of the anion include monovalent to trivalent anions, and a monovalent or divalent anion is preferable.

As the onium group, among them, a group having an ammonium salt structure represented by General Formula (A1) is preferable.

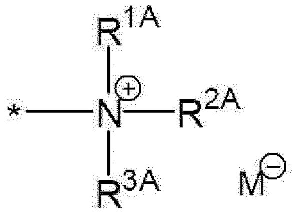

(A1)

In General Formula (A1), $R^{1A}$ to $R^{3A}$ each independently represent a hydrogen atom or an alkyl group (including all of a linear alkyl group, a branched alkyl group, and a cyclic alkyl group). The number of carbon atoms in the alkyl group is, for example, 1 to 10, preferably 1 to 6, and more preferably 1 to 3. $M^-$ represents an anion. * represents a bonding position. Moreover, the alkyl group may further have a substituent (for example, the substituent group Y).

The aryl halide group is not particularly limited as long as the aryl halide group is a group in which one or more halogen atoms are substituted on an aromatic ring group. The aromatic ring group may have any one of a monocyclic structure or a polycyclic structure, but is preferably a phenyl group. Moreover, examples of the halogen atom include a fluorine atom, a chlorine atom, a bromine atom, and an iodine atom, and a fluorine atom is preferable. Furthermore, the aryl halide group may further have a substituent (for example, the substituent group Y).

Specific examples of the aryl halide group include a fluorophenyl group, a perfluorophenyl group, a chlorophenyl group, a bromophenyl group, and an iodophenyl group.

The phosphoric acid ester group is not particularly limited as long as the phosphoric acid ester group is a group represented by $-OP(=O)(OR^B)_2$. Examples of $R^B$ include a hydrogen atom or a monovalent organic group. Here, any one or more of $R^B$'s represent a monovalent organic group. Examples of the monovalent organic group include an alkyl group (including all of a linear alkyl group, a branched alkyl group, and a cyclic alkyl group) and an aryl group. The number of carbon atoms in the alkyl group is, for example, 1 to 10, preferably 1 to 6, and more preferably 1 to 3. Moreover, the alkyl group may further have a substituent (for example, the substituent group Y). Furthermore, the aryl group is not

particularly limited, but examples thereof include a phenyl group and a pyrenyl group.

The halogenated alkyl group is not particularly limited, but examples thereof include a group in which one or more halogen atoms are substituted on an alkyl group having 1 to 10 carbon atoms. The number of carbon atoms in the alkyl group (including all of a linear alkyl group, a branched alkyl group, and a cyclic alkyl group) is preferably 1 to 6 and more preferably 1 to 3. Examples of the halogen atom include a fluorine atom, a chlorine atom, a bromine atom, and an iodine atom, and a fluorine atom, a chlorine atom, or a bromine atom is preferable. Moreover, the halogenated alkyl group may further have a substituent (for example, the substituent group Y).

The imidoester group is not particularly limited as long as the imidoester group is a group represented by $-C(=NR^C)-O-$ or $-O-C(=NR^C)-$. Examples of $R^C$ include a hydrogen atom and an alkyl group (including all of a linear alkyl group, a branched alkyl group, and a cyclic alkyl group). The number of carbon atoms in the alkyl group is, for example, 1 to 10, preferably 1 to 6, and more preferably 1 to 3. Moreover, the alkyl group may further have a substituent (for example, the substituent group Y).

Furthermore, the imidoester group may have an onium salt structure by a coordinate bond between an electron pair not being involved in chemical bonding of imine nitrogen and another cation (for example, a hydrogen ion).

The alkoxysilyl group is not particularly limited, but examples thereof include a group represented by General Formula (A2).

General Formula (A2): $*-Si(OR^D)_3$

In General Formula (A2), $R^D$'s each independently represent an alkyl group (including all of a linear alkyl group, a branched alkyl group, and a cyclic alkyl group). * represents a bonding position.

The alkyl group represented by $R^D$ is, for example, an alkyl group having 1 to 10 carbon atoms, preferably has 1 to 6 carbon atoms, and more preferably has 1 to 3 carbon atoms.

Specific examples thereof include a trimethoxysilyl group and a triethoxysilyl group.

Moreover, the alkyl group may further have a substituent (for example, the substituent group Y).

The amino group is not particularly limited, and may be any one of a primary amino group, a secondary amino group, or a tertiary amino group. Specific examples thereof include $-N(R^E)_2$ ($R^E$'s each independently represent a hydrogen atom or an alkyl group (including all of a linear alkyl group, a branched alkyl group, and a cyclic alkyl group)). The number of carbon atoms in the alkyl group is, for example, 1 to 10, preferably 1 to 6, and more preferably 1 to 3. Moreover, the alkyl group may further have a substituent (for example, the substituent group Y).

The number of the specific functional groups A in the surface modifier A is not particularly limited as long as the number thereof is 1 or larger. Moreover, the upper limit thereof is not particularly limited, but is preferably 15 or smaller. Among them, from the viewpoint that the dispersibility of the surface-modified inorganic nitride is superior, the number thereof is preferably 1 to 8, more preferably 1 to 3, and even more preferably 1 or 2.

• Condition 2: the surface modifier A has a fused-ring structure containing two or more rings selected from the group consisting of an aromatic hydrocarbon ring and an aromatic heterocyclic ring.

The aromatic hydrocarbon ring is not particularly limited, but examples thereof include a monocyclic aromatic hydrocarbon ring having a 5- or higher membered ring. The upper limit of the number of ring members is not particularly limited, but is 10 or smaller in many cases. As the aromatic hydrocarbon ring, a monocyclic aromatic hydrocarbon ring having a 5-membered or 6-membered ring is preferable.

Examples of the aromatic hydrocarbon ring include a cyclopentadienyl ring and a benzene ring.

The aromatic heterocyclic ring is not particularly limited, but examples thereof include a monocyclic aromatic hydrocarbon ring having a 5- or higher membered ring. The upper limit of the number of ring members is not particularly limited, but is 10 or smaller in many cases. As the aromatic heterocyclic ring, for example, a monocyclic aromatic heterocyclic ring having a 5-membered or 6-membered ring is preferable.

Examples of the aromatic heterocyclic ring include a thiophene ring, a thiazole ring, an imidazole ring, a pyridine ring, a pyridazine ring, a pyrimidine ring, a pyrazine ring, and a triazine ring.

The condensed structure is not particularly limited as long as the condensed structure is a fused-ring structure containing two or more rings selected from the group consisting of an aromatic hydrocarbon ring and an aromatic heterocyclic ring, but from the viewpoint that the effects of the present invention are superior, among them, a fused-ring structure containing two or more aromatic hydrocarbon rings is preferable, a fused-ring structure containing two or more benzene rings is more preferable, and a fused-ring structure containing three or more benzene rings is even more preferable. Moreover, the upper limit of the number of the aromatic hydrocarbon rings or the aromatic heterocyclic rings contained in the condensed structure is not particularly limited, but is, for example, 10 or smaller in many cases.

Specifically, the fused-ring structure having two or more aromatic hydrocarbon rings is preferably a condensed structure which consists of a fused ring selected from the group consisting of biphenylene, indacene, acenaphthylene, fluorene, phenalene, phenanthrene, anthracene, fluoranthene, acephenanthrylene, aceanthrylene, pyrene, chrysene, tetracene, pleiadene, picene, perylene, pentaphene, pentacene, tetraphenylene, hexaphene, and triphenylene, and from

the viewpoint that the effects of the present invention are superior, among them, a condensed structure consisting of a fused ring containing two or more benzene rings is more preferable, a condensed structure consisting of a fused ring containing three or more benzene rings is even more preferable, and a condensed structure consisting of pyrene or perylene is particularly preferable.

From the viewpoint that the dispersibility is further improved, the surface modifier A is preferably a compound represented by General Formula (V1) and more preferably a compound represented by General Formula (V2).

Hereinafter, the compound represented by General Formula (V1) and the compound represented by General Formula (V2) will be described, respectively.

(Compound represented by General Formula (V1))

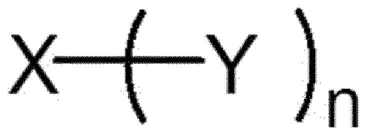

(V1)

In General Formula (V1), X represents an n-valent organic group which has a fused-ring structure containing two or more rings selected from the group consisting of an aromatic hydrocarbon ring and an aromatic heterocyclic ring.

X represents an n-valent organic group (n is an integer of 1 or greater). n is not particularly limited as long as n is an integer of 1 or greater. Moreover, the upper limit thereof is not particularly limited, but is preferably an integer of 15 or less. Among them, from the viewpoint that the dispersibility of the surface-modified inorganic nitride is superior, n is preferably 1 to 8, more preferably 1 to 3, and even more preferably 1 or 2.

Examples of the fused-ring structure containing two or more rings selected from the group consisting of the aromatic hydrocarbon ring and the aromatic heterocyclic ring in X include the structures described above, and the preferred aspect thereof is also the same as described above.

The n-valent organic group represented by X is not particularly limited as long as the organic group has a fused-ring structure containing two or more rings selected from the group consisting of an aromatic hydrocarbon ring and an aromatic heterocyclic ring, but from the viewpoint that the effects of the present invention are superior, a group formed by extracting n hydrogen atoms from a fused ring containing two or more rings selected from the group consisting of an aromatic hydrocarbon ring and an aromatic heterocyclic ring is preferable.

Moreover, the condensed structure may further have a substituent (for example, the substituent group Y) in addition to the specific functional group A.

Y represents a monovalent group represented by General Formula (B1), a monovalent group represented by General Formula (B2), or a monovalent group represented by General Formula (B4), or represents a divalent group represented by General Formula (B3), which is formed by bonding a plurality of Y's to each other, in a case where n represents an integer of 2 or greater.

In other words, in a case where n is 1, Y represents a monovalent group represented by General Formula (B1), a monovalent group represented by General Formula (B2), or a monovalent group represented by General Formula (B4).

In a case where n represents an integer of 2 or greater, Y represents a monovalent group represented by General Formula (B1), a monovalent group represented by General Formula (B2), or a monovalent group represented by General Formula (B4), or represents a divalent group represented by General Formula (B3), which is formed by bonding a plurality of Y's to each other. Moreover, in a case where n is 2 or greater, the plurality of Y's may be the same as or different from each other.

Furthermore, in a case where Y represents a divalent group represented by General Formula (B3), the compound represented by General Formula (V1) is represented by General Formula (V3).

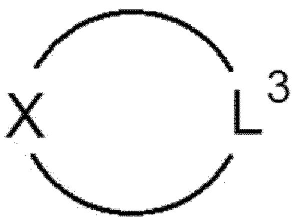

(V3)

In General Formula (V3), X has the same definition as X in General Formula (V1). Moreover, $L^3$ has the same

definition as $L^3$ in General Formula (B3).

General Formula (B1): $*^1$-$L^1$-$P^1$

In General Formula (B 1), $L^1$ represents a single bond or a divalent linking group.

The divalent linking group is not particularly limited, but examples thereof include -O-, -S-, -$NR^F$- ($R^F$ represents a hydrogen atom or an alkyl group), a divalent hydrocarbon group (for example, an alkylene group, an alkenylene group (for example, -CH=CH-), an alkynylene group (for example, -C=C-), and an arylene group), a divalent organic group (a carbonate group (-O-CO-O-), a carbodiimide group (-N=C=N-), an acid anhydride group (-CO-O-CO-), an ester group (-CO-O- or -O-CO-), a carbonyl group (-CO-), an imidoester group (-C(=$NR^C$)-O- or -O-C(=$NR^C$)-)) in the group P of functional groups, and a group obtained by combining these groups.

Examples of the combined group include -(divalent hydrocarbon group)-$X^{111}$-, -$X^{111}$-(divalent hydrocarbon group)-, -(divalent hydrocarbon group)-$X^{111}$-(divalent hydrocarbon group)-, -$X^{111}$-(divalent hydrocarbon group)-$X^{111}$-(divalent hydrocarbon group)-, and -(divalent hydrocarbon group)-$X^{111}$-(divalent hydrocarbon group)-$X^{111}$-. Moreover, -$X^{111}$- is -O-, -S-, -$NR^F$-, a divalent organic group in the group P of functional groups, or a group obtained by combining these groups. The total number of carbon atoms in the combined group is, for example, 1 to 20 and preferably 1 to 12.

$P^1$ represents a monovalent organic group (a boronic acid group (-$B(OH)_2$), an aldehyde group (-CHO), an isocyanate group (-N=C=O), an isothiocyanate group (-N=C=S), a cyanate group (-O-CN), an acyl azide group, a succinimide group, a sulfonyl chloride group (-$SO_2Cl$), a carboxylic acid chloride group (-COCl), an onium group, an aryl halide group, an acid anhydride group (examples thereof include a monovalent acid anhydride group such as maleic acid anhydride, phthalic acid anhydride, pyromellitic acid anhydride, and trimellitic acid anhydride), a carboxylic acid group (-COOH), a phosphonic acid group (-$PO(OH)_2$), a phosphinic acid group (-HPO(OH)), a phosphoric acid group (-$OP(=O)(OH)_2$), a phosphoric acid ester group (-$OP(=O)(OR^B)_2$), a sulfonic acid group (-$SO_3H$), a halogenated alkyl group, a nitrile group (-CN), a nitro group (-$NO_2$), an alkoxysilyl group, an acrylic group (-$OCOCH_2$=$CH_2$), a methacrylic group (-$OCOCH(CH_3)$=$CH_2$), an oxetanyl group, a vinyl group (-CH=$CH_2$), an alkynyl group (a group obtained by removing one hydrogen atom from alkyne, and examples thereof include an ethynyl group and a prop-2-yn-1-yl group), a maleimide group, a thiol group (-SH), a hydroxyl group (-OH), or a halogen atom (a F atom, a Cl atom, a Br atom, and an I atom)) in the group P of functional groups.

$*^1$ represents a position bonded to X.

General Formula (B2): $*^2$-$L^2$-$P^2$

In General Formula (B2), $L^2$ represents a divalent linking group including a divalent organic group (a carbonate group (-O-CO-O-), a carbodiimide group (-N=C=N-), an acid anhydride group (-CO-O-CO-), an ester group (-CO-O- or -O-CO-), a carbonyl group (-CO-), or an imidoester group (-C(=$NR^C$)-O- or -O-C(=$NR^C$)-)) in the group P of functional groups.

Examples of $L^2$ include a divalent organic group in the group P of functional groups, and a group obtained by combining a divalent organic group in the group P of functional groups with a linking group selected from the group consisting of -O-, -S-, -$NR^F$- ($R^F$ represents a hydrogen atom or an alkyl group), and a divalent hydrocarbon group (for example, an alkylene group, an alkenylene group (for example, -CH=CH-), an alkynylene group (for example, -C=C-), and an arylene group).

Examples of the combined group include -(divalent hydrocarbon group)-$X^{112}$-. Moreover, -$X^{112}$- is a divalent organic group in the group P of functional groups, or a group obtained by combining a divalent organic group in the group P of functional groups with a divalent group selected from -O-, -S-, and -$NR^F$-. The total number of carbon atoms in the combined group is, for example, 1 to 20 and preferably 1 to 12.

$P^2$ represents a monovalent organic group. The monovalent organic group represented by $P^2$ is not particularly limited, and examples thereof include an alkyl group. The number of carbon atoms in the alkyl group is, for example, 1 to 10, preferably 1 to 6, and more preferably 1 to 3.

$*^2$ represents a position bonded to X.

General Formula (B3): $*^{31}$-$L^3$-$*^{32}$

In General Formula (B3), $L^3$ represents a divalent linking group including a divalent organic group (a carbonate group (-O-CO-O-), a carbodiimide group (-N=C=N-), an acid anhydride group (-CO-O-CO-), an ester group (-CO-O- or -O-CO-), a carbonyl group (-CO-), or an imidoester group (-C(=$NR^C$)-O- or -O-C(=$NR^C$)-)) in the group P of functional groups.

Examples of $L^3$ include a divalent organic group in the group P of functional groups, and a group obtained by combining a divalent organic group in the group P of functional groups with a linking group selected from the group

consisting of -O-, -S-, -$NR^F$- ($R^F$ represents a hydrogen atom or an alkyl group), and a divalent hydrocarbon group (for example, an alkylene group, an alkenylene group (for example, -CH=CH-), an alkynylene group (for example, -C=C-), and an arylene group).

Examples of the combined group include -(divalent hydrocarbon group)-$X^{113}$-(divalent hydrocarbon group)-, -(divalent hydrocarbon group)-$X^{113}$-, -$X^{113}$-(divalent hydrocarbon group)-, and -$X^{113}$-(divalent hydrocarbon group)-$X^{113}$-. Moreover, -$X^{113}$- is a divalent organic group in the group P of functional groups, or a group obtained by combining a divalent organic group in the group P of functional groups with a divalent group selected from -O-, -S-, and -$NR^F$-. The total number of carbon atoms in the combined group is, for example, 1 to 20 and preferably 1 to 12.

$^{*31}$ and $^{*32}$ represent positions bonded to X. That is, $L^3$ forms a ring together with two different carbon atoms on a fused-ring structure represented by X.

General Formula (B4):

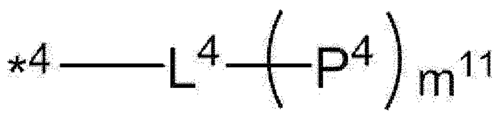

In General Formula (B4), $L^4$ represents an ($m^{11}$ + 1)-valent linking group.

$m^{11}$ represents an integer of 2 or greater. The upper limit value of $m^{11}$ is not particularly limited, but is, for example, 100 or less, preferably 30 or less, more preferably 20 or less, and even more preferably 15 or less. The lower limit value of $m^{11}$ is not particularly limited, but is preferably 4 or greater.

The linking group represented by $L^4$ is not particularly limited, but examples thereof include an ($m^{11}$ + 1)-valent aromatic hydrocarbon ring and a group represented by General Formula (M1).

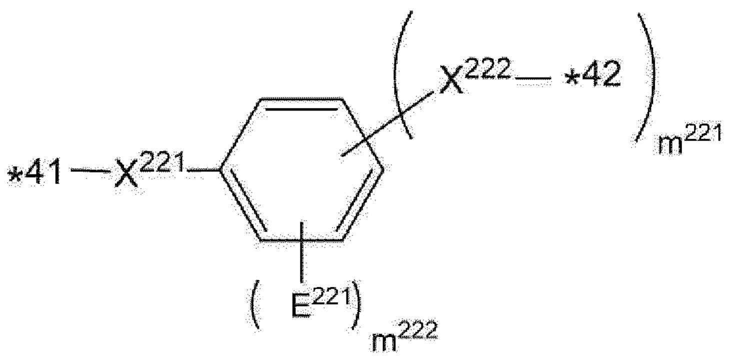

(M1)

In General Formula (M1), $X^{221}$ and $X^{222}$ each independently represent a single bond or a divalent linking group. The divalent linking groups represented by $X^{221}$ and $X^{222}$ have the same definitions as the divalent linking group represented by $L^1$ in General Formula (B1).

$E^{221}$ represents a substituent. Examples of the substituent represented by $E^{221}$ include the groups exemplified in the substituent group Y

$m^{221}$ represents an integer 2 to 5. Among them, $m^{221}$ is preferably 2 or 3.

$m^{222}$ represents an integer 0 to 3.

Here, $m^{221}$ + $m^{222}$ represents an integer 2 to 5.

$^{*41}$ represents a position bonded to X.

$^{*42}$ represents a position bonded to $P^4$.

Among them, the group represented by General Formula (M1) is preferably a group represented by General Formula (M2).

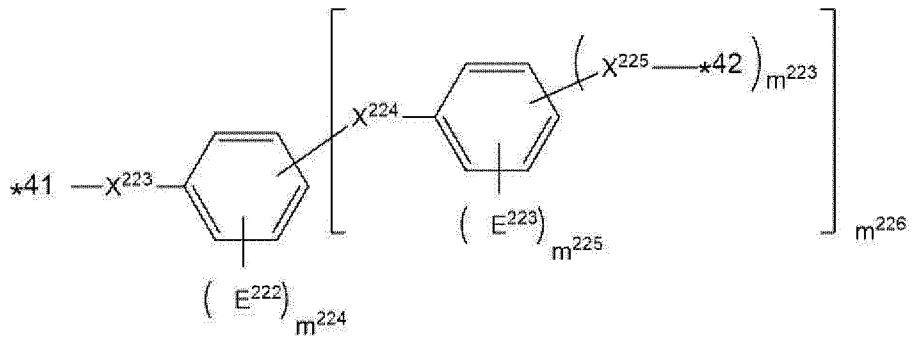

(M2)

In General Formula (M2), $X^{223}$, $X^{224}$, and $X^{225}$ each independently represent a single bond or a divalent linking group. The divalent linking groups represented by $X^{223}$, $X^{224}$, and $X^{225}$ have the same definitions as the divalent linking group represented by $L^1$ in General Formula (B1).

$E^{222}$ and $E^{223}$ each independently represent a substituent. Examples of the substituents represented by $E^{222}$ and $E^{223}$ include the groups exemplified in the substituent group Y $m^{223}$ represents an integer 1 to 5. Among them, $m^{223}$ is preferably 2 or 3. $m^{224}$ represents an integer 0 to 3.

$m^{225}$ represents an integer 0 to 4.

$m^{226}$ represents an integer 2 to 5. Among them, $m^{226}$ is preferably 2 or 3.

Here, $m^{224} + m^{226}$ represents an integer 2 to 5. Moreover, $m^{223} + m^{225}$ represents an integer 1 to 5.

$*^{41}$ represents a position bonded to X.

$*^{42}$ represents a position bonded to $P^4$.

$P^4$ has the same definition as $P^1$ in General Formula (B1).

$*^4$ represents a position bonded to X.

(Compound represented by General Formula (V2))

$$\left(Y^{12}\right)_{n^{12}} X^{11} \left(Y^{11}\right)_{n^{11}} \quad \textbf{(V2)}$$

In General Formula (V2), $X^{11}$ represents an $(n^{11} + n^{12})$-valent organic group which has a fused-ring structure containing two or more rings selected from the group consisting of an aromatic hydrocarbon ring and an aromatic heterocyclic ring.

$X^{11}$ represents an $(n^{11} + n^{12})$-valent organic group ($n^{11}$ and $n^{12}$ are each independently an integer of 1 or greater). $n^{11}$ and $n^{12}$ are not particularly limited as long as $n^{11}$ and $n^{12}$ are each independently an integer of 1 or greater. Moreover, the upper limit of $n^{11} + n^{12}$ is not particularly limited, but is preferably an integer of 15 or less. Among them, from the viewpoint that the dispersibility of the surface-modified inorganic substance is superior, $n^{11} + n^{12}$ is preferably 2 to 8, more preferably 2 or 3, and even more preferably 2.

Examples of the fused-ring structure containing two or more rings selected from the group consisting of the aromatic hydrocarbon ring and the aromatic heterocyclic ring in $X^{11}$ include the structures described above, and the preferred aspect thereof is also the same as described above.

The $(n^{11} + n^{12})$-valent organic group represented by $X^{11}$ is not particularly limited as long as the organic group has a fused-ring structure containing two or more rings selected from the group consisting of an aromatic hydrocarbon ring and an aromatic heterocyclic ring, but from the viewpoint that the effects of the present invention are superior, a group formed by extracting $(n^{11} + n^{12})$ hydrogen atoms from a fused ring containing two or more rings selected from the group consisting of an aromatic hydrocarbon ring and an aromatic heterocyclic ring is preferable.

Moreover, the condensed structure may further have a substituent (for example, the substituent group Y) in addition to $Y^{11}$ and $Y^{12}$.

$Y^{11}$ contains a functional group selected from the following group Q of functional groups. Functional groups exemplified in the following group Q of functional groups correspond particularly to groups which tend to have excellent adsorptivity to an inorganic substance (in particular, an inorganic nitride), among the functional groups exemplified in the group P of functional groups.

Moreover, $Y^{12}$ contains a functional group selected from the following group R of functional groups. Functional groups exemplified in the following group R of functional groups correspond to groups which have a function of easily promoting the curing of the composition, among the functional groups exemplified in the group P of functional groups.

(Group Q of functional groups)

A functional group selected from the group consisting of a boronic acid group ($-B(OH)_2$), an aldehyde group (-CHO), an isocyanate group (-N=C=O), an isothiocyanate group (-N=C=S), a cyanate group (-O-CN), an acyl azide group, a succinimide group, a sulfonyl chloride group ($-SO_2Cl$), a carboxylic acid chloride group (-COCl), an onium group, a carbonate group (-O-CO-O-), an aryl halide group, a carbodiimide group (-N=C=N-), an acid anhydride group (-CO-O-CO- or a monovalent acid anhydride group such as maleic acid anhydride, phthalic acid anhydride, pyromellitic acid anhydride, or trimellitic acid anhydride), a phosphonic acid group ($-PO(OH)_2$), a phosphinic acid group (-HPO(OH)), a phosphoric acid group ($-OP(=O)(OH)_2$), a phosphoric acid ester group ($-OP(=O)(OR^B)_2$), a sulfonic acid group ($-SO_3H$), a halogenated alkyl group, a nitrile group (-CN), a nitro group ($-NO_2$), an ester group (-CO-O- or -O-CO-), a carbonyl group (-CO-), an imidoester group (-C(=NRc)-O- or -O-C(=NRc)-), and a halogen atom (a fluorine atom, a chlorine atom, a bromine atom, and an iodine atom).

(Group R of functional groups)

A functional group selected from the group consisting of a carboxylic acid group (-COOH), an alkoxysilyl group, an acrylic group ($-OCOCH_2=CH_2$), a methacrylic group ($-OCOCH(CH_3)=CH_2$), an oxetanyl group, a vinyl group ($-CH=CH_2$), an alkynyl group (a group obtained by removing one hydrogen atom from alkyne, and examples thereof include an ethynyl group and a prop-2-yn-1-yl group), a maleimide group, a thiol group (-SH), a hydroxyl group (-OH), and an amino group.

In General Formula (V2), specifically, $Y^{11}$ represents a monovalent group represented by General Formula (C1) or a monovalent group represented by General Formula (C2), or represents a divalent group represented by General Formula (C3), which is formed by bonding a plurality of $Y^{11}$'s to each other, in a case where $n^{11}$ represents an integer of 2 or greater.

In other words, in a case where $n^{11}$ is 1, $Y^{11}$ represents a monovalent group represented by General Formula (C1) or a monovalent group represented by General Formula (C2). In a case where $n^{11}$ represents an integer of 2 or greater, $Y^{11}$ represents a monovalent group represented by General Formula (C1) or a monovalent group represented by General Formula (C2), or represents a divalent group represented by General Formula (C3), which is formed by bonding a plurality of $Y^{11}$'s to each other. Moreover, in a case where $n^{11}$ is 2 or greater, the plurality of $Y^{11}$'s may be the same as or different from each other.

Furthermore, in a case where $Y^{11}$ represents a divalent group represented by General Formula (C3), the compound represented by General Formula (V2) is represented by General Formula (V4).

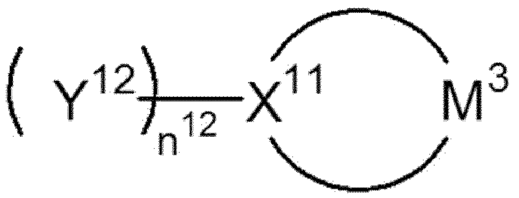
**(V4)**

In General Formula (V4), $X^{11}$, $Y^{12}$, and $n^{12}$ have the same definitions as $X^{11}$, $Y^{12}$, and $n^{12}$ in General Formula (V2), respectively. Moreover, $M^3$ has the same definition as $M^3$ in General Formula (C3).

General Formula (C1): $*^1-M^1-Q^1$

In General Formula (C1), $M^1$ represents a single bond or a divalent linking group. The divalent linking group represented by $M^1$ has the same definition as $L^1$, and the preferred aspects thereof are also the same.

$Q^1$ represents a monovalent organic group (a boronic acid group ($-B(OH)_2$), an aldehyde group (-CHO), an isocyanate group (-N=C=O), an isothiocyanate group (-N=C=S), a cyanate group (-O-CN), an acyl azide group, a succinimide group, a sulfonyl chloride group ($-SO_2Cl$), a carboxylic acid chloride group (-COCl), an onium group, an aryl halide group, an acid anhydride group (a monovalent acid anhydride group such as maleic acid anhydride, phthalic acid anhydride, pyromellitic acid anhydride, or trimellitic acid anhydride), a phosphonic acid group ($-PO(OH)_2$), a phosphinic acid group (-HPO(OH)), a phosphoric acid group ($-OP(=O)(OH)_2$), a phosphoric acid ester group ($-OP(=O)(OR^B)_2$), a

sulfonic acid group ($-SO_3H$), a halogenated alkyl group, a nitrile group (-CN), a nitro group ($-NO_2$), or a halogen atom (a fluorine atom, a chlorine atom, a bromine atom, and an iodine atom)) in the group Q of functional groups. $*^1$ represents a position bonded to $X^{11}$.

General Formula (C2): $*^2-M^2-Q^2$

In General Formula (B2), $M^2$ has the same definition as $L^2$, and the preferred aspects thereof are also the same. $Q^2$ represents a monovalent organic group. The monovalent linking group represented by $Q^2$ has the same definition as $P^2$, and the preferred aspects thereof are also the same. $*^2$ represents a position bonded to $X^{11}$.

General Formula (C3): $*^{31}-M^3-*^{32}$

In General Formula (B3), $M^3$ has the same definition as $L^3$, and the preferred aspects thereof are also the same. $*^{31}$ and $*^{32}$ represent positions bonded to $X^{11}$. That is, $M^3$ forms a ring together with two different carbon atoms on a fused-ring structure represented by $X^{11}$.
$Y^{12}$ represents a monovalent group represented by General Formula (D1) or a monovalent group represented by General Formula (D2).

General Formula (D1): $*^1-W^1-R^1$

In General Formula (D1), $W^1$ represents a single bond or a divalent linking group. $R^1$ represents a carboxylic acid group, an alkoxysilyl group, an acrylic group, a methacrylic group, an oxetanyl group, a vinyl group, an alkynyl group, a maleimide group, a thiol group, a hydroxyl group, or an amino group. $*^1$ represents a position bonded to $X^{11}$. Moreover, $R^1$ represents a functional group exemplified in the group R of functional groups.
The divalent linking group represented by $W^1$ has the same definition as $L^1$, and the preferred aspects thereof are also the same.
$*^1$ represents a position bonded to $X^{11}$.

General Formula (D2):

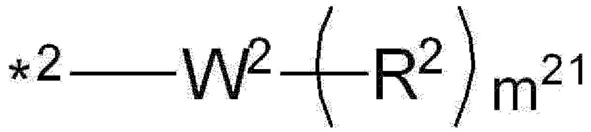

In General Formula (D2), $W^2$ represents an $(m^{21} + 1)$-valent linking group.
$m^{21}$ represents an integer of 2 or greater. The upper limit value of $m^{21}$ is not particularly limited, but is, for example, 100 or less, preferably 30 or less, more preferably 20 or less, and even more preferably 15 or less. The lower limit value of $m^{21}$ is not particularly limited, but is preferably 4 or greater.
$R^2$ represents a carboxylic acid group, an alkoxysilyl group, an acrylic group, a methacrylic group, an oxetanyl group, a vinyl group, an alkynyl group, a maleimide group, a thiol group, a hydroxyl group, or an amino group. Moreover, $R^2$ represents a functional group exemplified in the group R of functional groups.
The $(m^{21} + 1)$-valent linking group represented by $W^2$ has the same definition as $L^4$, and the preferred aspects thereof are also the same.
$*^2$ represents a position bonded to $X^{11}$.
A molecular weight of the surface modifier A is, for example, 150 or greater, is preferably 200 or greater from the viewpoint that the dispersibility of the surface-modified inorganic nitride is superior, and is preferably 2,000 or less and more preferably 1,000 or less from the viewpoint of solubility.

<Surface modifier B>

In addition, it is also preferable that the surface modifier is a surface modifier B described below.
The surface modifier B is a compound represented by General Formula (W1).

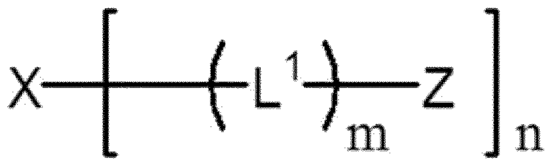 (W1)

In General Formula (W1), X represents a benzene ring group or a heterocyclic group, each of which may have a substituent. That is, X represents a benzene ring group which may have a substituent or a heterocyclic group which may have a substituent.

The heterocyclic group is not particularly limited, but examples thereof include an aliphatic heterocyclic group and an aromatic heterocyclic group. Moreover, examples of the aliphatic heterocyclic group include a 5-membered ring group, a 6-membered ring group, a 7-membered ring group, and a fused ring group thereof. Furthermore, examples of the aromatic heterocyclic group include a 5-membered ring group, a 6-membered ring group, a 7-membered ring group, and a fused ring group thereof.

In addition, the fused ring group may contain a ring group other than a heterocyclic group, such as a benzene ring group.

Specific examples of the aliphatic heterocyclic group are not particularly limited, but include an oxolane ring group, an oxane ring group, a piperidine ring group, and a piperazine ring group.

Examples of a heteroatom contained in the aromatic heterocyclic group include a nitrogen atom, an oxygen atom, and a sulfur atom. The number of carbon atoms in the aromatic heterocyclic group is not particularly limited, but is preferably 3 to 20.

Specific examples of the aromatic heterocyclic group are not particularly limited, but include a furan ring group, a thiophene ring group, a pyrrole ring group, an oxazole ring group, an isoxazole ring group, an oxadiazole ring group, a thiazole ring group, an isothiazole ring group, a thiadiazole ring group, an imidazole ring group, a pyrazole ring group, a triazole ring group, a furazan ring group, a tetrazole ring group, a pyridine ring group, a pyridazine ring group, a pyrimidine ring group, a pyrazine ring group, a triazine ring group, a tetrazine ring group, a benzofuran ring group, an isobenzofuran ring group, a benzothiophene ring group, an indole ring group, an indoline ring group, an isoindole ring group, a benzoxazole ring group, a benzothiazole ring group, an indazole ring group, a benzimidazole ring group, a quinoline ring group, an isoquinoline ring group, a cinnoline ring group, a phthalazine ring group, a quinazoline ring group, a quinoxaline ring group, a dibenzofuran ring group, a dibenzothiophene ring group, a carbazole ring group, an acridine ring group, a phenanthridine ring group, a phenanthroline ring group, a phenazine ring group, a naphthyridine ring group, a purine ring group, and a pteridine ring group.

The heterocyclic group represented by X is preferably an aromatic heterocyclic group.

Among them, X is preferably a benzene ring group or a triazine ring group and more preferably a triazine ring group.

In a case where X has a substituent, the substituent preferably includes a specific functional group B which will be described later.

In General Formula (W1), n represents an integer of 3 to 6, and n groups represented by $[-(L^1)_m-Z]$ are bonded to X.

In General Formula (W1), the group represented by $[-(L^1)_m-Z]$ is a group which is directly bonded to X.

$L^1$'s, which can be present in a plurality of numbers, each independently represent an arylene group which may have a substituent, an ester group (-CO-O- or -O-CO-), an ether group (-O-), a thioester group (-SO-O- or -O-SO-), a thioether group (-S-), a carbonyl group (-CO-), $-NR^N-$, an azo group (-N=N-), or an unsaturated hydrocarbon group which may have a substituent.

Moreover, $R^N$ represents a hydrogen atom, or an organic group which has 1 to 10 carbon atoms and may have a substituent.

The number of carbon atoms in the arylene group represented by $L^1$ is preferably 6 to 20, more preferably 6 to 10, and even more preferably 6. Among them, the arylene group is preferably a phenylene group.

In a case where the arylene group is a phenylene group, a position bonded to an adjacent group (the groups are two groups among X, $L^1$, and Z, and a case where the two groups are both $L^1$ is included) is not particularly limited, and the groups may be bonded at any one position of an ortho position, a meta position, or a para position, and are preferably bonded at a para position. The arylene group may or may not have a substituent, and preferably does not have a substituent. In a case where the arylene group has a substituent, the substituent preferably includes the specific functional group B which will be described later.

In a case where $L^1$ is an ester group, a carbon atom in the ester group is preferably present on a side of X. In a case where $L^1$ is a thioester group, a sulfur atom in the thioester group is preferably present on the side of X.

The unsaturated hydrocarbon group represented by $L^1$ may be linear or branched, and may have a cyclic

structure. The number of carbon atoms in the unsaturated hydrocarbon group is preferably 2 to 10, more preferably 2 to 5, even more preferably 2 or 3, and particularly preferably 2. Here, the aforementioned number of carbon atoms does not include the number of carbon atoms contained in the substituent that the unsaturated hydrocarbon group can have. An unsaturated bond of the unsaturated hydrocarbon group may be a double bond (-C=C-) or a triple bond (-C≡C-). The unsaturated hydrocarbon group may or may not have a substituent, and preferably does not have a substituent. In a case where the unsaturated hydrocarbon group has a substituent, the substituent preferably includes the specific functional group B.

In a case where $R^N$ in $-NR^N-$ represented by $L^1$ is an organic group which has 1 to 10 carbon atoms and may have a substituent, $R^N$ is preferably an alkyl group which has 1 to 10 carbon atoms and may have a substituent, preferably an alkyl group which has 1 to 5 carbon atoms and may have a substituent, and preferably an alkyl group which has 1 to 3 carbon atoms and may have a substituent. The alkyl group may be linear or branched, and may have a cyclic structure. $R^N$ is preferably a hydrogen atom.

m represents an integer of 0 or greater. m is preferably an integer of 0 to 10, more preferably an integer of 0 to 5, even more preferably an integer of 0 to 2, and particularly preferably an integer of 1 or 2.

In a case where m is 0, Z is directly bonded to X.

In a case where m is 1, $L^1$ is preferably an arylene group which may have a substituent, an ester group, an ether group, a thioester group, a thioether group, a carbonyl group, $-NR^N-$, an azo group, or an unsaturated hydrocarbon group which may have a substituent, more preferably an arylene group which may have a substituent, an ester group, an ether group, a carbonyl group, or an unsaturated hydrocarbon group which may have a substituent, and even more preferably an ester group, an ether group, a carbonyl group, or an unsaturated hydrocarbon group which may have a substituent.

In a case where m is 2, $[-(L^1)_m-Z]$ is $[-L^1-L^1-Z]$, $L^1$ bonded to X is preferably an arylene group which may have a substituent. In this case, $L^1$ bonded to Z is preferably an ester group, an ether group, a thioester group, a thioether group, a carbonyl group, $-NR^N-$, an azo group, or an unsaturated hydrocarbon group which may have a substituent, and more preferably an ester group or an unsaturated hydrocarbon group which may have a substituent.

In a case where m is greater than 2, a plurality of $L^1$'s in $[-(L^1)_m-Z]$ may be the same as or different from each other, but it is preferable that $L^1$'s bonded to each other are different from each other.

In General Formula (W1), $-(L^1)_m-$ is preferably a group represented by General Formula (Lq). That is, the group represented by $[-(L^1)_m-Z]$ is preferably a group represented by $[-L^a-Z]$,

General Formula (Lq) $-L^a-$

$L^a$ represents a single bond, -O-, -CO-, -COO-, a phenylene group, -C=C-, -C≡C-, -phenylene group-COO-, or -phenylene group-C≡C-.

Z represents an aryl group or a heterocyclic group, each of which may have a substituent. That is, Z represents an aryl group which may have a substituent or a heterocyclic group which may have a substituent.

The number of carbon atoms in the aryl group represented by Z is preferably 6 to 20, more preferably 6 to 14, and even more preferably 6. Examples of the aryl group include a phenyl group, a naphthyl group, and an anthracenyl group.

Examples of the heterocyclic group represented by Z include the heterocyclic groups which can be used as X. Moreover, the heterocyclic group represented by Z preferably exhibits aromaticity.

Among them, Z is preferably an aryl group, more preferably a phenyl group or an anthracenyl group, and even more preferably a phenyl group.

It is also preferable that Z has a substituent and more preferable that the substituent includes the specific functional group B which will be described later. The number of substituents contained in one Z is preferably 0 to 5, more preferably 0 to 2, and even more preferably 1 or 2.

It is preferable that at least one among the plurality of Z's has a substituent including the specific functional group B.

The total number of the specific functional groups B included in the substituents of the plurality of Z's in the surface modifier B is preferably 1 or larger, more preferably 2 or larger, and even more preferably 3 or larger.

The upper limit of the total number of the specific functional groups B included in the substituents of the plurality of Z's in the surface modifier B is not particularly limited, but is preferably 15 or smaller, more preferably 10 or smaller, and even more preferably 8 or smaller.

As described above, in General Formula (W1), n represents an integer of 3 to 6. The respective groups represented by a plurality of $[-(L^1)_m-Z]$'s may be the same as or different from each other.

That is, in General Formula (W1), a plurality of m's may be the same as or different from each other, in a case where there are a plurality of $L^1$'s, the plurality of $L^1$'s may be the same as or different from each other, and a plurality of Z's may be the same as or different from each other.

It is also preferable that the plurality of m's are all the same. Moreover, it is preferable that the plurality of m's all represent integers of 1 or greater, and also preferable that the plurality of m's all represent integers of 2 or greater.
It is also preferable that the plurality of [-$(L^1)_m$-Z]'s have the same configuration except for the substituents of Z, and also preferable that the plurality of [-$(L^1)_m$-Z]'s have the same configuration including the substituents of Z.
n is preferably 3 or 6.
In a case where a group which can be used as $(L^1)_m$, or Z is present in [-$(L^1)_m$-Z], the group is assumed to be $(L^1)_m$,. For example, in a case where [-$(L^1)_m$-Z] is [-benzene ring group-benzene ring group-halogen atom], the benzene ring group on the left side is $(L^1)_m$ and is not Z. More specifically, in the aforementioned case, a form in which "m is 1, $L^1$ is a phenylene group (arylene group), and Z is a phenyl group (aryl group) having a halogen atom as a substituent" is satisfied, and a form in which "m is 0 and Z is a phenyl group (aryl group) having an aryl halide group as a substituent" is not satisfied.
In addition, the surface modifier B represented by General Formula (W1) preferably has four or more benzene ring groups. For example, it is also preferable that the surface modifier B has a triphenylbenzene structure.
Moreover, it is also preferable that the surface modifier B represented by General Formula (W1) has a total of four or more benzene ring groups and triazine ring groups. In this case, for example, it is also preferable that X is a triazine ring group.

(Specific functional group B)

The surface modifier B preferably has one or more specific functional groups B and more preferably has two or more specific functional groups B.
The specific functional group B is a group selected from the group consisting of a boronic acid group, an aldehyde group, a hydroxyl group, a carboxylic acid group, an isocyanate group, an isothiocyanate group, a cyanate group, an acyl azide group, a succinimide group, a sulfonyl chloride group, a carboxylic acid chloride group, an onium group, a carbonate group, an aryl halide group, a carbodiimide group, an acid anhydride group (monovalent acid anhydride group), a phosphonic acid group, a phosphinic acid group, a phosphoric acid group, a phosphoric acid ester group, a sulfonic acid group, a halogen atom, a halogenated alkyl group, a nitrile group, a nitro group, an imidoester group, an alkoxycarbonyl group, an alkoxysilyl group, an acryloyl group, a methacryloyl group, an oxetanyl group, a vinyl group, an alkynyl group, a maleimide group, a thiol group, an amino group, and a silyl group.
Among them, as the specific functional group B, a hydroxyl group, an amino group, an acid anhydride group, a thiol group, a carboxylic acid group, an acryloyl group, a methacryloyl group, or a vinyl group is preferable.
Furthermore, the hydroxyl group means a group in which an -OH group is directly bonded to a carbon atom. For example, the -OH group present in a form of being included in a carboxylic acid group (-COOH) is not a hydroxyl group.
The alkoxycarbonyl group is not particularly limited as long as the alkoxycarbonyl group is a group represented by -CO-O-$R^f$. $R^f$ represents an alkyl group (including all of a linear alkyl group, a branched alkyl group, and a cyclic alkyl group).
The number of carbon atoms in the alkyl group represented by $R^f$ is, for example, 1 to 10, preferably 1 to 6, and more preferably 1 to 3.
Moreover, among the specific functional groups B, the functional groups which overlap with the specific functional group A are as described for the specific functional group A.
In a case where the surface modifier B has a plurality of specific functional groups B, the plurality of specific functional groups B may be the same as or different from each other.
A position where the specific functional group B is present is not particularly limited, and for example, the specific functional group B may be included in the substituent of X in General Formula (W1), may be included in the substituent of $L^1$ in a case where $L^1$ is an arylene group or an unsaturated hydrocarbon group, or may be included in the substituent of Z.
Moreover, the specific functional group B may be bonded to a group other than the specific functional group B to form one substituent.
Furthermore, the plurality of specific functional group B may be included in one substituent.
The substituent including the specific functional group B is preferably a group represented by General Formula (Rx), a group represented by General Formula (Ry), or a group represented by General Formula (Rz).

General Formula (Rx) $-Lx^1-Qx$

General Formula (Ry) $-Ly^1-Qy$

General Formula (Rz) $-Lz^1-Sz-(Lz^2-Qz)_s$

In General Formula (Rx), $Lx^1$ represents a single bond or a divalent linking group.

The divalent linking group is not particularly limited, but represents, for example, any one kind selected from the group consisting of -O-, -CO-, -NH-, and a divalent hydrocarbon group, or a divalent linking group obtained by combining two or more kinds thereof.

The divalent hydrocarbon group may further have a substituent (for example, the group exemplified in the substituent group Y).

Examples of the divalent hydrocarbon group include an alkylene group, an alkenylene group (for example, -CH=CH-), an alkynylene group (for example, -C=C-), and an arylene group (for example, a phenylene group). The alkylene group may be any one of linear, branched, or cyclic, but is preferably linear. Moreover, the number of carbon atoms thereof is preferably 1 to 10, more preferably 1 to 6, and even more preferably 1 to 4.

$Lx^1$ is preferably a single bond, -AL-, -O-, -O-CO-, -O-AL-, -AL-CO-, -O-AL-O-, -O-CO-AL-, -CO-O-AL-, -AL-NH-CO-, -O-AL-O-AL-, -CO-O-AL-O-, or -O-AL-O-Ar-.

AL represents an alkylene group having 1 to 10 carbon atoms (the number of carbon atoms is preferably 1 to 6 and more preferably 1 to 4).

Ar represents an arylene group which has 6 to 20 carbon atoms (a phenylene group is preferable). Moreover, in a case where $Lx^1$ is "-O-AL-O-Ar-", Ar in "-O-AL-O-Ar-" is bonded to Qx.

Qx represents a monovalent specific functional group B. Specific examples thereof include an aldehyde group, a hydroxyl group, a carboxylic acid group, an isocyanate group, an isothiocyanate group, a cyanate group, an acyl azide group, a succinimide group, a sulfonyl chloride group, a carboxylic acid chloride group, an onium group, an aryl halide group, a phosphonic acid group, a phosphinic acid group, a phosphoric acid group, a sulfonic acid group, a phosphoric acid ester group, a halogen atom, an acid anhydride group, a halogenated alkyl group, a nitrile group, a nitro group, an alkoxycarbonyl group, an alkoxysilyl group, an acryloyl group, a methacryloyl group, an oxetanyl group, a vinyl group, an alkynyl group, a maleimide group, a thiol group, an amino group, an oxiranyl group, and a silyl group.

In General Formula (Ry), $Ly^1$ represents a divalent linking group including a carbodiimide group, a carbonate group, or an imidoester group. The divalent linking group represented by $Ly^1$ may include a carbodiimide group, a carbonate group, or an imidoester group, and may be combined with another linking group. Examples of the other linking group include an alkylene group. For example, $Ly^1$ may be an -alkylene group-$Ly^3$-alkylene group-. $Ly^3$ represents a carbodiimide group, a carbonate group, or an imidoester group.

Qy represents a monovalent organic group. The monovalent organic group represented by Qy is not particularly limited, and examples thereof include an alkyl group. The number of carbon atoms in the alkyl group is, for example, 1 to 10, preferably 1 to 6, and more preferably 1 to 3.

In General Formula (Rz), s represents an integer of 2 or 3. s is preferably 2.

$Lz^1$ represents a group which can be represented by $Lx^1$, and the preferred conditions thereof are also the same.

A plurality of $Lz^2$'s each independently represent a single bond or a divalent linking group.

The divalent linking group is not particularly limited, but represents, for example, any one kind selected from the group consisting of -O-, -CO-, -NH-, and a divalent hydrocarbon group, or a divalent linking group obtained by combining two or more kinds thereof.

The divalent hydrocarbon group may further have a substituent (for example, the group exemplified in the substituent group Y).

Examples of the divalent hydrocarbon group include an alkylene group, an alkenylene group (for example, -CH=CH-), an alkynylene group (for example, -C=C-), and an arylene group (for example, a phenylene group). The alkylene group may be any one of linear, branched, or cyclic, but is preferably linear. Moreover, the number of carbon atoms thereof is preferably 1 to 10, more preferably 1 to 6, and even more preferably 1 to 4.

$Lz^2$ is preferably a single bond, -AL-, -O-, -O-CO-, -O-AL-, -AL-CO-, -O-AL-O-, -O-CO-AL-, -CO-O-AL-, -AL-NH-CO-, -O-AL-O-AL-, -CO-O-AL-O-, -O-AL-O-Ar-, or -O-Ar-.

AL represents an alkylene group having 1 to 10 carbon atoms (the number of carbon atoms is preferably 1 to 6 and more preferably 1 to 4).

Ar represents an arylene group which has 6 to 20 carbon atoms (a phenylene group is preferable).

Sz represents an (s + 1)-valent linking group.

As Sz, an (s + 1)-valent aromatic ring group is preferable. The aromatic ring group may be an aromatic hydrocarbon ring group or aromatic heterocyclic group, and is preferably a benzene ring group or a triazine ring group.

Qz represents a monovalent specific functional group B.

A plurality of Qz's each independently represent a group which can be represented by Qx, and the preferred conditions thereof are also the same.

(Compound represented by General Formula (W2))

The surface modifier B is preferably a compound represented by General Formula (W2).

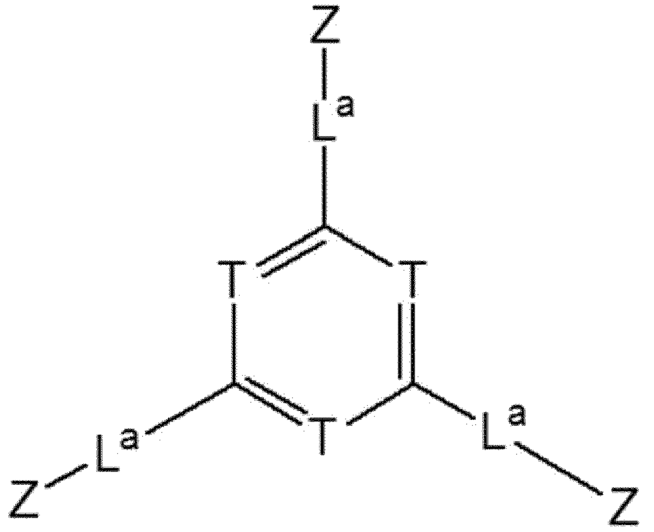

(W2)

In General Formula (W2), the definitions of $L^a$ and Z are as described above. Moreover, a plurality of $L^a$'s may be the same as or different from each other. A plurality of Z's may be the same as or different from each other.
T's each independently represent $-CR^a=$ or $-N=$. $R^a$ represents a hydrogen atom, a monovalent specific functional group B, or $-L^a-Z$. The definitions of $L^a$ and Z are as described above.
For example, in a case where all of T's are $-CR^a=$ and all of $R^a$'s are $-L^a-Z$, the compound represented by General Formula (W2) has six groups represented by $-L^a-Z$.
Moreover, in a case where all of T's are $-N=$, the compound represented by General Formula (W2) has a triazine ring.

(Compound represented by General Formula (W3))

As the compound represented by General Formula (W2), a compound represented by General Formula (W3) is preferable.

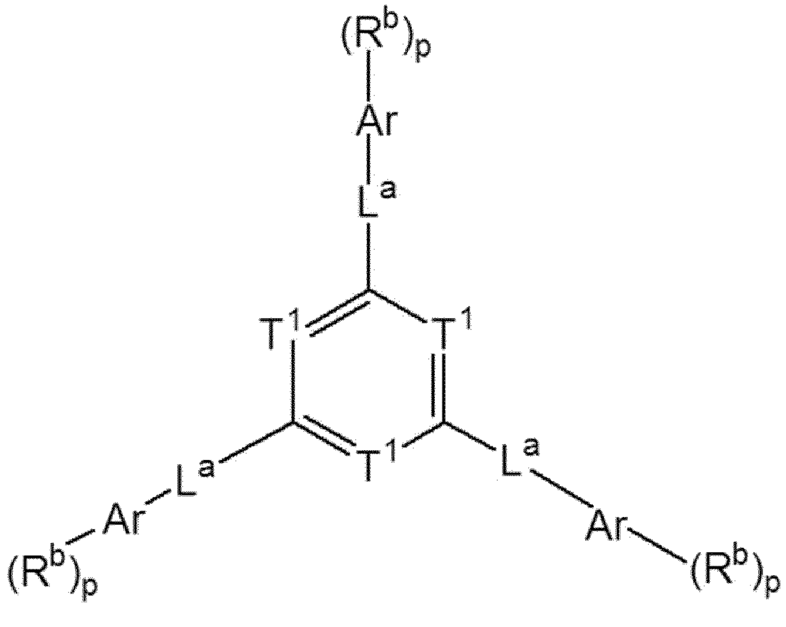

(W3)

In General Formula (W3), the definition of $L^a$ is as described above. Moreover, a plurality of $L^a$'s may be the same as or different from each other.
Ar's each independently represent an aryl group. As a suitable aspect of the aryl group, an aryl group represented by Z can be mentioned.
$R^b$'s each independently represent a substituent including the specific functional group B. The definition of the

specific functional group B is as described above. Moreover, the substituent including the specific functional group B is preferably a group represented by General Formula (Rx), a group represented by General Formula (Ry), or a group represented by General Formula (Rz).

p's each independently represent an integer of 0 to 5. p's are each preferably 0 to 2. In particular, among three p's in General Formula (W3), an aspect 1 in which two p's are 0 and one p is 1, or an aspect 2 in which three p's are all 1 is preferable.

In General Formula (W3), $T^1$'s each independently represent $-CR^c=$ or -N=. $R^c$ represents a hydrogen atom, a monovalent specific functional group B, or $-L^a-Ar-(R^b)_p$. The definitions of $L^a$, Ar, $R^b$, and p are as described above.

A molecular weight of the surface modifier B is preferably 300 or greater and more preferably 350 or greater from the viewpoint that the dispersibility of the surface-modified inorganic nitride is superior. Moreover, from the viewpoint that the solubility is excellent, the molecular weight of the surface modifier B is preferably 3,000 or less and more preferably 2,000 or less.

The surface modifier B can be synthesized according to known methods.

<Other surface modifiers>

In addition, it is also preferable that the composition (preferably, in a case where the inorganic substance includes an inorganic oxide (aluminum oxide or the like)) contains an organic silane molecule (preferably, a compound having an alkoxysilyl group) as the surface modifier. Examples of the organic silane molecule include the surface modifier A, the surface modifier B, and other surface modifiers which do not correspond to the both surface modifiers.

Examples of the organic silane molecule which is the other surface modifier include 3-aminopropyl triethoxysilane, 3-(2-aminoethyl)aminopropyl triethoxysilane, 3-aminopropyl trimethoxysilane, 3-(2-aminoethyl)aminopropyl trimethoxysilane, N-phenyl-3-aminopropyl trimethoxysilane, 3-mercapto triethoxysilane, and 3-ureidopropyl triethoxysilane.

One kind of the surface modifiers may be used singly, or two or more kinds thereof may be used.

In a case where the composition contains a surface modifier, a mass ratio (content of surface modifier/content of inorganic substance) of a content of the surface modifier to the content of the inorganic substance is preferably 0.0001 to 10 and more preferably 0.0001 to 5.

Furthermore, a mass ratio (total content of surface modifier A and surface modifier B/content of inorganic nitride) of the total content of the surface modifier A and the surface modifier B to the content of the inorganic nitride (preferably, boron nitride and/or aluminum nitride) is preferably 0.0001 to 10 and more preferably 0.0001 to 5.

A mass ratio (content of organic silane molecule/content of inorganic oxide) of the content of the organic silane molecule as the surface modifier (preferably, the organic silane molecule which is the other surface modifier) to the content of the inorganic oxide (preferably aluminum oxide) is preferably 0.0001 to 10 and more preferably 0.001 to 5.

[Curing accelerator]

The composition may further contain a curing accelerator.

A type of the curing accelerator is not limited, and examples thereof include triphenylphosphine, 2-ethyl-4-methylimidazole, a boron trifluoride amine complex, 1-benzyl-2-methylimidazole, and the compound described in paragraph 0052 in JP2012-067225A.

One kind of the curing accelerators may be used singly, or two or more kinds thereof may be used.

In a case where the composition contains a curing accelerator, a mass ratio (content of curing accelerator/content of epoxy compound) of a content of the curing accelerator to the content of the epoxy compound is preferably 0.0001 to 10 and more preferably 0.001 to 5.

[Dispersant]

The composition may further contain a dispersant.

In a case where the composition contains a dispersant, the dispersibility of the inorganic substance in the composition containing the epoxy compound and the phenolic compound is improved, and thus superior thermal conductivity and adhesiveness can be achieved.

The dispersant can be appropriately selected from commonly used dispersants. Examples thereof include DISPERBYK-106 (produced by BYK-Chemie GmbH), DISPERBYK-111 (produced by BYK-Chemie GmbH), ED-113 (produced by Kusumoto Chemicals, Ltd.), AJISPER PN-411 (produced by Ajinomoto Fine-Techno Co., Inc.), and REB 122-4 (produced by Hitachi Chemical Company, Ltd.).

One kind of the dispersants may be used singly, or two or more kinds thereof may be used.

In a case where the composition contains a dispersant, a mass ratio (content of dispersant/content of inorganic

substance) of a content of the dispersant to the content of the inorganic substance is preferably 0.0001 to 10 and more preferably 0.001 to 5.

[Solvent]

The composition may further contain a solvent.

A type of the solvent is not particularly limited, and an organic solvent is preferable. Examples of the organic solvent include cyclopentanone, cyclohexanone, ethyl acetate, methyl ethyl ketone, dichloromethane, and tetrahydrofuran.

In a case where the composition contains a solvent, a content of the solvent is preferably such that the concentration of the solid content in the composition is 20% to 90% by mass, more preferably such that the concentration is 30% to 85% by mass, and even more preferably such that the concentration is 40% to 85% by mass.

[Method for producing composition]

A method for producing the composition is not particularly limited, known methods can be adopted, and for example, the composition can be produced by mixing the aforementioned various components. In a case of mixing, the various components may be mixed at a time or mixed sequentially.

A method for mixing the components is not particularly limited, and known methods can be used. A mixing device used for the mixing is preferably a submerged disperser, and examples thereof include a rotating and revolving mixer, a stirrer such as a high-speed rotating shear-type stirrer, a colloid mill, a roll mill, a high-pressure injection-type disperser, an ultrasonic disperser, a beads mill, and a homogenizer. One kind of the mixing devices may be used singly, or two or more kinds thereof may be used. A deaeration treatment may be performed before and after the mixing and/or simultaneously with the mixing.

[Method for curing composition]

The composition according to the embodiment of the present invention is subjected to a curing treatment to obtain a thermally conductive material according to the embodiment of the present invention.

A method for curing the composition is not particularly limited, but a thermal curing reaction is preferable.

A heating temperature during the thermal curing reaction is not particularly limited. For example, the heating temperature may be appropriately selected within the range of 50°C to 250°C. Moreover, in a case where the thermal curing reaction is performed, a heating treatment may be performed a plurality of times at different temperatures.

The curing treatment is preferably performed on the composition which is formed in a film shape or a sheet shape. Specifically, for example, the composition may be applied to form a film, and a curing reaction may be performed.

In a case where the curing treatment is performed, it is preferable to apply the composition onto a substrate to form a coating film, and then cure the coating film. In this case, after further bringing the coating film formed on the substrate into contact with another substrate, the curing treatment may be performed. A cured substance (thermally conductive material) obtained after the curing may or may not be separated from one or both of the substrates.

Furthermore, in a case where the curing treatment is performed, after applying the composition onto different substrates to form respective coating films, the curing treatment may be performed in a state where the obtained coating films are in contact with each other. A cured substance (thermally conductive material) obtained after the curing may or may not be separated from one or both of the substrates.

During the curing treatment, press working may be performed. A press used for the press working is not limited, and for example, a flat plate press may be used, or a roll press may be used.

In a case where the roll press is used, for example, it is preferable that a substrate with a coating film, which is obtained by forming a coating film on a substrate, is sandwiched between a pair of rolls in which two rolls face each other, and while rotating the pair of rolls to cause the substrate with a coating film to be passed, a pressure is applied in a film thickness direction of the substrate with a coating film. In the substrate with a coating film, a substrate may be present on only one surface of a coating film, or a substrate may be present on both surfaces of a coating film. The substrate with a coating film may be passed through the roll press only once or a plurality of times.

Only one of the treatment with the flat plate press and the treatment with the roll press may be performed, or both the treatments may be performed.

In addition, the curing treatment may be completed when the composition is in a semi-cured state. The semi-cured thermally conductive material according to the embodiment of the present invention may be disposed so as to be in contact with a device to be used or the like, and then further cured by heating or the like to be finally cured. It is also preferable that the device and the thermally conductive material according to the embodiment of the present invention are attached to each other by heating or the like during the final curing.

Regarding the preparation of the thermally conductive material including a curing reaction, "Highly Thermally Conductive Composite Material" (CMC Publishing CO., LTD., written by Yoshitaka TAKEZAWA) can be referred to.
A shape of the thermally conductive material is not particularly limited, and the thermally conductive material can be molded into various shapes according to the use. Examples of a typical shape of the molded thermally conductive material include a sheet shape.
That is, it is also preferable that the thermally conductive material according to the embodiment of the present invention is a thermally conductive sheet.
Furthermore, the thermally conductive properties of the thermally conductive material according to the embodiment of the present invention are preferably isotropic rather than anisotropic.
The thermally conductive material preferably has insulating properties (electrical insulating properties). In other words, the composition according to the embodiment of the present invention is preferably a thermally conductive insulating composition.
For example, a volume resistivity of the thermally conductive material at 23°C and a relative humidity of 65% is preferably $10^{10}$ Ω·cm or greater, more preferably $10^{12}$ Ω·cm or greater, and even more preferably $10^{14}$ Ω·cm or greater. The upper limit thereof is not particularly limited, but is generally $10^{18}$ Ω·cm or less.

[Use of thermally conductive material]

The thermally conductive material according to the embodiment of the present invention can be used as a heat dissipation material such as a heat dissipation sheet, and can be used for dissipating heat from various devices. More specifically, a device with a thermally conductive layer is prepared by disposing a thermally conductive layer, which contains the thermally conductive material according to the embodiment of the present invention, on a device, and thus the heat generated from the device can be efficiently dissipated by the thermally conductive layer.
The thermally conductive material according to the embodiment of the present invention has sufficient thermally conductive properties and high heat resistance, and thus is suitable for dissipating heat from a power semiconductor device used in various electrical machines such as a personal computer, a general household electric appliance, and an automobile.
Furthermore, the thermally conductive material according to the embodiment of the present invention has sufficient thermally conductive properties even in a semi-cured state, and thus can also be used as a heat dissipation material which is disposed in a portion where light for photocuring is hardly reached, such as a gap between members of various devices. Moreover, the thermally conductive material also has excellent adhesiveness, and thus can also be used as an adhesive having thermally conductive properties.
The thermally conductive material according to the embodiment of the present invention may be used in combination with members other than the members formed of the present composition.
For example, a sheet-shaped thermally conductive material (thermally conductive sheet) may be combined with a sheet-shaped support in addition to the layer formed of the present composition.
Examples of the sheet-shaped support include a plastic film, a metal film, and a glass plate. Examples of a material of the plastic film include polyester such as polyethylene terephthalate (PET), polycarbonate, an acrylic resin, an epoxy resin, polyurethane, polyamide, polyolefin, a cellulose derivative, and silicone. Examples of the metal film include a copper film.
A film thickness of the sheet-shaped thermally conductive material (thermally conductive sheet) is preferably 100 to 300 μm and more preferably 150 to 250 μm.

<<Second aspect of present invention>>

Hereinafter, a second aspect of the present invention will be described in detail.

[Thermally conductive material-forming composition]

A thermally conductive material-forming composition (hereinafter, also simply referred to as a "composition") according to the embodiment of the present invention contains a phenolic compound, an epoxy compound, and boron nitride.
Moreover, the phenolic compound (hereinafter, also referred to as a "specific phenolic compound") satisfies the following conditions.

(1) A hydroxyl group content is 10.5 mmol/g or greater.
(2) An adsorption amount is 0.12 mg or less with respect to 1 g of boron nitride.

With the aforementioned configuration, a thermally conductive material obtained by the composition according to the embodiment of the present invention has excellent thermally conductive properties.

The action mechanism is not always clear, but the present inventors estimate as follows.

A feature point of the composition according to the embodiment of the present invention is that the specific phenolic compound is used. In the composition according to the embodiment of the present invention, the specific phenolic compound acts as a curing agent for the epoxy compound which is a main agent. By setting the adsorption amount of the specific phenolic compound with respect to the boron nitride to be equal to or less than a predetermined value, in the composition according to the embodiment of the present invention, a reaction rate of a crosslinking polymerization reaction between the epoxy compound and the specific phenolic compound is high, and a uniform crosslinking polymerization reaction between the epoxy compound and the specific phenolic compound is likely to proceed. As a result, it is estimated that the thermally conductive properties of the obtained thermally conductive material are improved.

Moreover, it is estimated that since the hydroxyl group content of the specific phenolic compound is equal to or greater than a predetermined value, a dense crosslinked structure is likely to be formed, and this also improves thus the thermally conductive properties of the obtained thermally conductive material.

Furthermore, a thermally conductive material formed of the composition according to the embodiment of the present invention also has favorable adhesiveness. Moreover, favorable insulating properties (electrical insulating properties) can also be imparted to the thermally conductive material formed of the composition according to the embodiment of the present invention.

Hereinafter, the components contained in the composition will be described in detail.

[Phenolic compound]

The composition according to the embodiment of the present invention contains a phenolic compound (specific phenolic compound) which has a hydroxyl group content of 10.5 mmol/g or greater, and an adsorption amount (hereinafter, also referred to as a "boron nitride adsorption amount") of 0.12 mg or less with respect to 1 g of the boron nitride.

The specific phenolic compound generally acts as a so-called curing agent in the composition according to the embodiment of the present invention.

The hydroxyl group content of the specific phenolic compound is 10.5 mmol/g or greater, more preferably 11.0 mmol/g or greater, even more preferably 12.0 mmol/g or greater, and particularly preferably 13.0 mmol/g or greater. Moreover, the upper limit value thereof is not particularly limited, but is preferably 25.0 mmol/g or less and more preferably 23.0 mmol/g or less.

Furthermore, the hydroxyl group content means the number of hydroxyl groups (preferably, phenolic hydroxyl groups) contained in 1 g of the specific phenolic compound.

The specific phenolic compound may have an active hydrogen-containing group (carboxylic acid group or the like) capable of a polymerization reaction with an epoxy compound, in addition to the hydroxyl group. The lower limit value of the content (total content of hydrogen atoms in a hydroxyl group, a carboxylic acid group, and the like) of an active hydrogen in the specific phenolic compound is preferably 10.5 mmol/g or greater, more preferably 11.0 mmol/g or greater, even more preferably 12.0 mmol/g or greater, and particularly preferably 13.0 mmol/g or greater. The upper limit value thereof is preferably 25.0 mmol/g or less and more preferably 23.0 mmol/g or less.

The adsorption amount (boron nitride adsorption amount of the specific phenolic compound) of the specific phenolic compound with respect to 1 g of the boron nitride is 0.12 mg or less, preferably 0.10 mg or less, and more preferably 0.08 mg or less. The lower limit value thereof is 0.00 mg or greater and preferably 0.01 mg or greater.

In the present specification, the boron nitride adsorption amount of the specific phenolic compound is defined as an adsorption amount with respect to 1 g of boron nitride "SGPS" produced by Denka Company Limited.

Furthermore, as described above, the boron nitride adsorption amount is defined as an adsorption amount with respect to 1 g of boron nitride "SGPS" produced by Denka Company Limited, but according to the examination by the present inventors, it has been confirmed that even in a case where SGPS is replaced with another boron nitride, there is a tendency to exhibit the same adsorption behavior as SGPS.

Examples of a method for measuring the boron nitride adsorption amount of the specific phenolic compound include a method using an ultraviolet-visible absorption spectrum. The method is specifically as follows.

<<Method using ultraviolet-visible absorption spectrum>>

First, a solution containing a predetermined amount of the specific phenolic compound is prepared, an ultraviolet-visible absorption spectrum of the solution is measured, and an absorbance X at an absorption maximum wavelength is determined. Thereafter, a predetermined amount of boron nitride (boron nitride "SGPS" produced by Denka Company Limited) is added to the solution, an ultraviolet-visible absorption spectrum of the resultant is measured, and an absorbance Y at an absorption maximum wavelength is determined. From the absorbance X (absorbance of the solution before

the addition of boron nitride) and the absorbance Y (absorbance of the solution after the addition of boron nitride), the adsorption amount (mg) of the phenolic compound with respect to 1 g of the boron nitride is calculated.

The upper limit value of the molecular weight of the specific phenolic compound is preferably 600 or less, more preferably 500 or less, even more preferably 450 or less, and particularly preferably 400 or less. The lower limit value thereof is preferably 110 or greater and more preferably 300 or greater.

One kind of the specific phenolic compounds may be used singly, or two or more kinds thereof may be used in combination.

Hereinafter, specific compounds which can be used as specific phenol will be described.

Examples of the specific phenolic compound include a compound represented by General Formula (1-0) and a compound represented by General Formula (2-0).

<Compound represented by General Formula (1-0)>

General Formula (1-0) will be shown below.

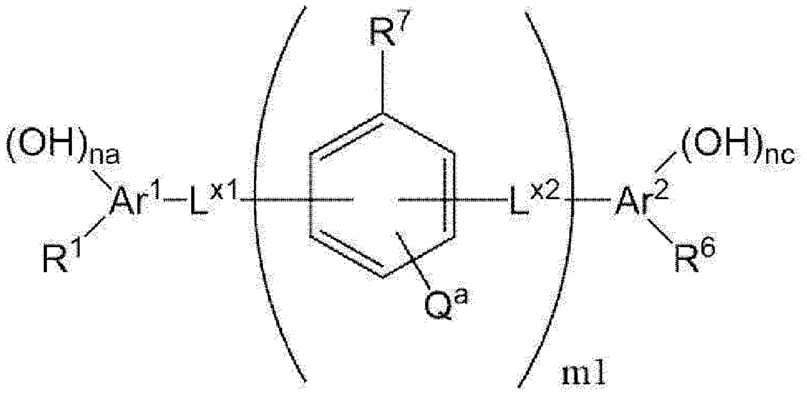

(1-0)

In General Formula (1-0), m1 represents an integer of 0 or greater.

m1 is preferably 0 to 10, more preferably 0 to 3, even more preferably 0 or 1, and particularly preferably 1.

In General Formula (1-0), na and nc each independently represent an integer of 1 or greater.

na and nc are each independently preferably 1 to 4, more preferably 2 to 4, even more preferably 2 or 3, and particularly preferably 2.

In General Formula (1-0), $R^1$ and $R^6$ each independently represent a hydrogen atom, a halogen atom, a carboxylic acid group, a boronic acid group, an aldehyde group, an alkyl group, an alkoxy group, or an alkoxycarbonyl group.

The alkyl group may be linear or branched. The number of carbon atoms in the alkyl group is preferably 1 to 10. Moreover, the alkyl group may have a substituent.

An alkyl group moiety in the alkoxy group and an alkyl group moiety in the alkoxycarbonyl group are the same as the aforementioned alkyl group.

$R^1$ and $R^6$ are each independently preferably a hydrogen atom or a halogen atom, more preferably a hydrogen atom or a chlorine atom, and even more preferably a hydrogen atom.

In General Formula (1-0), $R^7$ represents a hydrogen atom or a hydroxyl group.

It is preferable that at least one $R^7$ among $R^7$'s, which may be present in a plurality of numbers, represents a hydroxyl group, and more preferable that all of $R^7$'s represent hydroxyl groups.

In General Formula (1-0), $L^{x1}$ represents a single bond, $-C(R^2)(R^3)-$, or -CO-, and is preferably $-C(R^2)(R^3)-$ or -CO-.

$L^{x2}$ represents $-C(R^4)(R^5)-$ or -CO-, and is preferably $-C(R^4)(R^5)-$ or -CO-.

$R^2$ to $R^5$ each independently represent a hydrogen atom or a substituent.

The substituents are each independently preferably a hydroxyl group, a halogen atom, a carboxylic acid group, a boronic acid group, an aldehyde group, an alkyl group, an alkoxy group, or an alkoxycarbonyl group, and more preferably a hydroxyl group, a halogen atom, a carboxylic acid group, a boronic acid group, an aldehyde group, an alkyl group, an alkoxy group, or an alkoxycarbonyl group.

The alkyl group may be linear or branched. The number of carbon atoms in the alkyl group is preferably 1 to 10. The alkyl group may have a substituent.

An alkyl group moiety in the alkoxy group and an alkyl group moiety in the alkoxycarbonyl group are the same as the aforementioned alkyl group.

The phenyl group may have a substituent. In a case where the phenyl group has a substituent, it is more preferable to have 1 to 3 hydroxyl groups.

$R^2$ to $R^5$ are each independently preferably a hydrogen atom or a hydroxyl group and more preferably a hydrogen atom.

$L^{x1}$ and $L^{x2}$ are each independently preferably $-CH_2-$, -CH(OH)-, or -CO- and more preferably $-CH_2-$.

Among them, in a case where m1 is 0, $L^1$ is preferably $-CH_2-$, -CH(OH)-, or -CO-.

In a case where m1 is 1, $L^{x1}$ and $L^{x2}$ are each independently preferably $-CH_2-$.

Furthermore, in General Formula (1-0), in a case where there are a plurality of $R^4$'s, the plurality of $R^4$'s may be the same as or different from each other. In a case where there are a plurality of $R^5$'s, the plurality of $R^5$'s may be the same as or different from each other.

In General Formula (1-0), $Ar^1$ and $Ar^2$ each independently represent a benzene ring group or a naphthalene ring group.

$Ar^1$ and $Ar^2$ are each independently preferably a benzene ring group.

In General Formula (1-0), $Q^a$ represents a hydrogen atom, an alkyl group, a phenyl group, a halogen atom, a carboxylic acid group, a boronic acid group, an aldehyde group, an alkoxy group, or an alkoxycarbonyl group.

The alkyl group may be linear or branched. The number of carbon atoms in the alkyl group is preferably 1 to 10. The alkyl group may have a substituent.

An alkyl group moiety in the alkoxy group and an alkyl group moiety in the alkoxycarbonyl group are the same as the aforementioned alkyl group.

The phenyl group may have a substituent.

$Q^a$ is preferably bonded to a para position with respect to a hydroxyl group of a benzene ring group to which $Q^a$ is bonded.

$Q^a$ is preferably a hydrogen atom or an alkyl group. The alkyl group is preferably a methyl group.

Among them, in a case where both $Ar^1$ and $Ar^2$ are benzene ring groups, $Q^a$ is preferably an alkyl group.

Furthermore, in General Formula (1-0), in a case where there are a plurality of $R^7$'s, $L^{x2}$'s and/or $Q^a$'s, the plurality of $R^7$'s may be the same as or different from each other, the plurality of $L^{x2}$'s may be the same as or different from each other, and/or the plurality of $Q^a$'s may be the same as or different from each other.

<Compound represented by General Formula (2-0)>

General Formula (2-0) will be shown below.

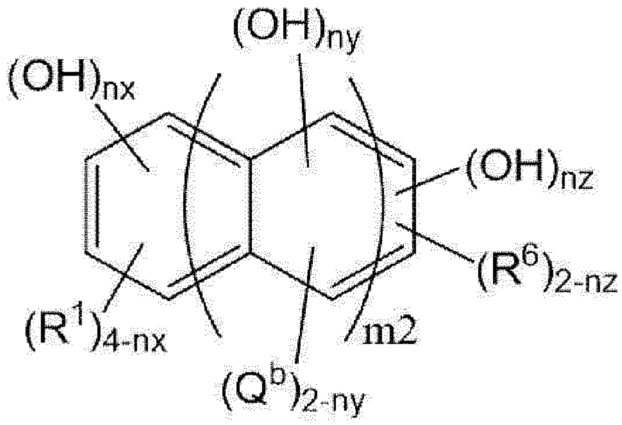

(2-0)

In General Formula (2-0), m2 represents an integer of 0 or greater.

m2 is preferably 0 to 10 and more preferably 0 to 4.

In General Formula (2-0), nx represents an integer of 0 to 4.

nx is preferably 1 to 2 and more preferably 2.

In General Formula (2-0), ny represents an integer of 0 to 2.

In a case where there are a plurality of ny's, the plurality of ny's may be the same as or different from each other.

It is preferable that at least one ny among ny's, which may be present in a plurality of numbers, represents 1. For example, in a case where m2 represents 1, it is preferable that one ny represents 1. In a case where m2 represents 4, it is preferable that at least one ny among four ny's represents 1, and more preferable that two ny's each represent 1.

In General Formula (2-0), nz represents an integer of 0 to 2.

nz is preferably 1.

In General Formula (2-0), the total number of nx, ny's which can be present in a plurality of numbers, and nz is preferably 2 or larger and more preferably 2 to 10.

In General Formula (2-0), $R^1$ and $R^6$ each independently represent a hydrogen atom, a halogen atom, a carboxylic acid group, a boronic acid group, an aldehyde group, an alkyl group, an alkoxy group, or an alkoxycarbonyl group.

$R^1$ and $R^6$ in General Formula (2-0) are the same as $R^1$ and $R^6$ in General Formula (1), respectively.

In a case where there are a plurality of $R^1$'s, the plurality of $R^1$'s may be the same as or different from each other. In a case where there are a plurality of $R^6$'s, the plurality of $R^6$'s may be the same as or different from each other.

In General Formula (2-0), $Q^b$ represents a hydrogen atom, an alkyl group, a phenyl group, a halogen atom, a carboxylic acid group, a boronic acid group, an aldehyde group, an alkoxy group, or an alkoxycarbonyl group.

The alkyl group may be linear or branched, preferably has 1 to 10 carbon atoms, and may have a substituent.

An alkyl group moiety in the alkoxy group and an alkyl group moiety in the alkoxycarbonyl group are the same as the aforementioned alkyl group.

The phenyl group may have a substituent.

$Q^b$ is preferably a hydrogen atom.

In a case where there are a plurality of $Q^b$'s, the plurality of $Q^b$'s may be the same as or different from each other.

Specific examples of the compound represented by General Formula (2-0) include benzenetriol (preferably 1,3,5-benzenetriol).

[Epoxy compound]

The composition according to the embodiment of the present invention contains an epoxy compound.

The epoxy compound generally acts as a so-called main agent in the composition according to the embodiment of the present invention.

The epoxy compound is a compound having at least one oxiranyl group (epoxy group) in one molecule. The oxiranyl group may have a substituent, if possible.

The number of oxiranyl groups contained in the epoxy compound is preferably 2 or larger, more preferably 2 to 40, even more preferably 2 to 10, and particularly preferably 2, in one molecule.

A molecular weight of the epoxy compound is preferably 150 to 10,000, more preferably 150 to 2,000, and even more preferably 250 to 400.

An oxiranyl group content of the epoxy compound is preferably 2.0 to 20.0 mmol/g and more preferably 5.0 to 15.0 mmol/g.

Moreover, the oxiranyl group content means the number of oxiranyl groups contained in 1 g of the epoxy compound.

The epoxy compound is preferably a liquid at room temperature (23°C).

For the same reason as the aforementioned specific phenolic compound, that is, from the viewpoint that the adsorptivity with respect to the boron nitride is suppressed and the thermally conductive properties of the thermally conductive material are further improved, the adsorption amount (boron nitride adsorption amount of the epoxy compound) of the epoxy compound with respect to 1 g of the boron nitride is preferably 0.20 mg or less, more preferably 0.15 mg or less, and even more preferably 0.10 mg or less. Moreover, the lower limit value thereof is 0.00 mg or greater.

Examples of a method for measuring the boron nitride adsorption amount of the epoxy compound include the method using an ultraviolet-visible absorption spectrum as described above.

The epoxy compound may exhibit liquid crystallinity.

That is, the epoxy compound may be a liquid crystal compound. In other words, the epoxy compound may be a liquid crystal compound having an oxiranyl group.

Examples of the epoxy compound (which may be a liquid crystalline epoxy compound) include a compound (rod-like compound) which has a rod-like structure in at least a portion thereof, and a compound (disk-like compound) which has a disk-like structure in at least a portion thereof.

Hereinafter, the rod-like compound and the disk-like compound will be described in detail.

(Rod-like compound)

Examples of an epoxy compound which is a rod-like compound include the same compounds as the epoxy compound which is the rod-like compound described in the first aspect of the present invention, and the preferred conditions thereof are also the same.

(Disk-like compound)

Examples of an epoxy compound which is a disk-like compound include the same compounds as the epoxy compound which is the disk-like compound described in the first aspect of the present invention, and the preferred conditions thereof are also the same.

(Other epoxy compounds)

Examples of other epoxy compounds except for the aforementioned epoxy compounds include the same compounds as the other epoxy compounds described in the first aspect of the present invention, and the preferred conditions thereof are also the same.

One kind of the epoxy compounds may be used singly, or two or more kinds thereof may be used in combination.

A ratio of the content of the epoxy compound to the content of the specific phenolic compound in the composition is preferably such that an equivalent ratio (the number of oxiranyl groups/the number of hydroxyl groups) of the oxiranyl group of the epoxy compound to the hydroxyl group of the specific phenolic compound is 30/70 to 70/30, more preferably such that the equivalent ratio is 40/60 to 60/40, and even more preferably such that the equivalent ratio is 45/55 to 55/45.

Moreover, the ratio of the content of the epoxy compound to the content of the specific phenolic compound in the composition is preferably such that an equivalent ratio (the number of oxiranyl groups/the number of active hydrogens) of the oxiranyl group of the epoxy compound to the active hydrogen (hydrogen atom in a hydroxyl group or the like) of the specific phenolic compound is 30/70 to 70/30, more preferably such that the equivalent ratio is 40/60 to 60/40, and even more preferably such that the equivalent ratio is 45/55 to 55/45.

Furthermore, in a case where the composition contains an other active hydrogen-containing compound, a ratio of the content of the epoxy compound to the total content of the specific phenolic compound and the other active hydrogen-containing compound is preferably such that an equivalent ratio (the number of oxiranyl groups/the number of active hydrogens) of the oxiranyl group of the epoxy compound to the active hydrogen (hydrogen atom in a hydroxyl group or the like) is 30/70 to 70/30, more preferably such that the equivalent ratio is 40/60 to 60/40, and even more preferably such that the equivalent ratio is 45/55 to 55/45.

In addition, the total content of the epoxy compound and the specific phenolic compound in the composition is preferably 5% to 90% by mass, more preferably 10% to 50% by mass, and even more preferably 15% to 40% by mass with respect to the total solid content of the composition.

Furthermore, the total solid content means components forming a thermally conductive material, and does not contain a solvent. The components forming a thermally conductive material mentioned here may be components of which the chemical structures are changed by being reacted (polymerized) in a case of forming a thermally conductive material. Moreover, in a case where a component is the component forming a thermally conductive material, the component is considered to be a solid content even in a case where a property of the component is liquid.

[Boron nitride]

The composition according to the embodiment of the present invention contains boron nitride (BN).

A shape of the boron nitride is not particularly limited, and may be a granule shape, a film shape, or a plate shape. Examples of a specific shape of the granule shape include a rice grain shape, a spherical shape, a cubical shape, a spindle shape, a scale shape, an aggregation shape, and an amorphous shape.

An average particle diameter of the boron nitride is preferably 500 μm or less, more preferably 300 μm or less, and even more preferably 200 μm or less, from the viewpoint that the dispersibility of the boron nitride is superior. The lower limit value thereof is not particularly limited, but is preferably 10 nm or greater and more preferably 100 nm or greater from the viewpoint of handleability, and is even more preferably 20 μm or greater and particularly preferably 50 μm or greater from the viewpoint that the thermally conductive properties of the thermally conductive material are superior.

For the average particle diameter of the boron nitride, in a case where a commercial product is used, the value listed in the catalog is adopted. In a case where a value is not listed in the catalog, as a method for measuring the average particle diameter, 100 particles of boron nitride are randomly selected using an electron microscope, particle diameters (major axes) of the respective particles of boron nitride are measured, and the arithmetic mean thereof is determined.

A content of the boron nitride in the composition is preferably 20% to 95% by mass, more preferably 30% to 95% by mass, and even more preferably 35% to 95% by mass with respect to the total solid content of the composition.

[Optional components]

The composition may contain materials other than the specific phenolic compound, the epoxy compound, and

the boron nitride, and examples thereof include other inorganic substances except for the boron nitride, a surface modifier, a curing accelerator, and a solvent.

Hereinafter, various components will be described in detail.

<Other inorganic substances except for boron nitride>

The other inorganic substances are not particularly limited, and any inorganic substances, which have been used in the related art as an inorganic filler of a thermally conductive material, may be used.

As the other inorganic substances, an inorganic oxide or an inorganic nitride (excluding boron nitride) is preferable. Moreover, the other inorganic substances may be inorganic oxynitrides.

Each shape of the other inorganic substances is not particularly limited, and may be a granule shape, a film shape, or a plate shape. Examples of the granule shape include a rice grain shape, a spherical shape, a cubical shape, a spindle shape, a scale shape, an aggregation shape, and an amorphous shape.

Examples of the inorganic oxide include zirconium oxide ($ZrO_2$), titanium oxide ($TiO_2$), silicon oxide ($SiO_2$), aluminum oxide ($Al_2O_3$), iron oxide ($Fe_2O_3$, FeO, or $Fe_3O_4$), copper oxide (CuO or $Cu_2O$), zinc oxide (ZnO), yttrium oxide ($Y_2O_3$), niobium oxide ($Nb_2O_5$), molybdenum oxide (MoOs), indium oxide ($In_2O_3$ or $In_2O$), tin oxide ($SnO_2$), tantalum oxide ($Ta_2O_5$), tungsten oxide ($WO_3$ or $W_2O_5$), lead oxide (PbO or $PbO_2$), bismuth oxide ($Bi_2O_3$), cerium oxide ($CeO_2$ or $Ce_2O_3$), antimony oxide ($Sb_2O_3$ or $Sb_2O_5$), germanium oxide ($GeO_2$ or GeO), lanthanum oxide ($La_2O_3$), and ruthenium oxide ($RuO_2$).

One kind of the inorganic oxides may be used singly, or two or more kinds thereof may be used in combination.

The inorganic oxide is preferably titanium oxide, aluminum oxide, or zinc oxide.

The inorganic oxide may be an oxide which is produced by oxidizing a metal prepared as a nonoxide in an environment or the like.

Examples of the inorganic nitride (here, boron nitride is not included) include carbon nitride ($C_3N_4$), silicon nitride ($Si_3N_4$), gallium nitride (GaN), indium nitride (InN), aluminum nitride (AlN), chromium nitride ($Cr_2N$), copper nitride ($Cu_3N$), iron nitride ($Fe_4N$), iron nitride ($Fe_3N$), lanthanum nitride (LaN), lithium nitride ($Li_3N$), magnesium nitride ($Mg_3N_2$), molybdenum nitride ($Mo_2N$), niobium nitride (NbN), tantalum nitride (TaN), titanium nitride (TiN), tungsten nitride ($W_2N$), tungsten nitride ($WN_2$), yttrium nitride (YN), and zirconium nitride (ZrN).

One kind of the inorganic nitrides may be used singly, or two or more kinds thereof may be used in combination.

The inorganic nitride preferably contains an aluminum atom or a silicon atom, more preferably contains aluminum nitride or silicon nitride, and even more preferably contains aluminum nitride.

An average particle diameter of the other inorganic substances is not particularly limited, but is preferably 500 μm or less, more preferably 300 μm or less, and even more preferably 200 μm or less, from the viewpoint that the dispersibility is superior. The lower limit value thereof is not particularly limited, but is preferably 10 nm or greater and more preferably 100 nm or greater from the viewpoint of handleability.

As a method for measuring the average particle diameter, 100 inorganic substances are randomly selected using an electron microscope, particle diameters (major axes) of the respective inorganic substances are measured, and the arithmetic mean thereof is determined. Moreover, in a case where a commercial product is used, the value listed in the catalog may be used.

One kind of the other inorganic substances may be used singly, or two or more kinds thereof may be used in combination.

In a case where the composition according to the embodiment of the present invention contains the other inorganic substances, the upper limit value of the content of the other inorganic substances is preferably 50% by mass or less and more preferably 40% by mass or less with respect to the total mass of the inorganic substance. Moreover, the lower limit value thereof is not particularly limited, but is, for example, 5% by mass or greater.

In addition, the content (which means the total content of the boron nitride, and other inorganic nitrides except for the boron nitride which can be optionally contained) of the inorganic nitride in the composition according to the embodiment of the present invention is preferably 10% to 100% by mass and more preferably 40% to 100% by mass with respect to the total mass of the inorganic substance.

<Surface modifier>

The composition according to the embodiment of the present invention may further contain a surface modifier. The surface modifier is a component which modifies surfaces of the aforementioned boron nitride and the other inorganic substances except for the boron nitride, which can be optionally contained (hereinafter, also simply referred to as an "inorganic substance").

In the present specification, "surface modification" means a state where an organic substance is adsorbed onto at least a portion of a surface of an inorganic substance. A form of the adsorption is not particularly limited, and may be

in a bonded state. That is, the surface modification also includes a state where an organic group obtained by desorbing a portion of an organic substance is bonded to a surface of an inorganic substance. The bond may be any one of a covalent bond, a coordinate bond, an ionic bond, a hydrogen bond, a van der Waals bond, or a metallic bond. In the surface-modified state, a monolayer may be formed on at least a portion of the surface. The monolayer is a single-layer film formed by chemical adsorption of organic molecules, and is known as a self-assembled monolayer (SAM). Moreover, in the present specification, the surface modification may be performed only on a portion of the surface of the inorganic substance, or may be performed on the entire surface thereof. In the present specification, a "surface-modified inorganic substance" means an inorganic substance of which the surface is modified with a surface modifier, that is, matter in which an organic substance is adsorbed onto a surface of an inorganic substance.

That is, in the composition according to the embodiment of the present invention, the inorganic substance may form a surface-modified inorganic substance in cooperation with the surface modifier. Furthermore, from the viewpoint that the adsorption of the specific phenolic compound and the epoxy compound can be further suppressed, it is preferable that the boron nitride forms a surface-modified boron nitride in cooperation with the surface modifier.

As the surface modifier, surface modifiers, which is known in the related art, such as carboxylic acid such as a long-chain alkyl fatty acid, organic phosphonic acid, organic phosphoric acid ester, and an organic silane molecule (silane coupling agent) can be used. In addition to the aforementioned surface modifiers, for example, the surface modifiers described in JP2009-502529A, JP2001-192500A, and JP4694929B may be used.

In addition, the composition preferably contains a compound having a fused-ring skeleton or a triazine skeleton as the surface modifier. The compound having a fused-ring skeleton or a triazine skeleton exhibits excellent surface modification properties for the inorganic nitride.

<Surface modifier A>

As the surface modifier, for example, a surface modifier A is preferable. Moreover, the surface modifier A is the same as the surface modifier A described in the first aspect of the present invention.

<Surface modifier B>

Furthermore, it is also preferable that the surface modifier is a surface modifier B. Moreover, the surface modifier B is the same as the surface modifier B described in the first aspect of the present invention.

(Other surface modifiers)

In addition, in a case where the composition contains an inorganic oxide (aluminum oxide or the like), it is also preferable to contain an organic silane molecule (preferably, a compound having an alkoxysilyl group) as the surface modifier. Examples of the organic silane molecule include the surface modifier A, the surface modifier B, and other surface modifiers which do not correspond to the both surface modifiers.

Examples of the organic silane molecule which is the other surface modifier include 3-aminopropyl triethoxysilane, 3-(2-aminoethyl)aminopropyl triethoxysilane, 3-aminopropyl trimethoxysilane, 3-(2-aminoethyl)aminopropyl trimethoxysilane, N-phenyl-3-aminopropyl trimethoxysilane, 3-mercapto triethoxysilane, and 3-ureidopropyl triethoxysilane.

One kind of the surface modifiers may be used singly, or two or more kinds thereof may be used in combination.

In a case where the composition contains a surface modifier, a mass ratio (content of surface modifier/content of inorganic substance) of a content of the surface modifier to the content of the inorganic substance is preferably 0.0001 to 10 and more preferably 0.0001 to 5.

Furthermore, a mass ratio (total content of surface modifier A and surface modifier B/content of inorganic nitride) of the total content of the surface modifier A and the surface modifier B to the content (which means the total content of the boron nitride, and other inorganic nitrides except for the boron nitride which can be optionally contained) of the inorganic nitride is preferably 0.0001 to 10 and more preferably 0.0001 to 5.

A mass ratio (content of organic silane molecule/content of inorganic oxide) of the content of the organic silane molecule as the surface modifier (preferably, the organic silane molecule which is the other surface modifier) to the content of the inorganic oxide (preferably aluminum oxide) is preferably 0.0001 to 10 and more preferably 0.001 to 5.

<Curing accelerator>

The composition may contain a curing accelerator.

A type of the curing accelerator is not limited, and examples thereof include triphenylphosphine, 2-ethyl-4-methylimidazole, a boron trifluoride amine complex, 1-benzyl-2-methylimidazole, and the compound described in paragraph 0052 in JP2012-067225A.

One kind of the curing accelerators may be used singly, or two or more kinds thereof may be used in combination.

In a case where the composition contains a curing accelerator, a mass ratio (content of curing accelerator/content of epoxy compound) of a content of the curing accelerator to the content of the epoxy compound is preferably 0.0001 to 10 and more preferably 0.001 to 5.

<Dispersant>

The composition may contain a dispersant.

In a case where the composition contains a dispersant, the dispersibility of the inorganic substance in the composition containing the epoxy compound and the specific phenolic compound is improved, and thus superior thermal conductivity and adhesiveness can be achieved.

The dispersant can be appropriately selected from commonly used dispersants. Examples thereof include DISPERBYK-106 (produced by BYK-Chemie GmbH), DISPERBYK-111 (produced by BYK-Chemie GmbH), ED-113 (produced by Kusumoto Chemicals, Ltd.), AJISPER PN-411 (produced by Ajinomoto Fine-Techno Co., Inc.), and REB 122-4 (produced by Hitachi Chemical Company, Ltd.).

One kind of the dispersants may be used singly, or two or more kinds thereof may be used in combination.

In a case where the composition contains a dispersant, a mass ratio (content of dispersant/content of inorganic substance) of a content of the dispersant to the content of the inorganic substance is preferably 0.0001 to 10 and more preferably 0.001 to 5.

<Solvent>

The composition may contain a solvent.

A type of the solvent is not particularly limited, and an organic solvent is preferable. Examples of the organic solvent include cyclopentanone, cyclohexanone, ethyl acetate, methyl ethyl ketone, dichloromethane, and tetrahydrofuran.

In a case where the composition contains a solvent, a content of the solvent is preferably such that the concentration of the solid content in the composition is 20% to 90% by mass, more preferably such that the concentration is 30% to 85% by mass, and even more preferably such that the concentration is 40% to 85% by mass.

[Method for producing composition]

A method for producing the composition is not particularly limited, known methods can be adopted, and for example, the composition can be produced by mixing the aforementioned various components. In a case of mixing, the various components may be mixed at a time or mixed sequentially.

A method for mixing the components is not particularly limited, and known methods can be used. A mixing device used for the mixing is preferably a submerged disperser, and examples thereof include a rotating and revolving mixer, a stirrer such as a high-speed rotating shear-type stirrer, a colloid mill, a roll mill, a high-pressure injection-type disperser, an ultrasonic disperser, a beads mill, and a homogenizer. One kind of the mixing devices may be used singly, or two or more kinds thereof may be used in combination. A deaeration treatment may be performed before and after the mixing and/or simultaneously with the mixing.

[Method for curing composition]

The composition according to the embodiment of the present invention is subjected to a curing treatment to obtain a thermally conductive material according to the embodiment of the present invention.

A method for curing the composition is not particularly limited, but a thermal curing reaction is preferable.

A heating temperature during the thermal curing reaction is not particularly limited. For example, the heating temperature may be appropriately selected within the range of 50°C to 250°C. Moreover, in a case where the thermal curing reaction is performed, a heating treatment may be performed a plurality of times at different temperatures.

The curing treatment is preferably performed on the composition which is formed in a film shape or a sheet shape. Specifically, for example, the composition may be applied to form a film, and a curing reaction may be performed.

In a case where the curing treatment is performed, it is preferable to apply the composition onto a substrate to form a coating film, and then cure the coating film. In this case, after further bringing the coating film formed on the substrate into contact with another substrate, the curing treatment may be performed. A cured substance (thermally conductive material) obtained after the curing may be separated from one or both of the substrates.

Furthermore, in a case where the curing treatment is performed, after applying the composition onto different

substrates to form respective coating films, the curing treatment may be performed in a state where the obtained coating films are in contact with each other. A cured substance (thermally conductive material) obtained after the curing may be separated from one or both of the substrates.

During the curing treatment, press working may be performed. A press used for the press working is not limited, and for example, a flat plate press may be used, or a roll press may be used.

In a case where the roll press is used, for example, it is preferable that a substrate with a coating film, which is obtained by forming a coating film on a substrate, is sandwiched between a pair of rolls in which two rolls face each other, and while rotating the pair of rolls to cause the substrate with a coating film to be passed, a pressure is applied in a film thickness direction of the substrate with a coating film. In the substrate with a coating film, a substrate may be present on only one surface of a coating film, or a substrate may be present on both surfaces of a coating film. The substrate with a coating film may be passed through the roll press only once or a plurality of times.

Only one of the treatment with the flat plate press and the treatment with the roll press may be performed, or both the treatments may be performed.

In addition, the curing treatment may be completed when the composition is in a semi-cured state. The semi-cured thermally conductive material according to the embodiment of the present invention may be disposed so as to be in contact with a device to be used or the like, and then further cured by heating or the like to be finally cured. It is also preferable that the device and the thermally conductive material according to the embodiment of the present invention are attached to each other by heating or the like during the final curing.

Regarding the preparation of the thermally conductive material including a curing reaction, "Highly Thermally Conductive Composite Material" (CMC Publishing CO., LTD., written by Yoshitaka TAKEZAWA) can be referred to.

A shape of the thermally conductive material is not particularly limited, and the thermally conductive material can be molded into various shapes according to the use. Examples of a typical shape of the molded thermally conductive material include a sheet shape.

Furthermore, the thermally conductive properties of the thermally conductive material according to the embodiment of the present invention are preferably isotropic rather than anisotropic.

[Physical properties of thermally conductive material]

[Volume resistivity]

The thermally conductive material preferably has insulating properties (electrical insulating properties). In other words, the composition according to the embodiment of the present invention is preferably a thermally conductive insulating composition.

For example, a volume resistivity of the thermally conductive material at 23°C and a relative humidity of 65% is preferably $10^{10}$ Ω·cm or greater, more preferably $10^{12}$ Ω·cm or greater, and even more preferably $10^{14}$ Ω·cm or greater. The upper limit thereof is not particularly limited, but is generally $10^{18}$ Ω·cm or less.

[Density ratio X]

In addition, in the thermally conductive material, a density ratio X determined from Expression (1) is preferably 0.96 or greater. The density ratio X of 0.96 or greater means that the generation of voids (pores) in the thermally conductive material is suppressed. The density ratio X is more preferably 0.99 or greater from the viewpoint that the thermally conductive properties of the thermally conductive material are superior. Moreover, the upper limit value of the density ratio X is 1.

The composition according to the embodiment of the present invention suppresses the adsorptivity of the specific phenolic compound and the epoxy compound with respect to the boron nitride to be low, and thus tends to have a low viscosity. In particular, in a case where each molecular weight of the specific phenolic compound and the epoxy compound is smaller and/or the leveling of each molecule of the specific phenolic compound and the epoxy compound is lower, the adsorptivity with respect to the boron nitride is likely to be lower, and thus the viscosity of the composition is likely to be lower. It is estimated that in a case where the viscosity of the composition according to the embodiment of the present invention is lower, the generation of voids is further suppressed in the obtained thermally conductive material, and the density X tends to easily satisfy the aforementioned value.

Density ratio X = activity measured density of thermally conductive material determined by Archimedes method/theoretical density Di of thermally conductive material determined by Expression (DI) Expression (1)

Expression (DI)

$$Di = Df \times Vf/100 + Dr \times Vr/100$$

In Expression (DI), Di means a density of a theoretical thermally conductive material T which consists of an organic nonvolatile component and an inorganic substance including the boron nitride. That is, the thermally conductive material T means a hypothetical thermally conductive material which consists of the inorganic substance including the boron nitride and the organic nonvolatile component and does not include voids (pores).

Moreover, a content mass Wf of the inorganic substance in the thermally conductive material T is equal to a content of an inorganic substance in the thermally conductive material-forming composition. Furthermore, a content mass Wr of the organic volatile component in the thermally conductive material T is equal to a value obtained by subtracting the content of the inorganic substance from a content of a total solid content in the thermally conductive material-forming composition. The definition of the total solid content is as described above.

In Expression (DI), Df is a density (g/cm$^3$) of the inorganic substance.

The density of the inorganic substance is a real density measured by a pycnometer method.

Moreover, in a case where a type of the used inorganic substance and a density value of that type of the inorganic substance are known, the known density value may be used as a density of the inorganic substance. For example, the density of boron nitride is generally 2.3 g/cm$^3$, and the density of aluminum oxide (alumina) is generally 3.9 g/cm$^3$.

In a case where the known density value is used as the density of the inorganic substance, and a case where the thermally conductive material contains two or more kinds of inorganic substances, a density of the entire inorganic substance is determined by weight-averaging the densities of the respective inorganic substances with content proportions (volume fractions) of the respective inorganic substances.

Furthermore, a method for specifying the type of the inorganic substance contained in the thermally conductive material and the content proportion thereof is not limited, and known methods (observation with an electron microscope, an infrared spectroscopy, and/or energy dispersive X-ray analysis) can be used.

In Expression (DI), Dr is a density (g/cm$^3$) of the organic nonvolatile component. The organic nonvolatile component in the thermally conductive material according to the embodiment of the present invention is mainly a polymer of the specific phenol and the epoxy compound, a density of this polymer is generally 1.2 g/cm$^3$, and thus the density of the organic nonvolatile component represented by Dr is assumed to be 1.2 g/cm$^3$.

In Expression (DI), Vf is a volume percentage of a volume of the inorganic substance in the thermally conductive material T to a volume of the thermally conductive material T. Vf is specifically a value determined by Expression (DII).

Expression (DII)

$$Vf = (Wf/Df)/((Wf/Df) + (Wr/Dr)) \times 100$$

Moreover, (Wf/Df) means a volume (cm$^3$) occupied by the inorganic substance in the thermally conductive material T. (Wr/Dr) means a volume (cm$^3$) occupied by the organic nonvolatile component in the thermally conductive material T.

In Expression (DI), Vr is a volume percentage of a volume of the organic nonvolatile component in the thermally conductive material T to the volume of the thermally conductive material T. Vr is specifically a value determined by Expression (DIII).

Expression (DIII)

$$Vr = 100 - Vf$$

More specifically, the theoretical density Di is determined by the following method (combustion method).

The content mass of the inorganic substance can be measured by using a general ash content measuring method. That is, a film is treated (subjected to a combustion treatment) at 500°C to 550°C for 4 hours or longer using a crucible made of platinum, quartz, or ceramic, and incinerated until the residues have a constant weight. The weight after the combustion treatment is defined as the content mass (Wf, unit: g) of the inorganic substance contained in the film.

Thereafter, a value of a mass obtained by subtracting the measured content mass (Wf, unit: g) of the inorganic substance from the mass (WO, unit: g) of the thermally conductive material before the combustion treatment is defined

as the content mass (Wr, unit: g) of the organic nonvolatile component in the thermally conductive material T.

From these values, a volume percentage (Vf) of the volume occupied by the inorganic substance in the thermally conductive material T is determined according to Expression (DII). Moreover, a volume percentage (Vr) of the volume occupied by the organic nonvolatile component in the thermally conductive material T is determined according to Expression (DIII).

Finally, a density (Di, unit: g/$cm^3$) of the thermally conductive material T is calculated according to Expression (DI).

In addition, in a case where formulation of the thermally conductive material or formulation of a composition (thermally conductive material-forming composition) for forming the thermally conductive material is known, the theoretical density of the film may be determined by performing calculation from the formulation.

For example, in a case where the thermally conductive material-forming composition consists of an inorganic substance, a solvent (an organic solvent and the like), and other components (a phenolic compound, an epoxy compound, a surface modifier, and the like), a thermally conductive material is assumed to be formed of only the inorganic substance and the other components.

Then, a mass (Wf, unit: g) of the inorganic substance is used. Next, the other components are regarded as the organic nonvolatile component, and a total mass of the other components is used as the mass (Wr, unit: g) of the organic nonvolatile component.

From these values, a volume percentage (Vf) of the volume occupied by the inorganic substance in the thermally conductive material T is determined according to Expression (DII). Moreover, a volume percentage (Vr) of the volume occupied by the organic nonvolatile component in the thermally conductive material T is determined according to Expression (DIII).

Finally, a density (Di, unit: g/$cm^3$) of the thermally conductive material T is calculated according to Expression (DI).

[Use of thermally conductive material]

The thermally conductive material according to the embodiment of the present invention can be used as a heat dissipation material such as a heat dissipation sheet, and can be used for dissipating heat from various devices. More specifically, a device with a thermally conductive layer is prepared by disposing a thermally conductive layer, which contains the thermally conductive material according to the embodiment of the present invention, on a device, and thus the heat generated from the device can be efficiently dissipated by the thermally conductive layer.

The thermally conductive material according to the embodiment of the present invention has sufficient thermally conductive properties and high heat resistance, and thus is suitable for dissipating heat from a power semiconductor device used in various electrical machines such as a personal computer, a general household electric appliance, and an automobile.

Furthermore, the thermally conductive material according to the embodiment of the present invention has sufficient thermally conductive properties even in a semi-cured state, and thus can also be used as a heat dissipation material which is disposed in a portion where light for photocuring is hardly reached, such as a gap between members of various devices. Moreover, the thermally conductive material also has excellent adhesiveness, and thus can also be used as an adhesive having thermally conductive properties.

The thermally conductive material according to the embodiment of the present invention may be used in combination with other members except for the members formed of the present composition.

Examples of a material obtained by combining the thermally conductive material according to the embodiment of the present invention with the other members include a thermally conductive sheet. Examples of a specific configuration of the thermally conductive sheet include a configuration in which a sheet-shaped support and a sheet-shaped thermally conductive material disposed on the support are provided.

Examples of the support include a plastic film, a metal film, and a glass plate. Examples of a material of the plastic film include polyester such as polyethylene terephthalate (PET), polycarbonate, an acrylic resin, an epoxy resin, polyurethane, polyamide, polyolefin, a cellulose derivative, and silicone. Examples of the metal film include a copper film.

Examples

Hereinafter, the present invention will be described in more detail based on Examples. The materials, the amount and proportion of the materials used, the details of treatments, the procedure of treatments, and the like shown in the following Examples can be appropriately changed within a range that does not depart from the gist of the present invention. Accordingly, the scope of the present invention is not limitedly interpreted by the following Examples.

In addition, Examples A and Bare shown below, and Example numbers, table numbers, or the like mentioned in each Example refer to Example numbers, table numbers, or the like in each Example. For example, Example 1

mentioned in Example B refers to Example 1 in Example B. Similarly, Table 1 mentioned in Example B refers to Table 1 in Example B.

«Example A: Example according to first aspect of present invention»

Hereinafter, Example according to the first aspect of the present invention will be described.

[Preparation and evaluation of composition]

[Various components]

Various components used in Examples and Comparative Example will be shown below.

<Phenolic compound>

Phenolic compounds used in Examples and Comparative Example will be shown below.
Moreover, the phenolic compounds used in Examples were synthesized with reference to US4992596A.

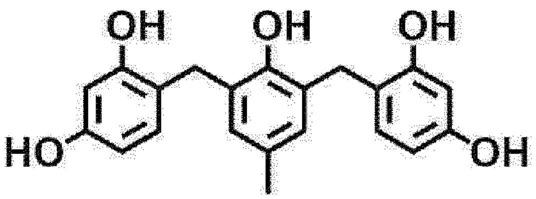

Molecular Weight: 352.39
A-1

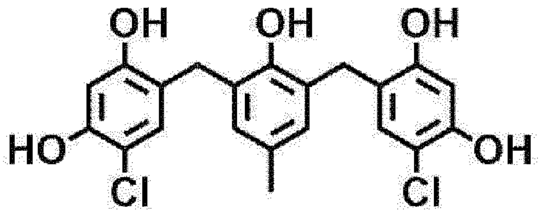

Molecular Weight: 421.27
A-2

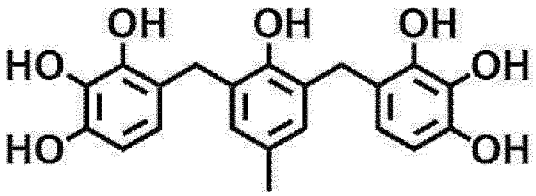

Molecular Weight: 384.38
A-3

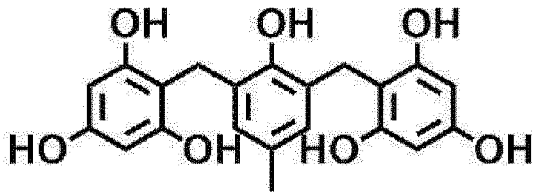

Molecular Weight: 384.38
A-4

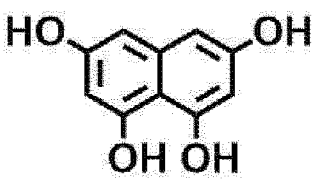

Molecular Weight: 192.17
A-5

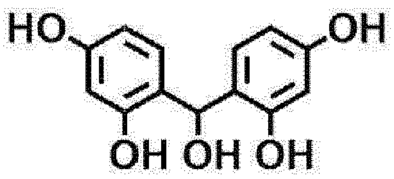

Molecular Weight: 248.23
A-6

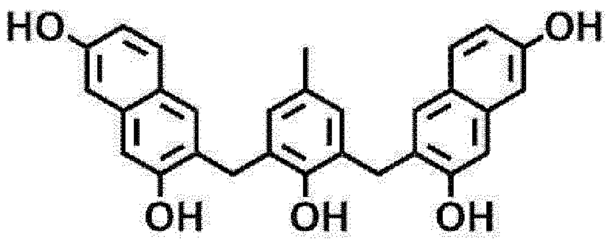

Molecular Weight: 452.51

A-7

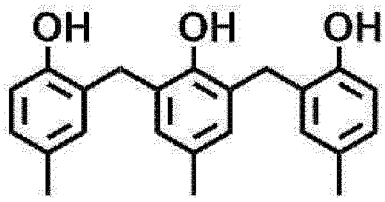

Molecular Weight: 348.44

D-1

<Epoxy compound>

Epoxy compounds used in Examples and Comparative Example will be shown below.

Moreover, the following B-5 is a mixture of two kinds of epoxy compounds (trade name: EPOTOHTO ZX-1059, produced by Tohto Kasei Co., Ltd.).

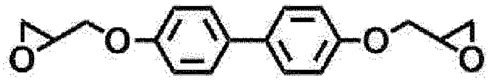

Molecular Weight: 298.34

B-1

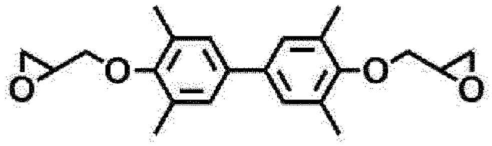

Molecular Weight: 354.45

B-2

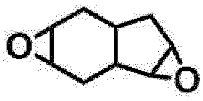

Molecular Weight: 152.19

B-3

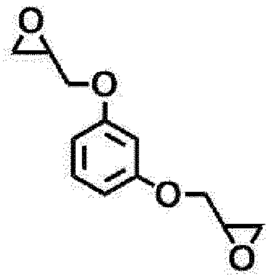

Molecular Weight: 222.24

B-4

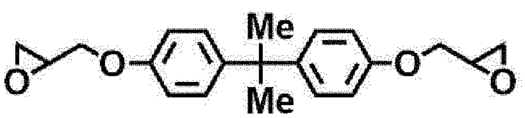

Molecular Weight: 340.42

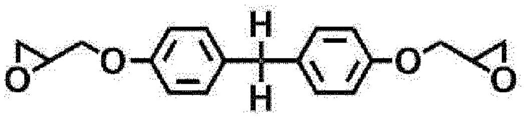

Molecular Weight: 312.37

B-5

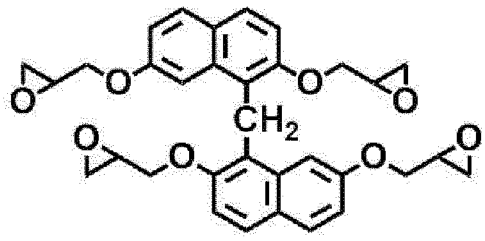

Molecular Weight: 556.61

B-6

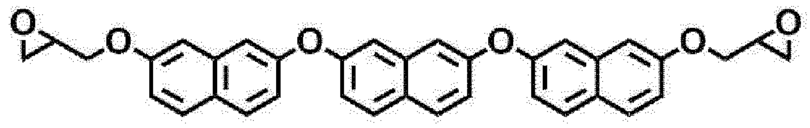

Molecular Weight: 556.61

B-7

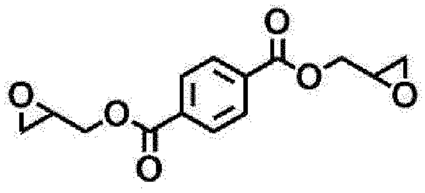

Molecular Weight: 278.26

B-8

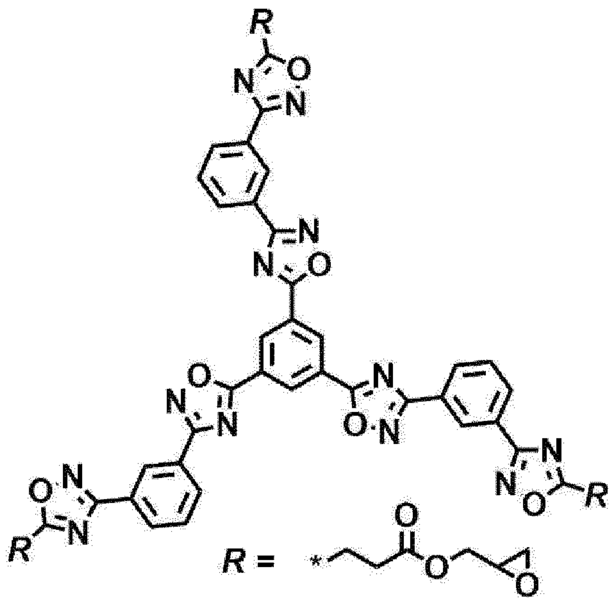

Molecular Weight: 1099

B-9

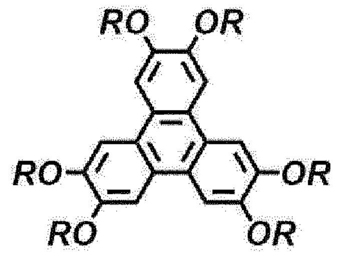

OR = 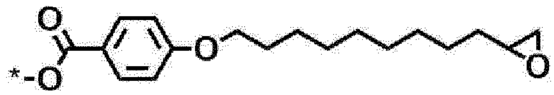

Molecular Weight: 1800

B-10

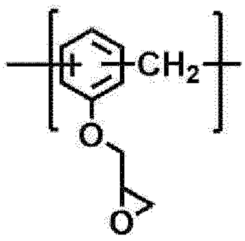

B-11

<Inorganic substance>

Inorganic substances used in Examples and Comparative Example will be shown below.

"PTX-60": aggregation-shaped boron nitride (average particle diameter: 60 μm, produced by Momentive)
"PT-110": flat plate-shaped boron nitride (average particle diameter: 45 μm, produced by Momentive)
"AA-3": aluminum oxide (average particle diameter: 3 μm, produced by Sumitomo Chemical Co., Ltd.)
"AA-04": aluminum oxide (average particle diameter: 0.4 μm, produced by Sumitomo Chemical Co., Ltd.)
"S-50": aluminum nitride (average particle diameter: 55 μm, produced by MARUWA Co., Ltd.)
"HP40 MF100": aggregation-shaped boron nitride (average particle diameter: 40 μm, produced by MIZUSHIMA FERROALLOY CO., LTD.)

<Curing accelerator>

$PPh_3$ (triphenylphosphine) was used as the curing accelerator.

<Solvent>

Cyclopentanone was used as the solvent.

<Dispersant>

DISPERBYK-106 (polymer salt having an acidic group) was used as the dispersant.

<Surface treatment agent for aluminum oxide (organic silane molecule)>

The following compound was used as the surface modifier for aluminum oxide.

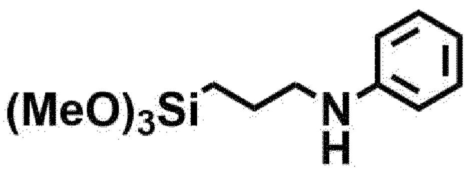

<Surface modifier for inorganic nitride>

Surface modifiers for an inorganic nitride used in Examples and Comparative Example will be shown below.

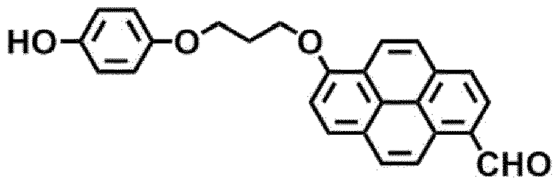

(A)

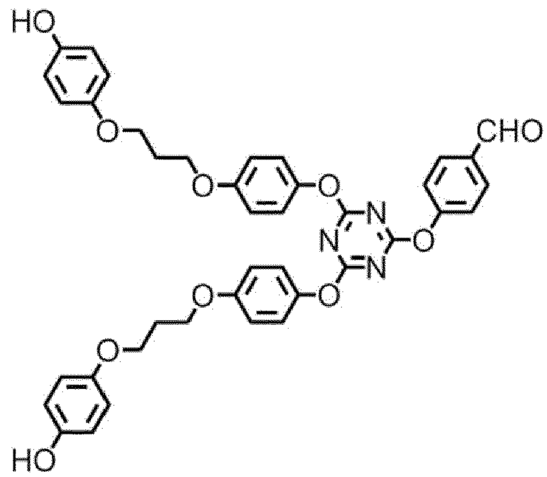

(B)

[Preparation of composition]

A curing liquid was prepared by formulating the epoxy compound and the phenolic compound of each combination shown in Table 1 below in an equivalent (amount in which the number of oxiranyl groups in the epoxy compound is equal to the number of hydroxyl groups in the phenolic compound).

The aforementioned curing liquid, solvent, dispersant, surface modifier (the surface modifier for aluminum oxide and the surface modifier for an inorganic nitride), and curing accelerator were mixed in this order, and then the inorganic substance was added thereto. The obtained mixture was treated for 5 minutes with a rotating and revolving mixer (manufactured by THINKY CORPORATION, AWATORI RENTARO ARE-310) to obtain a composition (thermally conductive material-forming composition) of each Example or Comparative Example.

Here, the addition amount of the solvent was set such that the concentration of the solid content in the composition was 50% to 80% by mass.

Furthermore, the concentration of the solid content in the composition was adjusted for each composition within the above range so that the viscosities of the compositions were about the same.

The addition amount of the curing accelerator was set such that the content of the curing accelerator in the composition was 1% by mass with respect to the content of the epoxy compound.

The addition amount (total of all inorganic substances) of the inorganic substance was set such that the content of the inorganic substance in the composition was a value (% by mass) shown in Table 1 with respect to the total solid content of the composition.

Moreover, the inorganic substances were used after being mixed so that a ratio (mass ratio) of contents of the respective inorganic substances satisfied a relationship shown in Table 1.

The addition amount of the dispersant was set such that the content of the dispersant in the composition was 0.2% by mass with respect to the content of the inorganic substance.

The addition amount of the surface modifier for aluminum oxide was set such that the content of the surface modifier for aluminum oxide in the composition was 0.2% by mass with respect to the content (total content of AA-3 and AA04) of the aluminum oxide. Moreover, in a case where the composition did not contain aluminum oxide, the surface modifier for aluminum oxide was not used.

In a case where the surface modifier for an inorganic nitride was used, the addition amount of the surface modifier for an inorganic nitride was set such that the content of the surface modifier for an inorganic nitride in the composition was 0.3% by mass with respect to the content (total addition amount of PTX-60, PT-110, HP-40 MF100, and S-50) of the inorganic nitride.

[Evaluation]

<Thermally conductive properties>

The prepared composition was uniformly applied onto a release surface of a release-treated polyester film (NP-100A, manufactured by PANAC CO., LTD., film thickness of 100 μm) by using an applicator, and left to stand at 120°C for 5 minutes to obtain a coating film.

Two polyester films with such a coating film were prepared, and after laminating the coating film surfaces with each other, two polyester films with a coating film were hot-pressed (treated for 1 minute at a hot plate temperature of 65°C and a pressure of 12 MPa) in the air to obtain a semi-cured film. The obtained semi-cured film was treated with a hot press (treated for 20 minutes at a hot plate temperature of 160°C and a pressure of 12 MPa, and then for 90 minutes at 180°C and a normal pressure) in the air to cure the coating film, thereby obtaining a resin sheet. The polyester films on both surfaces of the resin sheet were peeled off to obtain a thermally conductive sheet having an average film thickness of 200 μm.

The evaluation of thermally conductive properties was performed using each thermally conductive sheet which was obtained by using each composition. The thermal conductivity was measured by the following method, and the thermally conductive properties were evaluated according to the following standards.

(Measurement of thermal conductivity (W/m·k))

(1) By using "LFA 467" manufactured by NETZSCH, the thermal diffusivity of the thermally conductive sheet in a thickness direction was measured through a laser flash method.
(2) By using a balance "XS204" manufactured by METTLER TOLEDO, the specific gravity of the thermally conductive sheet was measured through an Archimedes method ("solid specific gravity measuring kit" was used).
(3) By using "DSC320/6200" manufactured by Seiko Instruments Inc., the specific heat of the thermally conductive sheet at 25°C was determined under a temperature rising condition of 10 °C/min.
(4) The thermal conductivity of the thermally conductive sheet was calculated by multiplying the obtained thermal diffusivity by the specific gravity and the specific heat.

(Evaluation standards)

The measured thermal conductivity was classified according to the following standards, and the thermally conductive properties were evaluated.

"A+": 15 W/m·K or greater
"A": 10 W/m·K or greater and less than 15 W/m·K
"B": 8 W/m·K or greater and less than 10 W/m·K
"C": 5 W/m·K or greater and less than 8 W/m·K
"D": Less than 5 W/m·K

The results are shown in Table 1.

<Insulating properties>

A volume resistance value of a thermally conductive sheet, which was prepared in the same manner as in the evaluation of "Thermally conductive properties", at 23°C and a relative humidity of 65% was measured using a HIRESTA MCP-HT450 type (manufactured by Nittoseiko Analytech Co., Ltd.).

(Evaluation standards)

The measured volume resistance value of the thermally conductive sheet was classified according to the following standards, and the insulating properties were evaluated.

"A": $10^{14}$ Ω·cm or greater
"B": $10^{12}$ Ω·cm or greater and less than $10^{14}$ Ω·cm
"C": $10^{10}$ Ω·cm or greater and less than $10^{12}$ Ω·cm

"D": Less than $10^{10}$ Ω·cm

<Adhesiveness>

A tensile shear test based on JIS K 6850 was performed using copper plates as adherends and the composition as an adhesive.

Moreover, a test specimen was prepared by laminating two copper plates (size: 100 mm × 25 mm × 0.3 mm) with each other with an adhesion area of 12.5 mm × 25 mm.

The curing conditions of the composition were the same as those in a case where the thermally conductive sheet was prepared in the measurement of the thermally conductive properties.

For the test, TENSILON UNIVERSAL MATERIAL TESTING INSTRUMENT RTc-1225A was used, and a tensile rate was 0.05 mm/s.

(Evaluation standards)

The measured breaking stress was classified according to the following standards, and the adhesiveness was evaluated.

"A": 5 MPa or greater
"B": 4 MPa or greater and less than 5 MPa
"C": 3 MPa or greater and less than 4 MPa
"D": Less than 3 MPa

[Results]

Table 1 will be shown below.

In Table 1, a column of "Specific skeleton" indicates whether the used epoxy compound has a biphenyl skeleton. A case where the requirement is satisfied is indicated as A, and a case where the requirement is not satisfied is indicated as B.

A column of "Number of functional groups" indicates the hydroxyl group content (mmol/g) of the used phenolic compound.

A column of "Surface modifier" indicates the type of the used surface modifier for an inorganic nitride.

[Table 1]

| Table 1 | Characteristics of composition | | | | | | | | Evaluation | | |
|---|---|---|---|---|---|---|---|---|---|---|---|
| | Phenolic compound | | | Epoxy compound | | Inorganic substance formulation (mass ratio) | Content of inorganic substance (% by mass) | Type of surface modifier | Thermal conductivity | Insulating properties | Adhesiveness |
| | Type | Molecular weight | Number of functional groups (mmol/g) | Type | Specific skeleton | | | | | | |
| Example 1 | A-1 | 352 | 14.2 | B-1 | A | PTX-60/AA-3/AA-04 = 47/40/13 | 77 | A | A+ | A | A |
| Example 2 | A-1 | 352 | 14.2 | B-2 | A | PTX-60/AA-3/AA-04 = 47/40/13 | 77 | A | A+ | A | A |
| Example 3 | A-1 | 352 | 14.2 | B-2 | A | PTX-60/AA-3/AA-04 = 47/40/13 | 82 | A | A+ | A | A |
| Example 4 | A-1 | 352 | 14.2 | B-2 | A | PTX-60/AA-3/AA-04 = 47/40/13 | 87 | A | A+ | A | A |
| Example 5 | A-1 | 352 | 14.2 | B-2 | A | PT-110/AA-3/AA-04 = 47/40/13 | 77 | A | A+ | A | A |
| Example 6 | A-1 | 352 | 14.2 | B-2 | A | HP-40 MF100/AA-3/AA-04 = 47/40/13 | 77 | None | A | A | A |
| Example 7 | A-1 | 352 | 14.2 | B-2 | A | HP-40 MF100/AA-3/AA-04 = 47/40/13 | 77 | A | A+ | A | A |
| Example 8 | A-1 | 352 | 14.2 | B-2 | A | HP-40 MF100/AA-3/AA-04 = 47/40/13 | 82 | A | A+ | A | A |
| Example 9 | A-1 | 352 | 14.2 | B-2 | A | HP-40 MF100/AA-3/AA-04 = 47/40/13 | 87 | A | A+ | A | A |

(continued)

| Table 1 | Characteristics of composition | | | | | | | | Evaluation | | |
|---|---|---|---|---|---|---|---|---|---|---|---|
| | Phenolic compound | | | Epoxy compound | | Inorganic substance formulation (mass ratio) | Content of inorganic substance (% by mass) | Type of surface modifier | Thermal conductivity | Insulating properties | Adhesiveness |
| | Type | Molecular weight | Number of functional groups (mmol/g) | Type | Specific skeleton | | | | | | |
| Example 10 | A-1 | 352 | 14.2 | B-2 | A | Only HP-40 MF100 | 77 | None | A | A | A |
| Example 11 | A-1 | 352 | 14.2 | B-2 | A | Only HP-40 MF100 | 77 | A | A+ | A | A |
| Example 12 | A-1 | 352 | 14.2 | B-2 | A | Only HP-40 MF100 | 82 | A | A+ | A | A |
| Example 13 | A-1 | 352 | 14.2 | B-2 | A | Only HP-40 MF100 | 87 | A | A+ | A | A |
| Example 14 | A-1 | 352 | 14.2 | B-2 | A | Only HP-40 MF100 | 77 | B | A+ | A | A |
| Example 15 | A-1 | 352 | 14.2 | B-2 | A | Only HP-40 MF100 | 82 | B | A+ | A | A |
| Example 16 | A-1 | 352 | 14.2 | B-2 | A | Only HP-40 MF100 | 87 | B | A+ | A | A |
| Example 17 | A-1 | 352 | 14.2 | B-2 | A | S-50/AA-3/AA-04 = 47/40/13 | 77 | None | A | A | A |
| Example 18 | A-1 | 352 | 14.2 | B-2 | A | Only PTX-60 | 77 | None | A | A | A |
| Example 19 | A-1 | 352 | 14.2 | B-3 | B | PTX-60/AA-3/AA-04 = 47/40/13 | 77 | None | B | A | A |
| Example 20 | A-1 | 352 | 14.2 | B-4 | B | PTX-60/AA-3/AA-04 = 47/40/13 | 77 | None | B | A | A |

(continued)

| Table 1 | Characteristics of composition | | | | | | | | Evaluation | | |
|---|---|---|---|---|---|---|---|---|---|---|---|
| | Phenolic compound | | | Epoxy compound | | Inorganic substance formulation (mass ratio) | Content of inorganic substance (% by mass) | Type of surface modifier | Thermal conductivity | Insulating properties | Adhesiveness |
| | Type | Molecular weight | Number of functional groups (mmol/g) | Type | Specific skeleton | | | | | | |
| Example 21 | A-1 | 352 | 14.2 | B-5 | B | PTX-60/AA-3/AA-04 = 47/40/13 | 77 | None | B | A | A |
| Example 22 | A-1 | 352 | 14.2 | B-6 | B | PTX-60/AA-3/AA-04 = 47/40/13 | 77 | None | B | A | A |
| Example 23 | A-1 | 352 | 14.2 | B-7 | B | PTX-60/AA-3/AA-04 = 47/40/13 | 77 | None | B | A | B |
| Example 24 | A-1 | 352 | 14.2 | B-8 | B | PTX-60/AA-3/AA-04 = 47/40/13 | 77 | None | B | A | A |
| Example 25 | A-1 | 352 | 14.2 | B-9 | B | PTX-60/AA-3/AA-04 = 47/40/13 | 77 | None | B | A | B |

[Table 2]

| Table 1 | Characteristics of composition | | | | | | | | Evaluation | | |
|---|---|---|---|---|---|---|---|---|---|---|---|
| | Phenolic compound | | | Epoxy compound | | Inorganic substance formulation (mass ratio) | Content of inorganic substance (% by mass) | Type of surface modifier | Thermal conductivity | Insulating properties | Adhesiveness |
| | Type | Molecular weight | Number of functional groups (mmol/g) | Type | Specific skeleton | | | | | | |
| Example 26 | A-1 | 352 | 14.2 | B-10 | B | PTX-60/AA-3/AA-04 = 47/40/13 | 77 | None | B | A | B |
| Example 27 | A-1 | 352 | 14.2 | B-11 | B | PTX-60/AA-3/AA-04 = 47/40/13 | 77 | None | B | A | A |
| Example 28 | A-2 | 421 | 11.9 | B-1 | A | PTX-60/AA-3/AA-04 = 47/40/13 | 77 | None | B | B | B |
| Example 29 | A-2 | 421 | 11.9 | B-2 | A | PTX-60/AA-3/AA-04 = 47/40/13 | 77 | None | B | B | B |
| Example 30 | A-2 | 421 | 11.9 | B-3 | B | PTX-60/AA-3/AA-04 = 47/40/13 | 77 | None | C | B | B |
| Example 31 | A-2 | 421 | 11.9 | B-4 | B | PTX-60/AA-3/AA-04 = 47/40/13 | 77 | None | C | B | B |
| Example 32 | A-2 | 421 | 11.9 | B-5 | B | PTX-60/AA-3/AA-04 = 47/40/13 | 77 | None | C | B | B |
| Example 33 | A-2 | 421 | 11.9 | B-6 | B | PTX-60/AA-3/AA-04 = 47/40/13 | 77 | None | C | B | B |
| Example 34 | A-2 | 421 | 11.9 | B-7 | B | PTX-60/AA-3/AA-04 = 47/40/13 | 77 | None | C | B | C |

(continued)

| Table 1 | Characteristics of composition | | | | | | | | Evaluation | | |
|---|---|---|---|---|---|---|---|---|---|---|---|
| | Phenolic compound | | | Epoxy compound | | Inorganic substance formulation (mass ratio) | Content of inorganic substance (% by mass) | Type of surface modifier | Thermal conductivity | Insulating properties | Adhesiveness |
| | Type | Molecular weight | Number of functional groups (mmol/g) | Type | Specific skeleton | | | | | | |
| Example 35 | A-2 | 421 | 11.9 | B-8 | B | PTX-60/AA-3/AA-04 = 47/40/13 | 77 | None | C | B | B |
| Example 36 | A-2 | 421 | 11.9 | B-9 | B | PTX-60/AA-3/AA-04 = 47/40/13 | 77 | None | C | B | C |
| Example 37 | A-2 | 421 | 11.9 | B-10 | B | PTX-60/AA-3/AA-04 = 47/40/13 | 77 | None | C | B | C |
| Example 38 | A-2 | 421 | 11.9 | B-11 | B | PTX-60/AA-3/AA-04 = 47/40/13 | 77 | None | C | B | B |
| Example 39 | A-3 | 384 | 18.2 | B-1 | A | PTX-60/AA-3/AA-04 = 47/40/13 | 77 | None | A | A | A |
| Example 40 | A-3 | 384 | 18.2 | B-2 | A | PTX-60/AA-3/AA-04 = 47/40/13 | 77 | None | A | A | A |
| Example 41 | A-3 | 384 | 18.2 | B-3 | B | PTX-60/AA-3/AA-04 = 47/40/13 | 77 | None | B | A | A |
| Example 42 | A-3 | 384 | 18.2 | B-4 | B | PTX-60/AA-3/AA-04 = 47/40/13 | 77 | None | B | A | A |
| Example 43 | A-3 | 384 | 18.2 | B-5 | B | PTX-60/AA-3/AA-04 = 47/40/13 | 77 | None | B | A | A |

(continued)

| Table 1 | Characteristics of composition | | | | | | | | Evaluation | | |
|---|---|---|---|---|---|---|---|---|---|---|---|
| | Phenolic compound | | | Epoxy compound | | Inorganic substance formulation (mass ratio) | Content of inorganic substance (% by mass) | Type of surface modifier | Thermal conductivity | Insulating properties | Adhesiveness |
| | Type | Molecular weight | Number of functional groups (mmol/g) | Type | Specific skeleton | | | | | | |
| Example 44 | A-3 | 384 | 18.2 | B-6 | B | PTX-60/AA-3/AA-04 = 47/40/13 | 77 | None | B | A | A |
| Example 45 | A-3 | 384 | 18.2 | B-7 | B | PTX-60/AA-3/AA-04 = 47/40/13 | 77 | None | B | A | B |
| Example 46 | A-3 | 384 | 18.2 | B-8 | B | PTX-60/AA-3/AA-04 = 47/40/13 | 77 | None | B | A | A |
| Example 47 | A-3 | 384 | 18.2 | B-9 | B | PTX-60/AA-3/AA-04 = 47/40/13 | 77 | None | B | A | B |
| Example 48 | A-3 | 384 | 18.2 | B-10 | B | PTX-60/AA-3/AA-04 = 47/40/13 | 77 | None | B | A | B |
| Example 49 | A-3 | 384 | 18.2 | B-11 | B | PTX-60/AA-3/AA-04 = 47/40/13 | 77 | None | B | A | A |
| Example 50 | A-4 | 384 | 18.2 | B-1 | A | PTX-60/AA-3/AA-04 = 47/40/13 | 77 | None | A | A | A |

[Table 3]

| Table 1 | Characteristics of composition | | | | | | | | Evaluation | | |
|---|---|---|---|---|---|---|---|---|---|---|---|
| | Phenolic compound | | | Epoxy compound | | Inorganic substance formulation (mass ratio) | Content of inorganic substance (% by mass) | Type of surface modifier | Thermal conductivity | Insulating properties | Adhesiveness |
| | Type | Molecular weight | Number of functionalgroups (mmol/g) | Type | Specific skeleton | | | | | | |
| Example 51 | A-4 | 384 | 18.2 | B-2 | A | PTX-60/AA-3/AA-04 = 47/40/13 | 77 | None | A | A | A |
| Example 52 | A-4 | 384 | 18.2 | B-3 | B | PTX-60/AA-3/AA-04 = 47/40/13 | 77 | None | B | A | A |
| Example 53 | A-4 | 384 | 18.2 | B-4 | B | PTX-60/AA-3/AA-04 = 47/40/13 | 77 | None | B | A | A |
| Example 54 | A-4 | 384 | 18.2 | B-5 | B | PTX-60/AA-3/AA-04 = 47/40/13 | 77 | None | B | A | A |
| Example 55 | A-4 | 384 | 18.2 | B-6 | B | PTX-60/AA-3/AA-04 = 47/40/13 | 77 | None | B | A | A |
| Example 56 | A-4 | 384 | 18.2 | B-7 | B | PTX-60/AA-3/AA-04 = 47/40/13 | 77 | None | B | A | B |
| Example 57 | A-4 | 384 | 18.2 | B-8 | B | PTX-60/AA-3/AA-04 = 47/40/13 | 77 | None | B | A | A |
| Example 58 | A-4 | 384 | 18.2 | B-9 | B | PTX-60/AA-3/AA-04 = 47/40/13 | 77 | None | B | A | B |
| Example 59 | A-4 | 384 | 18.2 | B-10 | B | PTX-60/AA-3/AA-04 = 47/40/13 | 77 | None | B | A | B |

(continued)

| Table 1 | Characteristics of composition | | | | | | | | Evaluation | | |
|---|---|---|---|---|---|---|---|---|---|---|---|
| | Phenolic compound | | | Epoxy compound | | Inorganic substance formulation (mass ratio) | Content of inorganic substance (% by mass) | Type of surface modifier | Thermal conductivity | Insulating properties | Adhesiveness |
| | Type | Molecular weight | Number of functionalgroups (mmol/g) | Type | Specific skeleton | | | | | | |
| Example 60 | A-4 | 384 | 18.2 | B-11 | B | PTX-60/AA-3/AA-04 = 47/40/13 | 77 | None | B | A | A |
| Example 61 | A-5 | 192 | 20.8 | B-2 | A | PTX-60/AA-3/AA-04 = 47/40/13 | 77 | None | A | B | A |
| Example 62 | A-5 | 192 | 20.8 | B-4 | B | PTX-60/AA-3/AA-04 = 47/40/13 | 77 | None | B | B | A |
| Example 63 | A-6 | 248 | 20.1 | B-2 | A | PTX-60/AA-3/AA-04 = 47/40/13 | 77 | None | A | B | A |
| Example 64 | A-6 | 248 | 20.1 | B-4 | B | PTX-60/AA-3/AA-04 = 47/40/13 | 77 | None | B | B | A |
| Example 65 | A-7 | 453 | 11.0 | B-2 | A | PTX-60/AA-3/AA-04 = 47/40/13 | 77 | None | B | B | B |
| Example 66 | A-7 | 453 | 11.0 | B-4 | B | PTX-60/AA-3/AA-04 = 47/40/13 | 77 | None | C | B | B |
| Comparative Example 1 | D-1 | 384 | 18.2 | B-2 | A | PTX-60/AA-3/AA-04 = 47/40/13 | 77 | None | D | D | D |

From the results shown in the tables, it was confirmed that a thermally conductive material having excellent thermally conductive properties can be obtained by using the composition according to the embodiment of the present invention. Moreover, it was confirmed that the aforementioned thermally conductive material also has excellent insulating properties and adhesiveness.

It was confirmed that in a case where the hydroxyl group content of the used phenolic compound is 12.0 mmol/g or greater, the thermally conductive properties and adhesiveness of the obtained thermally conductive material are superior (results of Examples 28 to 38, 65, and 66, and the like).

It was confirmed that in a case where the molecular weight of the used phenolic compound is 400 or less, the thermally conductive properties and adhesiveness of the obtained thermally conductive material are superior (results of Examples 28 to 38, 65, and 66, and the like).

It was confirmed that in a case where the used epoxy compound is a compound having a biphenyl skeleton, the thermally conductive properties of the obtained thermally conductive material are superior (results of Examples in which B-1 or B-2 is used as the epoxy compound, and the like).

It was confirmed that in a case where a compound having a fused-ring skeleton or a triazine skeleton is used as the surface modifier, the thermally conductive properties of the obtained thermally conductive material are superior (results of Examples 1 to 5, 7 to 9, and 11 to 16, and the like).

«Example B: Example according to second aspect of present invention»

Hereinafter, Example according to the second aspect of the present invention will be described.

[Preparation of composition]

[Various components]

Various components used in Examples and Comparative Examples will be shown below.

<Phenolic compound>

Phenolic compounds used in Examples and Comparative Examples will be shown below.

Moreover, the phenolic compounds A1 to A4 used in Examples were synthesized with reference to US4992596A.

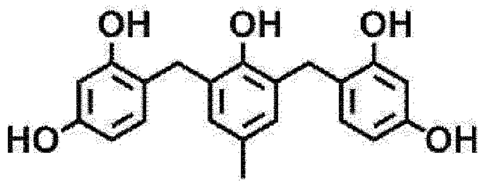

Molecular Weight: 352.39

A-1

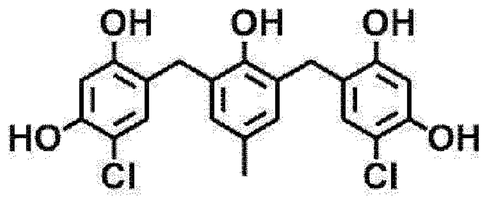

Molecular Weight: 421.27

A-2

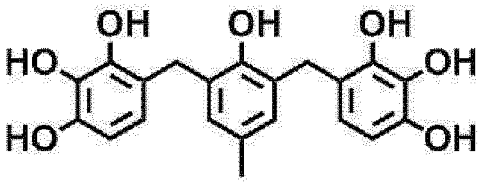

Molecular Weight: 384.38

A-3

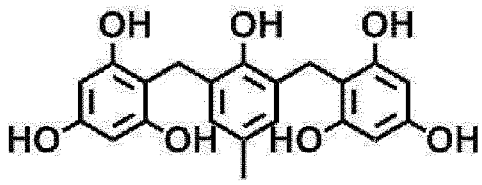

Molecular Weight: 384.38

A-4

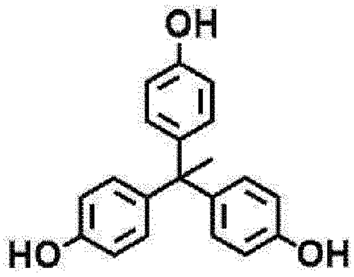

Molecular Weight: 306.36

A-5

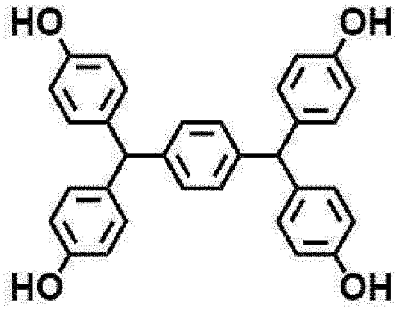

Molecular Weight: 474.56

A-6

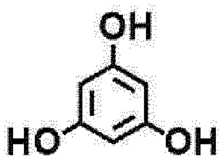

Molecular Weight: 126.11

A-7

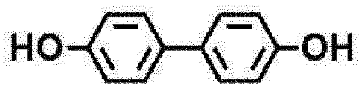

Molecular Weight: 186.21

A-8

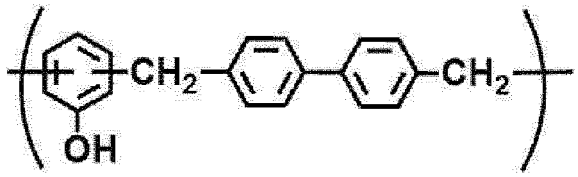

D-1

<Epoxy compound>

Epoxy compounds used in Examples and Comparative Examples will be shown below.

Moreover, the following B-5 is a mixture of two kinds of epoxy compounds (trade name: EPOTOHTO ZX-1059, produced by Tohto Kasei Co., Ltd.).

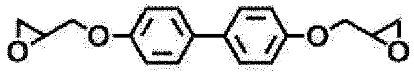

Molecular Weight: 298.34

B-1

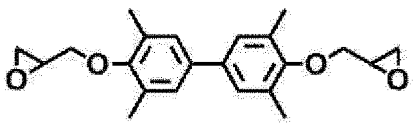

Molecular Weight: 354.45

B-2

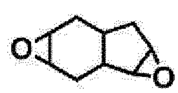

Molecular Weight: 152.19

B-3

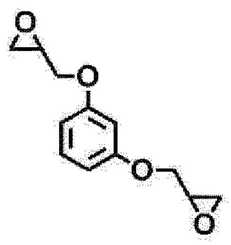

Molecular Weight: 222.24

B-4

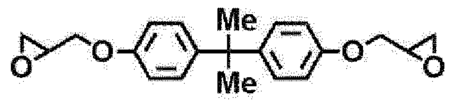

Molecular Weight: 340.42

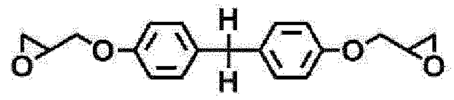

Molecular Weight: 312.37

B-5

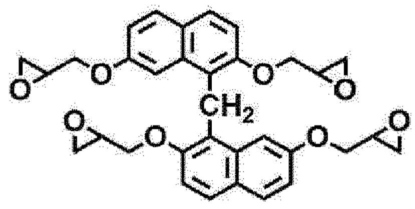

Molecular Weight: 556.61

B-6

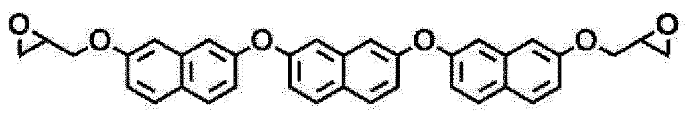

Molecular Weight: 556.61

B-7

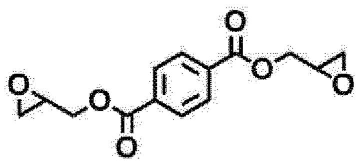

Molecular Weight: 278.26

B-8

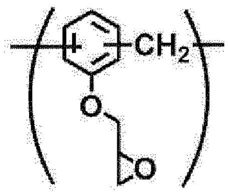

E-1

<Inorganic substance>

Inorganic substances used in Examples and Comparative Examples will be shown below.

"PTX-60": aggregation-shaped boron nitride (average particle diameter: 60 μm, produced by Momentive)
"AA-3": aluminum oxide (average particle diameter: 3 μm, produced by Sumitomo Chemical Co., Ltd.)
"AA-04": aluminum oxide (average particle diameter: 0.4 μm, produced by Sumitomo Chemical Co., Ltd.)
"HP40 MF100": aggregation-shaped boron nitride (average particle diameter: 40 μm, produced by MIZUSHIMA FERROALLOY CO., LTD.)

<Curing accelerator>

$PPh_3$ (triphenylphosphine) was used as the curing accelerator.

<Solvent>

Cyclopentanone was used as the solvent.

<Dispersant>

DISPERBYK-106 (polymer salt having an acidic group) was used as the dispersant.

<Surface treatment agent for aluminum oxide (organic silane molecule)>

The following compound was used as the surface modifier for aluminum oxide.

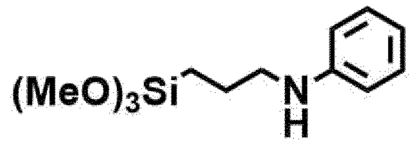

<Surface modifier for inorganic nitride>

Surface modifiers for an inorganic nitride used in Examples and Comparative Examples will be shown below.

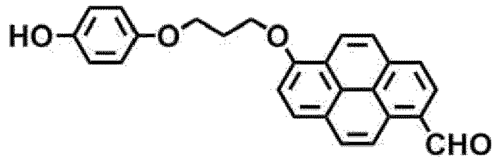

(A)

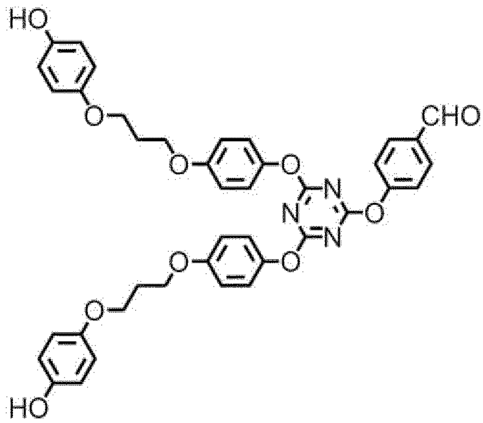

(B)

[Adsorption amount of phenolic compound with respect to boron nitride]

Each phenolic compound (10 mg) used in Examples and Comparative Examples was dissolved in each acetonitrile (100 mL), and further diluted to 1/10 to obtain a solution. Moreover, in a case where the phenolic compound was not dissolved in acetonitrile, tetrahydrofuran (THF) was used instead of acetonitrile. An ultraviolet-visible absorption spectrum (measuring device: UV-3100PC manufactured by Shimadzu Corporation) of the obtained solution was measured, and an absorbance X at an absorption maximum wavelength was determined.

Thereafter, boron nitride "SGPS" (0.5 g; and it corresponds to "content (g) of boron nitride in solution" in Expression (2)) produced by Denka Company Limited was added to the solution (20 mL = 0.2 mg of phenolic compound is contained; and it corresponds to "content (mg) of phenolic compound in solution" in Expression (2)), and the mixture was stirred for several seconds. After stirring, a supernatant liquid of the obtained solution was filtered with a filter of 0.45 μm. By using the obtained filtrate, an ultraviolet-visible absorption spectrum (measuring device: UV-3100PC manufactured by Shimadzu Corporation) of the filtrate was measured in the same manner as described above, and an absorbance Y at an absorption maximum wavelength was determined.

Subsequently, the absorbance Y of the filtrate, which was obtained by the addition of boron nitride, measured at an absorption maximum wavelength with respect to the absorbance X of the solution, to which boron nitride was not yet added, measured at an absorption maximum wavelength was calculated, and the adsorption amount (mg) of the phenolic compound with respect to 1 g of the boron nitride was calculated by Expression (2).

$$\text{Expression (2)} \quad \begin{array}{c}\text{Adsorption amount (mg)}\\\text{with respect to 1 g of}\\\text{boron nitride}\end{array} = \begin{array}{c}\text{content (mg) of}\\\text{phenolic compound}\\\text{in solution}\end{array} \times \left(1 - \frac{\text{absorbance Y}}{\text{absorbance X}}\right) \times \frac{1}{\begin{array}{c}\text{content (g) of boron nitride}\\\text{in solution}\end{array}}$$

[Adsorption amount of epoxy compound with respect to boron nitride]

For each epoxy compound used in Examples and Comparative Examples, the adsorption amount (mg) with respect to 1 g of the boron nitride was calculated in the same manner as in the section of [Adsorption amount of phenolic compound with respect to boron nitride].

[Preparation of composition]

A curing liquid was prepared by formulating the epoxy compound and the phenolic compound of each combination shown in Table 1 below in an equivalent (amount in which the number of epoxy groups in the epoxy compound is equal to the number of hydroxyl groups in the phenolic compound).
The aforementioned curing liquid, solvent, dispersant, surface modifier (the surface modifier for aluminum oxide and the surface modifier for an inorganic nitride), and curing accelerator were mixed in this order, and then the inorganic substance was added thereto. The obtained mixture was treated for 5 minutes with a rotating and revolving mixer (manufactured by THINKY CORPORATION, AWATORI RENTARO ARE-310) to obtain a composition (thermally conductive material-forming composition) of each Example or Comparative Example.
Here, the addition amount of the solvent was set such that the concentration of the solid content in the composition was 50% to 80% by mass.
Furthermore, the concentration of the solid content in the composition was adjusted for each composition within the above range so that the viscosities of the compositions were about the same.
The addition amount of the curing accelerator was set such that the content of the curing accelerator in the composition was 1% by mass with respect to the content of the epoxy compound.
The addition amount (total of all inorganic substances) of the inorganic substance was set such that the content of the inorganic substance in the composition was a value (% by mass) shown in Table 1 with respect to the total solid content of the composition.
Moreover, the inorganic substances were used after being mixed so that a ratio (mass ratio) of contents of the respective inorganic substances satisfied a relationship shown in Table 1.
The addition amount of the dispersant was set such that the content of the dispersant in the composition was 0.2% by mass with respect to the content of the inorganic substance.
The addition amount of the surface modifier for aluminum oxide was set such that the content of the surface modifier for aluminum oxide in the composition was 0.2% by mass with respect to the content (total content of AA-3 and AA-04) of the aluminum oxide. Moreover, in a case where the composition did not contain aluminum oxide, the surface modifier for aluminum oxide was not used.
In a case where the surface modifier for an inorganic nitride was used, the addition amount of the surface modifier for an inorganic nitride was set such that the content of the surface modifier for an inorganic nitride in the composition was 0.3% by mass with respect to the content (total addition amount of PTX-60 or HP-40 MF100) of the inorganic nitride.

[Preparation of sheet-shaped thermally conductive material]

The prepared composition was uniformly applied onto a release surface of a release-treated polyester film (NP-100A, manufactured by PANAC CO., LTD., film thickness of 100 μm) by using an applicator, and then the obtained composition film was dried at 120°C for 5 minutes to obtain a coating film.
Two polyester films with such a coating film were prepared, and after laminating the coating film surfaces with each other, two polyester films with a coating film were hot-pressed (treated for 1 minute at a hot plate temperature of 65°C and a pressure of 12 MPa) in the air to obtain a semi-cured film. The obtained semi-cured film was treated with a hot press (treated for 20 minutes at a hot plate temperature of 160°C and a pressure of 12 MPa, and then for 90 minutes at 180°C and a normal pressure) in the air to cure the coating film, thereby obtaining a resin sheet. The polyester films on both surfaces of the resin sheet were peeled off to obtain a sheet-shaped thermally conductive material having an average film thickness of 200 μm.

[Various evaluations]

[Density ratio]

<Measurement of actually measured density of thermally conductive material>

The actually measured density of the thermally conductive material was measured through the Archimedes

method ("solid specific gravity measuring kit" was used) by using a balance "XS204" manufactured by METTLER TOLEDO.

<Measurement of theoretical density of thermally conductive material>

The theoretical density of the thermally conductive material was determined by performing calculation from the formulation of the composition according to the method described in the specification. In this case, the density of the boron nitride was calculated as 2.3 g/$cm^3$, and the density of the aluminum oxide (alumina) was calculated as 3.9 g/$cm^3$.

Furthermore, the theoretical density of the thermally conductive material prepared in Example 1 was determined also using the combustion method described in the specification, and the theoretical density obtained by the combustion method was closely consistent with the theoretical density determined through the calculation from the formulation of the composition.

The density ratio X (actually measured density/theoretical density) was calculated based on the obtained actually measured density and theoretical density, and was classified according to the following standards.

<Evaluation standards>

"A": The density ratio X was 0.99 or greater
"B": The density ratio X was 0.96 or greater and less than 0.99
"C": The density ratio X was less than 0.96

The results are shown in Table 1.

[Thermally conductive properties]

<Measurement of thermal conductivity (W/m·k)>

The evaluation of thermally conductive properties was performed using each thermally conductive material. The thermal conductivity was measured by the following method, and the thermally conductive properties were evaluated according to the following standards.

(1) By using "LFA 467" manufactured by NETZSCH, the thermal diffusivity of the thermally conductive material in a thickness direction was measured through a laser flash method.
(2) By using a balance "XS204" manufactured by METTLER TOLEDO, the specific gravity of the thermally conductive material was measured through an Archimedes method ("solid specific gravity measuring kit" was used).
(3) By using "DSC320/6200" manufactured by Seiko Instruments Inc., the specific heat of the thermally conductive material at 25°C was determined under a temperature rising condition of 10 °C/min.
(4) The thermal conductivity of the thermally conductive material was calculated by multiplying the obtained thermal diffusivity by the specific gravity and the specific heat.

<Evaluation standards>

The measured thermal conductivity was classified according to the following standards, and the thermally conductive properties were evaluated.

"A+": 15 W/m·K or greater
"A": 10 W/m·K or greater and less than 15 W/m·K
"B": 8 W/m·K or greater and less than 10 W/m·K
"C": 5 W/m·K or greater and less than 8 W/m·K
"D": Less than 5 W/m·K

The results are shown in Table 1.

[Insulating properties]

A volume resistance value of a thermally conductive material, which was prepared in the same manner as in

the evaluation of "Thermally conductive properties", at 23°C and a relative humidity of 65% was measured using a HIRESTA MCP-HT450 type (manufactured by Nittoseiko Analytech Co., Ltd.).

<Evaluation standards>

The measured volume resistance value of the thermally conductive material was classified according to the following standards, and the insulating properties were evaluated.

"A": $10^{14}$ $\Omega$·cm or greater
"B": $10^{12}$ $\Omega$·cm or greater and less than $10^{14}$ $\Omega$·cm
"C": $10^{10}$ $\Omega$·cm or greater and less than $10^{12}$ $\Omega$·cm
"D": Less than $10^{10}$ $\Omega$·cm

The results are shown in Table 1.

[Adhesiveness]

A tensile shear test based on JIS K 6850 was performed using copper plates as adherends and the composition as an adhesive.
Moreover, a test specimen was prepared by laminating two copper plates (size: 100 mm $\times$ 25 mm $\times$ 0.3 mm) with each other with an adhesion area of 12.5 mm $\times$ 25 mm.
The curing conditions of the composition were the same as those in a case where the thermally conductive material was prepared in the measurement of the thermally conductive properties.
For the test, TENSILON UNIVERSAL MATERIAL TESTING INSTRUMENT RTc-1225A was used, and a tensile rate was 0.05 mm/s.

<Evaluation standards>

The measured breaking stress was classified according to the following standards, and the adhesiveness was evaluated.

"A": 5 MPa or greater
"B": 4 MPa or greater and less than 5 MPa
"C": 3 MPa or greater and less than 4 MPa
"D": Less than 3 MPa

The results are shown in Table 1.

[Results]

Table 1 will be shown below.
In addition, in Table 1, "BN adsorption amount (mg/g)" in a column of "Phenolic compound" indicates the adsorption amount (mg) of the used phenolic compound with respect to 1 g of the boron nitride.
"Number of functional groups" in the column of "Phenolic compound" indicates the hydroxyl group content (mmol/g) of the used phenolic compound.
Moreover, "BN adsorption amount (mg/g)" in a column of "Epoxy compound" indicates the adsorption amount (mg) of the used epoxy compound with respect to 1 g of the boron nitride.
"Number of functional groups" in the column of "Epoxy compound" indicates the content (mmol/g) of the oxiranyl group in the used epoxy compound.
"Specific skeleton" in the column of "Epoxy compound" indicates whether the used epoxy compound has a biphenyl skeleton. A case where the requirement is satisfied is indicated as A, and a case where the requirement is not satisfied is indicated as B.
Furthermore, a column of "Surface modifier" indicates the type of the used surface modifier for an inorganic nitride.

[Table 4]

| Table 1 | Characteristics of composition | | | | | | | | | | Density ratio X of thermally conductive sheet | Evaluation | | |
|---|---|---|---|---|---|---|---|---|---|---|---|---|---|---|
| | Phenolic compound | | | Epoxy compound | | | | Inorganic substance formulation (mass ratio) | Content of inorganic substance (% by mass) | Type of surface modifier | | Thermal conductivity | Insulating properties | Adhesiveness |
| | Type | BN adsorption amount (mg/g) | Number of functional groups (mmol/g) | Type | BN adsorption amount (mg/g) | Number of functional groups (mmol/g) | Specific skeleton | | | | | | | |
| Example 1 | A-1 | 0.06 | 14.2 | B-2 | 0.06 | 5.64 | A | PTX-60/AA-3/AA-04 = 47/40/13 | 77 | None | A | A | A | A |
| Example 2 | A-1 | 0.06 | 14.2 | B-2 | 0.06 | 5.64 | A | PTX-60/AA-3/AA-04 = 47/40/13 | 77 | A | A | A+ | A | A |
| Example 3 | A-1 | 0.06 | 14.2 | B-2 | 0.06 | 5.64 | A | PTX-60/AA-3/AA-04 = 47/40/13 | 82 | A | A | A+ | A | A |
| Example 4 | A-1 | 0.06 | 14.2 | B-2 | 0.06 | 5.64 | A | Only HP-40 MF100 | 77 | None | A | A | A | A |
| Example 5 | A-1 | 0.06 | 14.2 | B-2 | 0.06 | 5.64 | A | Only HP-40 MF100 | 77 | A | A | A+ | A | A |
| Example 6 | A-1 | 0.06 | 14.2 | B-2 | 0.06 | 5.64 | A | Only HP-40 MF100 | 82 | A | A | A+ | A | A |
| Example 6 | A-1 | 0.06 | 14.2 | B-2 | 0.06 | 5.64 | A | Only HP-40 MF100 | 87 | A | A | A+ | A | A |
| Example 7 | A-1 | 0.06 | 14.2 | B-2 | 0.06 | 5.64 | A | Only HP-40 MF100 | 77 | B | A | A+ | A | A |
| Example 8 | A-1 | 0.06 | 14.2 | B-2 | 0.06 | 5.64 | A | Only HP-40 MF100 | 82 | B | A | A+ | A | A |
| Example 9 | A-1 | 0.06 | 14.2 | B-2 | 0.06 | 5.64 | A | Only HP-40 MF100 | 87 | B | A | A+ | A | A |
| Example 10 | A-1 | 0.06 | 14.2 | B-1 | 0.08 | 6.7 | A | Only HP-40 MF100 | 77 | None | A | A | A | A |

(continued)

| Table 1 | Characteristics of composition | | | | | | | | | | Density ratio X of thermally conductive sheet | Evaluation | | |
|---|---|---|---|---|---|---|---|---|---|---|---|---|---|---|
| | Phenolic compound | | | Epoxy compound | | | | Inorganic substance formulation (mass ratio) | Content of inorganic substance (% by mass) | Type of surface modifier | | Thermal conductivity | Insulating properties | Adhesiveness |
| | Type | BN adsorption amount (mg/g) | Number of functional groups (mmol/g) | Type | BN adsorption amount (mg/g) | Number of functional groups (mmol/g) | Specific skeleton | | | | | | | |
| Example 11 | A-1 | 0.06 | 14.2 | B-3 | 0.00 | 13.1 | B | Only HP-40 MF100 | 77 | None | B | B | A | A |
| Example 12 | A-1 | 0.06 | 14.2 | B-4 | 0.02 | 9 | B | Only HP-40 MF100 | 77 | None | B | B | A | A |
| Example 13 | A-1 | 0.06 | 14.2 | B-5 | 0.00 | 6.13 | B | Only HP-40 MF100 | 77 | None | B | B | A | A |
| Example 14 | A-1 | 0.06 | 14.2 | B-6 | 0.12 | 7.19 | B | Only HP-40 MF100 | 77 | None | B | B | A | A |
| Example 15 | A-1 | 0.06 | 14.2 | B-7 | 0.09 | 3.59 | B | Only HP-40 MF100 | 77 | None | B | B | A | B |
| Example 16 | A-1 | 0.06 | 14.2 | B-8 | 0.03 | 7.19 | B | Only HP-40 MF100 | 77 | None | B | B | A | A |
| Example 17 | A-2 | 0.06 | 11.9 | B-2 | 0.06 | 5.64 | A | Only HP-40 MF100 | 77 | None | B | B | B | B |
| Example 18 | A-3 | 0.10 | 18.2 | B-2 | 0.06 | 5.64 | A | Only HP-40 MF100 | 77 | None | A | A | A | A |
| Example 19 | A-4 | 0.10 | 18.2 | B-2 | 0.06 | 5.64 | A | Only HP-40 MF100 | 77 | None | A | A | A | A |
| Example 20 | A-7 | 0.00 | 23.8 | B-2 | 0.06 | 5.64 | A | Only HP-40 MF100 | 77 | None | A | A | B | B |
| Example 21 | A-8 | 0.05 | 10.7 | B-2 | 0.06 | 5.64 | A | Only HP-40 MF100 | 77 | None | A | B | B | B |
| Comparative Example 1 | D-1 | 0.14 | 3.5 | E-1 | 0.21 | 5.61 | B | Only HP-40 MF100 | 77 | None | C | D | D | D |

(continued)

| Table 1 | Characteristics of composition | | | | | | | | | | Density ratio X of thermally conductive sheet | Evaluation | | |
|---|---|---|---|---|---|---|---|---|---|---|---|---|---|---|
| | Phenolic compound | | | Epoxy compound | | | | Inorganic substance formulation (mass ratio) | Content of inorganic substance (% by mass) | Type of surface modifier | | Thermal conductivity | Insulating properties | Adhesiveness |
| | Type | BN adsorption amount (mg/g) | Number of functional groups (mmol/g) | Type | BN adsorption amount (mg/g) | Number of functional groups (mmol/g) | Specific skeleton | | | | | | | |
| Comparative Example 2 | D-1 | 0.14 | 3.5 | B-2 | 0.06 | 5.64 | A | Only HP-40 MF100 | 77 | None | C | D | D | D |
| Comparative Example 3 | A-5 | 0.00 | 9.8 | B-7 | 0.09 | 3.59 | B | Only HP-40 MF100 | 77 | None | B | C | B | C |
| Comparative Example 4 | A-6 | 0.00 | 8.4 | B-7 | 0.09 | 3.59 | B | Only HP-40 MF100 | 77 | None | B | C | B | C |

As is clear from Table 1, with the compositions of Examples, a thermally conductive material having excellent thermally conductive properties can be formed. Moreover, it was confirmed that the aforementioned thermally conductive material also has excellent insulating properties and adhesiveness.

Further, it is clear that in a case where the composition according to the embodiment of the present invention contains a surface modifier for boron nitride, the thermal conductivity of the obtained thermally conductive material is superior (comparison between Example 1 and Example 2, and comparison between Example 4 and Examples 5 and 7).

Furthermore, it is clear that in a case where the epoxy compound contained in the composition according to the embodiment of the present invention has a biphenyl skeleton, the thermal conductivity of the obtained thermally conductive material is superior and the density ratio X is evaluated as "A" (in other words, the generation of voids is further suppressed) (comparison between Examples 4 and 10 and Examples 11 to 16).

In addition, it is clear that in a case where the hydroxyl group content of the specific phenolic compound contained in the composition according to the embodiment of the present invention is 12.0 mmol/g or greater, the thermal conductivity of the obtained thermally conductive material is superior (comparison between Example 4 and Examples 17 to 21). Meanwhile, it is clear that in a case where there is no adsorption amount of the specific phenolic compound with respect to 1 g of the boron nitride, the insulating properties of the obtained thermally conductive material and the adhesiveness of the composition tend to be decreased (results of Example 20).

## Claims

**1.** A thermally conductive material-forming composition comprising:

an epoxy compound;
one or more kinds of phenolic compounds selected from the group consisting of a compound represented by General Formula (1) and a compound represented by General Formula (2); and
an inorganic substance,

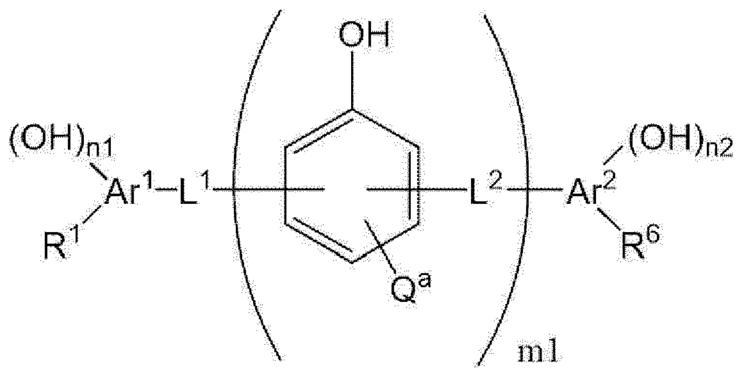

(1)

in General Formula (1), m1 represents an integer of 0 or greater;
n1 and n2 each independently represent an integer of 2 or greater;
$L^1$ represents $-C(R^2)(R^3)-$ or -CO-;
$L^2$ represents $-C(R^4)(R^5)-$ or -CO-;
$Ar^1$ and $Ar^2$ each independently represent a benzene ring group or a naphthalene ring group;
$R^1$ and $R^6$ each independently represent a hydrogen atom, a halogen atom, a carboxylic acid group, a boronic acid group, an aldehyde group, an alkyl group, an alkoxy group, or an alkoxycarbonyl group;
$R^2$ to $R^5$ each independently represent a hydrogen atom, a hydroxyl group, a halogen atom, a carboxylic acid group, a boronic acid group, an aldehyde group, an alkyl group, an alkoxy group, or an alkoxycarbonyl group;
$Q^a$ represents a hydrogen atom, an alkyl group, a phenyl group, a halogen atom, a carboxylic acid group, a boronic acid group, an aldehyde group, an alkoxy group, or an alkoxycarbonyl group; and
in a case where there are a plurality of $L^2$'s and $Q^a$'s, the plurality of $L^2$'s may be the same as or different from each other and the plurality of $Q^a$'s may be the same as or different from each other, and
in a case where m1 represents 0, $L^1$ represents -CH(OH)- or -CO-; and

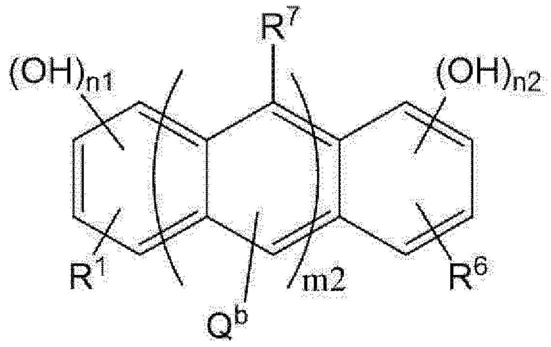

(2)

in General Formula (2), m2 represents an integer of 0 or greater;
n1 and n2 each independently represent an integer of 2 or greater;
$R^1$ and $R^6$ each independently represent a hydrogen atom, a halogen atom, a carboxylic acid group, a boronic acid group, an aldehyde group, an alkyl group, an alkoxy group, or an alkoxycarbonyl group;
$R^7$ represents a hydrogen atom or a hydroxyl group;
$Q^b$ represents a hydrogen atom, an alkyl group, a phenyl group, a halogen atom, a carboxylic acid group, a boronic acid group, an aldehyde group, an alkoxy group, or an alkoxycarbonyl group; and
in a case where there are a plurality of $R^7$'s and $Q^b$'s, the plurality of $R^7$'s may be the same as or different from each other and the plurality of $Q^b$'s may be the same as or different from each other.

2. The thermally conductive material-forming composition according to claim 1, wherein a hydroxyl group content of the phenolic compound is 12.0 mmol/g or greater.

3. The thermally conductive material-forming composition according to claim 1 or 2, wherein a molecular weight of the phenolic compound is 400 or less.

4. The thermally conductive material-forming composition according to any one of claims 1 to 3, wherein the epoxy compound has a biphenyl skeleton.

5. The thermally conductive material-forming composition according to any one of claims 1 to 4, wherein the inorganic substance includes an inorganic nitride.

6. The thermally conductive material-forming composition according to claim 5, wherein the inorganic nitride includes boron nitride.

7. The thermally conductive material-forming composition according to any one of claims 1 to 6, further comprising a surface modifier for the inorganic substance.

8. The thermally conductive material-forming composition according to claim 7, wherein the surface modifier has a fused-ring skeleton or a triazine skeleton.

9. The thermally conductive material-forming composition according to any one of claims 1 to 8, further comprising a curing accelerator.

10. A thermally conductive material obtained by curing the thermally conductive material-forming composition according to any one of claims 1 to 9.

11. A thermally conductive sheet consisting of the thermally conductive material according to claim 10.

12. A device with a thermally conductive layer comprising:

a device; and
a thermally conductive layer which is disposed on the device and includes the thermally conductive sheet according to claim 11.

**13.** A thermally conductive material-forming composition comprising:

a phenolic compound;
an epoxy compound; and
boron nitride,
wherein the phenolic compound has a hydroxyl group content of 10.5 mmol/g or greater, and an adsorption amount of 0. 12 mg or less with respect to 1 g of the boron nitride,
wherein the adsorption amount is measured as described in the description.

**14.** The thermally conductive material-forming composition according to claim 13,
wherein the hydroxyl group content is 12.0 mmol/g or greater.

**15.** The thermally conductive material-forming composition according to claim 13 or 14,
wherein the adsorption amount of the phenolic compound is 0.01 mg or greater with respect to 1 g of the boron nitride.

**16.** The thermally conductive material-forming composition according to any one of claims 13 to 15,
wherein an adsorption amount of the epoxy compound is 0.20 mg or less with respect to 1 g of the boron nitride.

**17.** The thermally conductive material-forming composition according to any one of claims 13 to 16,
wherein the epoxy compound has a biphenyl skeleton.

**18.** The thermally conductive material-forming composition according to any one of claims 13 to 17, further comprising a surface modifier for the boron nitride.

**19.** The thermally conductive material-forming composition according to any one of claims 13 to 18, further comprising a curing accelerator.

**20.** A thermally conductive material obtained by curing the thermally conductive material-forming composition according to any one of claims 13 to 19.

**21.** The thermally conductive material according to claim 20, which is molded into a sheet shape.

**22.** The thermally conductive material according to claim 21,

wherein a density ratio X determined from Expression (1) is 0.96 or greater,

Density ratio X = activity measured density of thermally conductive material determined by Archimedes method/theoretical density Di of thermally conductive material determined by Expression (DI) Expression (1)

Expression (DI)

$$Di = Df \times Vf/100 + Dr \times Vr/100$$

in Expression (DI), Di means a density of a theoretical thermally conductive material T which consists of an organic nonvolatile component and an inorganic substance including boron nitride;
a content mass Wf of the inorganic substance in the thermally conductive material T is equal to a content of an inorganic substance in the thermally conductive material-forming composition, and a content mass Wr of the organic nonvolatile component in the thermally conductive material T is equal to a value obtained by subtracting the content of the inorganic substance from a content of a total solid content in the thermally conductive material-forming composition;
Df is a density of the inorganic substance;
Dr is a density of the organic nonvolatile component and is 1.2 g/cm$^3$;
Vf is a volume percentage of a volume of the inorganic substance in the thermally conductive material T to a volume of the thermally conductive material T and is a value determined by Expression (DII); and

$$\text{Expression (DII)}$$
$$Vf = (Wf/Df)/((Wf/Df) + (Wr/Dr)) \times 100$$

Vr is a volume percentage of a volume of the organic nonvolatile component in the thermally conductive material T to the volume of the thermally conductive material T and is a value determined by Expression (DIII),

$$\text{Expression (DIII)}$$
$$Vr = 100 - Vf.$$

**23.** A thermally conductive sheet comprising the thermally conductive material according to claim 21 or 22.

**24.** A device with a thermally conductive layer comprising:

a device; and
a thermally conductive layer which is disposed on the device and includes the thermally conductive sheet according to claim 23.

**Patentansprüche**

**1.** Wärmeleitfähiges Material-bildende Zusammensetzung, umfassend:

eine Epoxyverbindung;
eine oder mehr Arten von phenolischer Verbindungen, ausgewählt aus der Gruppe bestehend aus einer durch die allgemeine Formel (1) dargestellten Verbindung und einer durch die allgemeine Formel (2) dargestellten Verbindung; und
eine anorganische Substanz,

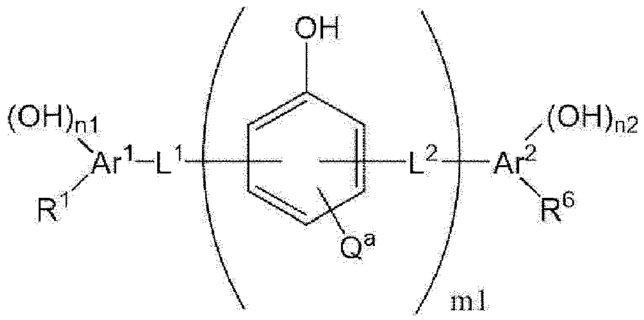 (1)

worin in der allgemeinen Formel (1) m1 eine ganze Zahl von 0 oder größer darstellt;
n1 und n2 jeweils unabhängig eine ganze Zahl von 2 oder größer darstellen;
$L^1$ -C($R^2$)($R^3$)- oder -CO- darstellt;
$L^2$ -C($R^4$)($R^5$)- oder -CO- darstellt;
$Ar^1$ und $Ar^2$ jeweils unabhängig eine Benzolringgruppe oder eine Naphthalinringgruppe darstellen;
$R^1$ und $R^6$ jeweils unabhängig ein Wasserstoffatom, ein Halogenatom, eine Carbonsäuregruppe, eine Boronsäuregruppe, eine Aldehydgruppe, eine Alkylgruppe, eine Alkoxygruppe oder eine Alkoxycarbonylgruppe darstellen;
$R^2$ bis $R^5$ jeweils unabhängig ein Wasserstoffatom, eine Hydroxylgruppe, ein Halogenatom, eine Carbonsäuregruppe, eine Boronsäuregruppe, eine Aldehydgruppe, eine Alkylgruppe, eine Alkoxygruppe oder eine Alkoxycarbonylgruppe darstellen;
$Q^a$ ein Wasserstpffatom, eine Alkylgruppe, eine Phenylgruppe, ein Halogenatom, eine Carbonsäuregruppe, eine Boronsäuregruppe, eine Aldehydgruppe, eine Alkoxygruppe oder eine Alkoxycarbonylgruppe darstellt; und wenn mehrere $L^2$ und $Q^a$ vorliegen, die mehreren $L^2$ gleich oder voneinander verschieden sein können und die mehreren $Q^a$ gleich oder voneinander verschieden sein können, und

wenn m1 0 darstellt, $L^1$ -CH(OH)- oder -CO- darstellt; und

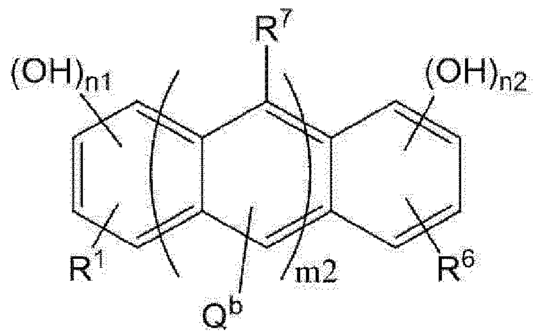

(2)

worin in der allgemeinen Formel (2) m2 eine ganze Zahl von 0 oder größer darstellt;
n1 und n2 jeweils unabhängig eine ganze Zahl von 2 oder größer darstellen;
$R^1$ und $R^6$ jeweils unabhängig ein Wasserstoffatom, ein Halogenatom, eine Carbonsäuregruppe, eine Boronsäuregruppe, eine Aldehydgruppe, eine Alkylgruppe, eine Alkoxygruppe oder eine Alkoxycarbonylgruppe darstellen;
$R^7$ ein Wasserstoffatom oder eine Hydroxylgruppe darstellt;
$Q^b$ ein Wasserstoffatom, eine Alkylgruppe, eine Phenylgruppe, ein Halogenatom, eine Carbonsäuregruppe, eine Boronsäuregruppe, eine Aldehydgruppe, eine Alkoxygruppe oder eine Alkoxycarbonylgruppe darstellt; und wenn mehrere $R^7$ und $Q^b$ vorliegen, die mehreren $R^7$ gleich oder voneinander verschieden sein können und die mehreren $Q^b$ gleich oder voneinander verschieden sein können.

**2.** Wärmeleitfähiges Material-bildende Zusammensetzung gemäß Anspruch 1, worin der Hydroxylgruppengehalt der phenolischen Verbindung 12,0 mmol/g oder mehr beträgt.

**3.** Wärmeleitfähiges Material-bildende Zusammensetzung gemäß Anspruch 1 oder 2, worin as Molekulargewicht der phneolischen Verbindung 400 oder kleiner ist.

**4.** Wärmeleitfähiges Material-bildende Zusammensetzung gemäß irgendeinem der Ansprüche 1 bis 3, worin die Epoxyverbindung ein Biphenylgerüst aufweist.

**5.** Wärmeleitfähiges Material-bildende Zusammensetzung gemäß irgendeinem der Ansprüche 1 bis 4, worin die anorganische Substanz ein anorganisches Nitrid umfasst.

**6.** Wärmeleitfähiges Material-bildende Zusammensetzung gemäß Anspruch 5, worin das anorgnaische Nitrid Bornitrid umfasst.

**7.** Wärmeleitfähiges Material-bildende Zusammensetzung gemäß irgendeinem der Ansprüche 1 bis 6, ferner umfassend einen Oberflächenmodifizierer für die anorganische Substanz.

**8.** Wärmeleitfähiges Material-bildende Zusammensetzung gemäß Anspruch 7, worin der Oberflächenmodifizierer ein kondensiertes Ringggerüst oder ein Triazingerüst aufweist.

**9.** Wärmeleitfähiges Material-bildende Zusammensetzung gemäß irgendeinem der Ansprüche 1 bis 8, ferner umfassend einen Härtungsbeschleuniger.

**10.** Wärmeleitfähiges Material, erhalten durch Härten der wärmeleitfähiges Material-bildenden Zusammensetzung gemäß irgendeinem der Ansprüche 1 bis 9.

**11.** Wärmeleitfähiges Blatt, umfassend das wärmeleitfähige Material gemäß Anspruch 10.

**12.** Vorrichtung mit einer wärmeleitfähigen Schicht, umfassend:

eine Vorrichtung; und
eine wärmeleitfähige Schicht, die auf der Vorrichtung angeordnet ist und das wärmeleitfähige Blatt gemäß

Anspruch 11 umfasst.

**13.** Wärmeleitfähiges Material-bildende Zusammensetzung, umfassend:

eine phenolische Verbindung;
eine Epoxyverbindung; und
Bornitrid,
worin die phenolische Verbindung einen Hydroxylgruppengehalt von 10,5 mmol/g oder größer und eine Adsorptionsmenge von 0,12 mg oder weniger in Bezug auf 1g des Bornitrids aufweist,
worin die Adsorptionsmenge wie in der Beschreibung beschrieben gemessen wird.

**14.** Wärmeleitfähiges Material-bildende Zusammensetzung gemäß Anspruch 13, worin der Hydroxylgruppengehalt 12,0 mmol/g oder größer ist.

**15.** Wärmeleitfähiges Material-bildende Zusammensetzung gemäß Anspruch 13 oder 14, worin die Adsorptionsmenge der phenolischen Verbindung 0,01 mg oder mehr, bezogen auf 1 g des Bornitrids, beträgt.

**16.** Wärmeleitfähiges Material-bildende Zusammensetzung gemäß irgendeinem der Ansprüche 13 bis 15, worin die Adsorptionsmenge der Epoxyverbindung 0,20 mm oder weniger beträgt, bezogen auf 1 g des Bornitrids.

**17.** Wärmeleitfähiges Material-bildende Zusammensetzung gemäß irgendeinem der Ansprüche 13 bis 16, worin die Epoxyverbindung ein Biphenylgerüst aufweist.

**18.** Wärmeleitfähiges Material-bildende Zusammensetzung gemäß irgendeinem der Ansprüche 13 bis 17, ferner umfassend einen Oberflächenmodifizierer für das Bornitird.

**19.** Wärmeleitfähiges Material-bildende Zusammensetzung gemäß irgendeinem der Ansprüche 13 bis 18, ferner umfassend einen Härtungsbeschleuniger.

**20.** Wärmeleitfähiges Material, erhalten durch Härten der wärmeleitfähiges Material-bildenden Zusammensetzung gemäß irgendeinem der Ansprüche 13 bis 19.

**21.** Wärmeleitfähiges Material gemäß Anspruch 20, das zu einer Blattform geformt ist.

**22.** Wärmeleitfähiges Material gemäß Anspruch 21,

worin das Dichteverhältnis X, bestimmt durch den Ausdruck (1), 0,96 oder größer ist

Dichteverhältnis X = tatsächlich gemessene Dichte des wärmeleitfähigen Materials, bestimmt durch das Archimedes-Verfahren/theoretische Dichte Di des wärmeleitfähigen Materials, bestimmt durch den Ausdruck (DI) Ausdruck (1)

Ausdruck (DI)

$$Di = Df \times Vf/100 + Dr \times Vr/100$$

worin im Ausdruck (DI) Di die Dichte eines theoretischen wärmeleitfähigen Materials T bezeichnet, das aus einer organischen nichtflüchtigen Komponente und einer anorganischen Substanz, die Bornitrid umfasst, besteht;
worin der Mengenanteil WF der anorganischen Substanz in dem wärmeleitfähigen Material T gleich zur Menge einer anorganischen Substanz in der wärmeleitfähiges Material-bildenden Zusammensetzung ist, und der Mengenanteil Wr der organischen nichtflüchten Komponente in dem wärmeleitfähigen Material T gleich zu einem

Wert ist, der durch Subtrahieren des Gehalts der anorganischen Substanz von einem Gehalt des Gesamtfeststoffgehalts in der wärmeleitfähiges Material-bildenden Zusammensetzung erhalten wird;
Df die Dichte der anorganischen Substanz ist;
Dr die Dichte der organischen nichtflüchtigen Komponente ist und 1,2 g/cm$^3$ ist;
Vf der prozentuale Volumenanteil eines Volumens der anorganischen Substanz in dem wärmeleitfähigen Material T am Volumen des wärmeleitfähigen Materials T ist und ein Wert ist, der durch den Ausdruck (DII) bestimmt ist; und

Ausdruck (DII)

$$Vf = (Wf/Df)/((Wf/Df) + (Wr/Dr)) \times 100$$

worin Vr ein prozentualer Volumenanteil eines Volumens der organischen nichtflüchtigen Komponente im wärmeleitfähigen Material T am Volumen des wärmleitfähigen Materials T ist und ein Wert ist, der durch den Ausdruck (DIII) bestimmt ist,

Ausdruck (DIII)

$$Vr = 100 - Vf.$$

**23.** Wärmeleitfähiges Blatt, umfassend das wärmeleitfähige Material gemäß Anspruch 21 oder 22.

**24.** Vorrichtung mit einer wärmeleitfähigen Schicht, umfassend:

eine Vorrichtung; und
eine wärmeleitfähige Schicht, die auf der Vorrichtung angeordnet ist und das wärmeleitfähige Blatt gemäß Anspruch 23 umfasst.

**Revendications**

**1.** Composition pour la formation de matériaux thermoconducteurs comprenant :

un composé époxy ;
un ou plusieurs types de composés phénoliques choisis dans le groupe constitué par un composé représenté par la formule générale (1) et un composé représenté par la formule générale (2) ; et
une substance inorganique,

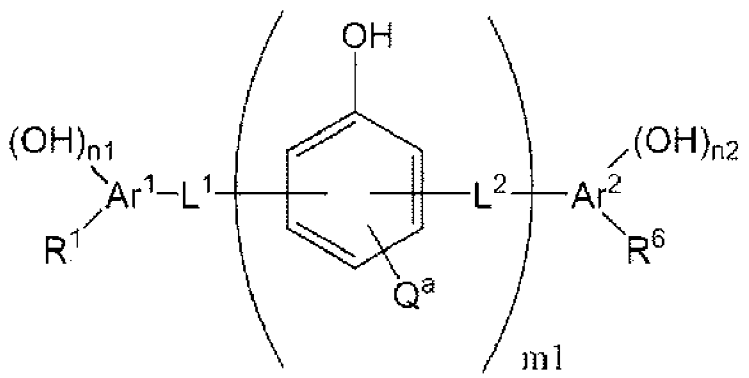

(1)

dans la formule générale (1), m1 représente un nombre entier de 0 ou plus ;
n1 et n2 représentent chacun indépendamment un nombre entier de 2 ou plus ;
$L^1$ représente -C($R^2$)($R^3$)- ou -CO- ;

$L^2$ représente -C($R^4$)($R^5$)- ou -CO- ;
$Ar^1$ et $Ar^2$ représentent chacun indépendamment un groupe cyclique benzène ou un groupe cyclique naphtalène ;
$R^1$ et $R^6$ représentent chacun indépendamment un atome d'hydrogène, un atome d'halogène, un groupe acide carboxylique, un groupe acide boronique, un groupe aldéhyde, un groupe alkyle, un groupe alcoxy ou un groupe alcoxycarbonyle ;
$R^2$ à $R^5$ représentent chacun indépendamment un atome d'hydrogène, un groupe hydroxyle, un atome d'halogène, un groupe acide carboxylique, un groupe acide boronique, un groupe aldéhyde, un groupe alkyle, un groupe alcoxy ou un groupe alcoxycarbonyle ;
$Q^a$ représente un atome d'hydrogène, un groupe alkyle, un groupe phényle, un atome d'halogène, un groupe acide carboxylique, un groupe acide boronique, un groupe aldéhyde, un groupe alcoxy ou un groupe alcoxycarbonyle ; et
dans un cas où il existe une pluralité de $L^2$ et de $Q^a$, la pluralité de $L^2$ peuvent être identiques les uns aux autres ou différents les uns des autres et la pluralité de $Q^a$ peuvent être identiques les uns aux autres ou différents les uns des autres, et
dans un cas où m1 représente 0, $L^1$ représente -CH(OH)- ou -CO- ; et

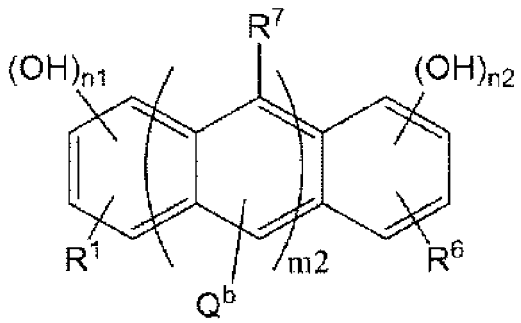

(2)

dans la formule générale (2), m2 représente un nombre entier de 0 ou plus ;
n1 et n2 représentent chacun indépendamment un nombre entier de 2 ou plus ;
$R^1$ et $R^6$ représentent chacun indépendamment un atome d'hydrogène, un atome d'halogène, un groupe acide carboxylique, un groupe acide boronique, un groupe aldéhyde, un groupe alkyle, un groupe alcoxy ou un groupe alcoxycarbonyle ;
$R^7$ représente un atome d'hydrogène ou un groupe hydroxyle ;
$Q^b$ représente un atome d'hydrogène, un groupe alkyle, un groupe phényle, un atome d'halogène, un groupe acide carboxylique, un groupe acide boronique, un groupe aldéhyde, un groupe alcoxy ou un groupe alcoxycarbonyle ; et
dans un cas où il existe une pluralité de $R^7$ et de $Q^b$, la pluralité de $R^7$ peuvent être identiques les uns aux autres ou différents les uns des autres et la pluralité de $Q^b$ peuvent être identiques les uns aux autres ou différents les uns des autres.

**2.** Composition pour la formation de matériaux thermoconducteurs selon la revendication 1,
dans laquelle une teneur en groupe hydroxyle du composé phénolique est de 12,0 mmol/g ou plus.

**3.** Composition pour la formation de matériaux thermoconducteurs selon la revendication 1 ou la revendication 2,
dans laquelle un poids moléculaire du composé phénolique est de 400 ou moins.

**4.** Composition pour la formation de matériaux thermoconducteurs selon l'une quelconque des revendications 1 à 3,
dans laquelle le composé époxy a un squelette biphényle.

**5.** Composition pour la formation de matériaux thermoconducteurs selon l'une quelconque des revendications 1 à 4,
dans laquelle la substance inorganique inclut un nitrure inorganique.

**6.** Composition pour la formation de matériaux thermoconducteurs selon la revendication 5,
dans laquelle le nitrure inorganique inclut du nitrure de bore.

**7.** Composition pour la formation de matériaux thermoconducteurs selon l'une quelconque des revendications 1 à 6,

comprenant en outre un modificateur de surface pour la substance inorganique.

**8.** Composition pour la formation de matériaux thermoconducteurs selon la revendication 7,
dans laquelle le modificateur de surface a un squelette à cycle fusionné ou un squelette triazine.

**9.** Composition pour la formation de matériaux thermoconducteurs selon l'une quelconque des revendications 1 à 8, comprenant en outre un accélérateur de durcissement.

**10.** Matériau thermoconducteur obtenu par durcissement de la composition pour la formation de matériaux thermoconducteurs selon l'une quelconque des revendications 1 à 9.

**11.** Feuille thermoconductrice constituée du matériau thermoconducteur selon la revendication 10.

**12.** Dispositif doté d'une couche thermoconductrice comprenant :

un dispositif ; et
une couche thermoconductrice qui est disposée sur le dispositif et inclut la feuille thermoconductrice selon la revendication 11.

**13.** Composition pour la formation de matériaux thermoconducteurs comprenant :

un composé phénolique ;
un composé époxy ; et
du nitrure de bore,
dans laquelle le composé phénolique a une teneur en groupe hydroxyle de 10,5 mmol/g ou plus, et une quantité d'adsorption de 0,12 mg ou moins par rapport à 1 g du nitrure de bore,
dans laquelle la quantité d'adsorption est mesurée comme décrit dans la description.

**14.** Composition pour la formation de matériaux thermoconducteurs selon la revendication 13,
dans laquelle la teneur en groupe hydroxyle est de 12,0 mmol/g ou plus.

**15.** Composition pour la formation de matériaux thermoconducteurs selon la revendication 13 ou la revendication 14, dans laquelle la quantité d'adsorption du composé phénolique est de 0,01 mg ou plus par rapport à 1 g de nitrure de bore.

**16.** Composition pour la formation de matériaux thermoconducteurs selon l'une quelconque des revendications 13 à 15, dans laquelle une quantité d'adsorption du composé époxy est de 0,20 mg ou moins par rapport à 1 g du nitrure de bore.

**17.** Composition pour la formation de matériaux thermoconducteurs selon l'une quelconque des revendications 13 à 16, dans laquelle le composé époxy a un squelette biphényle.

**18.** Composition pour la formation de matériaux thermoconducteurs selon l'une quelconque des revendications 13 à 17, comprenant en outre un modificateur de surface pour le nitrure de bore.

**19.** Composition pour la formation de matériaux thermoconducteurs selon l'une quelconque des revendications 13 à 18, comprenant en outre un accélérateur de durcissement.

**20.** Matériau thermoconducteur obtenu par durcissement de la composition pour la formation de matériaux thermoconducteurs selon l'une quelconque des revendications 13 à 19.

**21.** Matériau thermoconducteur selon la revendication 20, qui est moulé en une forme de feuille.

**22.** Matériau thermoconducteur selon la revendication 21,

dans lequel un rapport de densité X déterminé à partir de l'expression (1) est de 0,96 ou plus, Expression (1)

Rapport de densité X = densité réellement mesurée du matériau thermoconducteur déterminée par le procédé

d'Archimède/densité théorique Di du matériau thermoconducteur déterminée par l'expression (DI)

Expression (DI)

$$Di = Df \times Vf/100 + Dr \times Vr/100$$

dans l'expression (DI), Di désigne une densité d'un matériau thermoconducteur théorique T qui est constitué d'un composant non volatil organique et d'une substance inorganique incluant du nitrure de bore ;
une masse de teneur Wf de la substance inorganique dans le matériau thermoconducteur T est égale à une teneur d'une substance inorganique dans la composition pour la formation de matériaux thermoconducteurs,

et une masse de teneur Wr du composant non volatil organique dans le matériau thermoconducteur T est égale à une valeur obtenue en soustrayant la teneur de la substance inorganique d'une teneur d'une teneur solide totale dans la composition pour la formation de matériaux thermoconducteurs ;

Df est une densité de la substance inorganique ;
Dr est une densité du composant non volatil organique et est de 1,2 $g/cm^3$ ;
Vf est un pourcentage volumique d'un volume de la substance inorganique dans le matériau thermoconducteur T par rapport à un volume du matériau thermoconducteur T et est une valeur déterminée par l'expression (DII) ; et

Expression (DII)

$$Vf = (Wf/Df)/((Wf/Df) + (Wr/Dr)) \times 100$$

Vf est un pourcentage volumique d'un volume du composant non volatil organique dans le matériau thermoconducteur T par rapport au volume du matériau thermoconducteur T et est une valeur déterminée par l'expression (DIII),

Expression (DIII)

$$Vr = 100 - Vf$$

**23.** Feuille thermoconductrice comprenant le matériau thermoconducteur selon la revendication 21 ou la revendication 22.

**24.** Dispositif doté d'une couche thermoconductrice comprenant :

un dispositif ; et
une couche thermoconductrice qui est disposée sur le dispositif et inclut la feuille thermoconductrice selon la revendication 23.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2013089670 A
- WO 2010140674 A1
- JP 1999513019 A
- JP H11513019 A
- WO 97000600 A
- JP 11323162 A
- JP H11323162 A
- JP 4118691 B
- JP 7306317 A
- JP H07306317 A
- JP 2007002220 A
- JP 2010244038 A
- JP 4592225 B
- JP 7281028 A
- JP H07281028 A
- JP 2005156822 A
- JP 2006301614 A
- JP 2006076992 A
- JP 2009502529 A
- JP 2001192500 A
- JP 4694929 B
- JP 2012067225 A
- US 4992596 A


### Non-patent literature cited in the description


- *Angew. Chem. Int. Ed.,* 2012, vol. 51, 7990-7993
- **C. DESTRADE et al.** *Mol. Crysr. Liq. Cryst.,* 1981, vol. 71, 111
- Quarterly Review of Chemistry. Chemistry of liquid crystal. 1994
- **B. KOHNE et al.** *Angew. Chem. Soc. Chem. Comm.,* 1985, 1794
- **J. ZHANG et al.** *J. Am. Chem. Soc.,* 1994, vol. 116, 2655
- *Angew. Chem. Int. Ed.,* 2012, vol. 51, 7990-7993
- Liquid Crystal Handbook. MARUZEN Co., Ltd, 2000, 330-333